(19) Europäisches Patentamt
European Patent Office
Office européen des brevets

(11) EP 2 649 082 B1

(12) **EUROPEAN PATENT SPECIFICATION**

(45) Date of publication and mention of the grant of the patent:
**14.01.2015 Bulletin 2015/03**

(21) Application number: **11781453.3**

(22) Date of filing: **09.11.2011**

(51) Int Cl.:
***C07F 7/08*** (2006.01) ***H01L 51/00*** (2006.01)

(86) International application number:
**PCT/EP2011/005621**

(87) International publication number:
**WO 2012/076092 (14.06.2012 Gazette 2012/24)**

(54) **NON-LINEAR ACENE DERIVATIVES AND THEIR USE AS ORGANIC SEMICONDUCTORS**

NICHTLINEARE ACENDERIVATE UND IHRE VERWENDUNG ALS ORGANISCHE HALBLEITER

DÉRIVÉS NON LINÉAIRES D'ACENE ET LEUR UTILISATION EN TANT QUE SEMI-CONDUCTEURS ORGANIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.12.2010 EP 10015339**

(43) Date of publication of application:
**16.10.2013 Bulletin 2013/42**

(73) Proprietor: **Merck Patent GmbH**
**64293 Darmstadt (DE)**

(72) Inventors:
- **MITCHELL, William**
  **Chandler's Ford SO53 3PE (GB)**
- **WANG, Changsheng**
  **Durham DH6 6EB (GB)**
- **D'LAVARI, Mansoor**
  **Bude EX23 9AG (GB)**
- **BLOUIN, Nicolas**
  **Southampton SO16 7DE (GB)**
- **TIERNEY, Steven**
  **Southampton SO16 4BS (GB)**

(56) References cited:
**WO-A1-2010/099583**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 649 082 B1

## Description

Field of the Invention

The invention relates to novel non-linear acene derivatives, methods of their preparation, their use as semiconductors in organic electronic (OE) devices, and to OE devices comprising these derivatives.

Background and Prior Art

In recent years, there has been development of organic semiconducting (OSC) materials in order to produce more versatile, lower cost electronic devices. Such materials find application in a wide range of devices or apparatus, including organic field effect transistors (OFETs), organic light emitting diodes (OLEDs), photodetectors, organic photovoltaic (OPV) cells, sensors, memory elements and logic circuits to name just a few. The organic semiconducting materials are typically present in the electronic device in the form of a thin layer, for example less than 1 micron thick.

The performance of OFET devices is principally based upon the charge carrier mobility of the semiconducting material and the current on/off ratio, so the ideal semiconductor should have a low conductivity in the off state, combined with a high charge carrier mobility (> 1 x $10^{-3}$ $cm^2V^{-1}$ $s^{-1}$). In addition, it is important that the semiconducting material is relatively stable to oxidation i.e. it has a high ionisation potential, as oxidation leads to reduced device performance. Further requirements for the semiconducting material are a good processability, especially for large-scale production of thin layers and desired patterns, and high stability, film uniformity and integrity of the organic semiconductor layer.

In the prior art, various materials have been proposed for use as OSCs in OFETs, including small molecules like for example pentacene, and polymers like for example polyhexylthiophene.

A promising class of conjugated small molecule semiconductors has been based upon the pentacene unit (see J. E. Anthony, Angew. Chem. Int. Ed., 2008, 47, 452). When deposited as a thin film by vacuum deposition, it was shown to have carrier mobilities in excess of 1 $cm^2$ $V^{-1}$ $s^{-1}$ with very high current on/off ratios greater than $10^6$. (see S. F. Nelson, Y. Y. Lin, D. J. Gundlach and T. N. Jackson, Appl. Phys. Lett., 1998, 72, 1854). However, vacuum deposition is an expensive processing technique that is unsuitable for the fabrication of large-area films. Initial device fabrication was improved by adding solubilising groups, such as trialkylsilylethynyl, allowing mobilities >0.1 $cm^2V^{-1}$ $s^{-1}$ (see Maliakal, K. Raghavachari, H. Katz, E. Chandross and T. Siegrist, Chem. Mater., 2004, 16, 4980). It has also been reported that adding further substituents to the pentacene core unit can improve its semiconducting performance in field-effect transistor (FET) devices (see J. E. Anthony, Angew. Chem. Int Ed., 2008, 47, 452).

However, the OSC materials of the prior art, and devices comprising them, which have been investigated so far, do still have several drawbacks, and their properties, especially the solubility, processibility, charge-carrier mobility, on/off ratio and stability still leave room for further improvement.

Therefore, there is still a need for OSC materials that show good electronic properties, especially high charge carrier mobility, and good processibilty, especially a high solubility in organic solvents. Moreover, for use in OFETs there is a need for OSC materials that allow improved charge injection into the semiconducting layer from the source-drain electrodes. For use in OPV cells, there is a need for OSC materials having a low bandgap, which enable improved light harvesting by the photoactive layer and can lead to higher cell efficiencies.

It was an aim of the present invention to provide compounds for use as organic semiconducting materials that do not have the drawbacks of prior art materials as described above, and do especially show good processibility, good solubility in organic solvents and high charge carrier mobility. Another aim of the invention was to extend the pool of organic semiconducting materials available to the expert.

It was found that these aims can be achieved by providing compounds as claimed in the present invention. In particular, the inventors of this invention have found that the above-mentioned problems can at least partially be solved by providing non-linear acene compounds containing solubilising ethynyl substituents at the central ring. These acene compounds have a bent shape and can be illustrated for example by the following structures

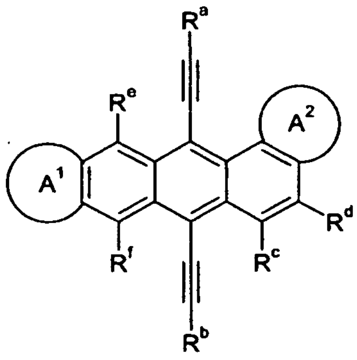

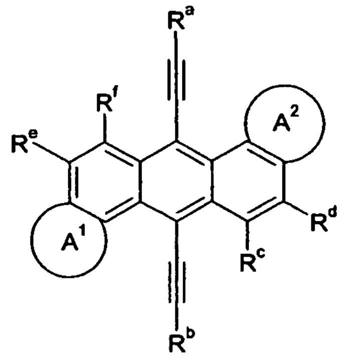

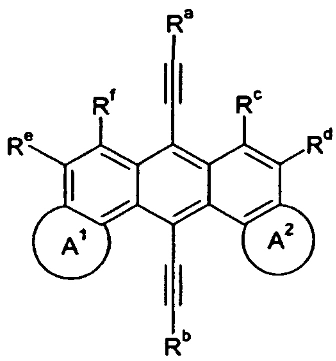

wherein $A^1$ and $A^2$ denote aromatic or heterocyclic groups that are optionally substituted, $R^a$ and $R^b$ denote a silyl or germyl group that is substituted by carbyl or hydrocarbyl groups, and $R^{c\text{-}f}$ denote H, halogen or carbyl or hydrocarbyl substituents that are not cross-bridged with each other.

It was found that these compounds are suitable as semiconductors, exhibit very good solubility in many organic solvents, and show high performance when used as semiconducting layer in electronic devices like OFETs. It was also found that OFET devices comprising such compounds as semiconductors, especially when prepared by solution deposition fabrication, show high charge carrier mobility values above 0.1 $cm^2/Vs$.

WO 2010/099583 A1 discloses polycyclic aromatic compounds, which are substituted with alkylsilylethynyl groups and which contain at least one ring atom that is common to three rings, and their use in photosensitive optoelectronic applications. However, linear polyacenes with bent shape like those of the present invention, are neither disclosed nor suggested. Compound 1 of WO 2010/099583 A1 (7,14-bis(triisopropylsilylethynyl) dibenzo[*b*,*def*] chrysene) has been reported to exhibit 1-D $\pi$-$\pi$ stacking according to analysis by single-crystal X-ray diffraction (Winzenberg et al, Chem. Mater. 2009, 21, 5701-5703). Whilst no charge carrier mobility values have been cited for compound 1 or other compounds in WO 2010/099583 A1, OSCs demonstrating a 1-D $\pi$-$\pi$ stacking crystal motif exhibit in general low charge carrier mobilities below 0.1 $cm^2/Vs$ and in some cases lower than $10^{-4}$ $cm^2/Vs$ (Payne et al, J. Am. Chem. Soc. 2005, 127,4986-4987). This performance renders them unpromising candidates for use in most backplane-driving transistors, like for example LCD and OLED displays, which require significantly higher charge carrier mobilities.

## Summary of the Invention

The invention relates to compounds of formula I

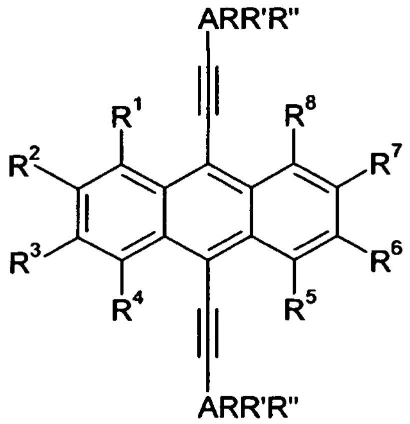

I

wherein the individual groups have the following meanings

$R^{1-8}$ independently of each other denote H, F, Cl, Br, I, CN, straight chain, branched or cyclic alkyl, alkoxy, thioalkyl, alkenyl, alkynyl, alkylcarbonyl, alkoxycarbonyl, alkylcarbonyloxy, alkylcarbonylamido, alkylamidocarbonyl or alkoxycarbonyloxy with 1 to 20 C-atoms, which is unsubstituted or substituted by one or more groups L, and wherein one or more non-adjacent $CH_2$ groups are optionally replaced, in each case independently from one another, by -O-, -S-, $-NR^0-$, $-SiR^0R^{00}-$, $-CY^0=CY^{00}-$ or -C≡C- in such a manner that O and/or S atoms are not linked directly to one another, or denote aryl or heteroaryl with 5 to 20 ring atoms which is unsubstituted or substituted by one or more groups L, or one or more of the pairs $R^1$ and $R^2$, $R^2$ and $R^3$, $R^3$ and $R^4$, $R^5$ and $R^6$, $R^6$ and $R^7$, $R^7$ and $R^8$ are cross-bridged with each other to form a $C_4$-$C_{40}$ saturated or unsaturated ring which is optionally intervened by one or more heteroatoms or groups selected from -O-, -S-, -Se-, -Ge-, $-SiR^0R^{00}-$ and $-N(R^x)-$, and which is optionally substituted,

A is Si, C or Ge,

R, R', R" are identical or different groups selected from the group consisting of H, straight-chain, branched or cyclic alkyl or alkoxy having 1 to 20 C atoms, straight-chain, branched or cyclic alkenyl having 2 to 20 C atoms, straight-chain, branched or cyclic alkynyl having 2 to 20 C atoms, straight-chain, branched or cyclic alkylcarbonyl having 2 to 20 C atoms, aryl or heteroaryl having 5 to 20 ring atoms, arylalkyl or heteroarylalkyl having 5 to 20 ring atoms, aryloxy or heteroaryloxy having 5 to 20 ring atoms, or arylalkyloxy or heteroarylalkyloxy having 5 to 20 ring atoms, wherein all the aforementioned groups are optionally substituted with one or more groups L,

L is selected from P-Sp-, F, Cl, Br, I, -OH, -CN, $-NO_2$, -NCO, -NCS, -OCN, -SCN, $-C(=O)NR^0R^{00}$, $-C(=O)X^0$, $-C(=O)R^0$, $-NR^0R^{00}$, C(=O)OH, optionally substituted aryl or heteroaryl having 5 to 20 ring atoms, or straight chain, branched or cyclic alkyl with 1 to 20, preferably 1 to 12 C atoms wherein one or more non-adjacent $CH_2$ groups are optionally replaced, in each case independently from one another, by -O-, -S-, $-NR^0-$, $-SiR^0R^{00}-$, $-CY^0=CY^{00}-$ or -C≡C- in such a manner that O and/or S atoms are not linked directly to one another and which is unsubstituted or substituted with one or more F or Cl atoms or OH groups,

P is a polymerisable group,

Sp is a spacer group or a single bond,

$X^0$ is halogen,

$R^x$ has one of the meanings given for $R^1$,

$R^0$, $R^{00}$ independently of each other denote H or alkyl with 1 to 20 C-atoms,

$Y^0$, $Y^{00}$ independently of each other denote H, F, Cl or CN,

characterized in that

at least one of the pairs $R^1$ and $R^2$, $R^3$ and $R^4$, $R^5$ and $R^6$, $R^7$ and $R^8$ is cross-bridged with each other to form a $C_4$-$C_{40}$ saturated or unsaturated ring which is optionally intervened by one or more heteroatoms or groups selected from -O-, -S-, -Se-, -Ge-, -$SiR^0R^{00}$- and -$N(R^x)$-, and which is optionally substituted, and
at least one of the pairs $R^1$ and $R^2$, $R^3$ and $R^4$, $R^5$ and $R^6$, $R^7$ and $R^8$ is not cross-bridged with each other, and
the compound does not contain a ring atom that is common to more than two rings.

The invention further relates to a formulation comprising one or more compounds of formula I and one or more solvents, preferably selected from organic solvents.

The invention further relates to an organic semiconducting formulation comprising one or more compounds of formula I, one or more organic binders, or precursors thereof, preferably having a permittivity $\varepsilon$ at 1,000 Hz of 3.3 or less, and optionally one or more solvents.

The invention further relates to the use of compounds and formulations according to the present invention as charge transport, semiconducting, electrically conducting, photoconducting or light emitting material in an optical, electrooptical, electronic, electroluminescent or photoluminescent components or devices.

The invention further relates to a charge transport, semiconducting, electrically conducting, photoconducting or light emitting material or component comprising one or more compounds or formulations according to the present invention.

The invention further relates to an optical, electrooptical or electronic component or device comprising one or more compounds, formulations, components or materials according to the present invention.

The optical, electrooptical, electronic, electroluminescent and photoluminescent components or devices include, without limitation, organic field effect transistors (OFET), thin film transistors (TFT), integrated circuits (IC), logic circuits, capacitors, radio frequency identification (RFID) tags, devices or components, organic light emitting diodes (OLED), organic light emitting transistors (OLET), flat panel displays, backlights of displays, organic photovoltaic devices (OPV), solar cells, laser diodes, photoconductors, photodetectors, electrophotographic devices, electrophotographic recording devices, organic memory devices, sensor devices, charge injection layers, charge transport layers or interlayers in polymer light emitting diodes (PLEDs), organic plasmon-emitting diodes (OPEDs), Schottky diodes, planarising layers, antistatic films, polymer electrolyte membranes (PEM), conducting substrates, conducting patterns, electrode materials in batteries, alignment layers, biosensors, biochips, security markings, security devices, and components or devices for detecting and discriminating DNA sequences.

Detailed Description of the Invention

This invention relates to a new class of compounds expressed by the general structure as shown in formula I. Apart of being novel, these compounds demonstrate one or more of the following properties:

i) The addition of two ethynyl groups, preferably trialkylsilylethynyl groups, in para-position at the central ring of the acene core helps in solubilising the molecular material in common organic solvents allowing the material to be easily solution processed. The addition of the (trialkylsilyl) ethynyl substituents also promotes the material to exhibit $\pi$-stacking order and thus to form highly organized crystalline films after deposition from solution.

ii) The size of the (trialkylsilyl) ethynyl groups strongly influences the $\pi$-stacking interactions in the solid state. For small substituent groups, where the diameter of the trialkylsilyl group is significantly smaller than half the length of the acene core, a one-dimensional $\pi$-$\pi$-stack or "slipped stack" arrangement is formed. However, when the size of the trialkylsilyl group is approximately the same as half the length of the acene core, a two-dimensional $\pi$-stack or "bricklayer" arrangement is favoured, which has been found to be the optimal for charge transport in FET devices. Therefore, by adding two trialkylsilyl ethynyl groups of the correct size and in the correct position to the anthracene core, the packing arrangement in the solid state is affected and a preferential $\pi$-stacking can be obtained with a suitably sized trialkylsilyl group.

iii) The non-linear structure of the acene compound promotes additional solubility thereby allowing the material to be easily solution processed.

iv)The non-linear backbone of the compound increases the band-gap compared with the linear equivalent thereby improving the stability of the compound.

v) Additional fine-tuning of the electronic energies (HOMO/LUMO levels) by *either* further modification of the acene core or co-polymerisation with appropriate co-monomer(s) should afford candidate materials for organic photovoltaic applications.

The compounds of the present invention are easy to synthesize and exhibit several advantageous properties, like a high charge carrier mobility, a high melting point, a high solubility in organic solvents, a good processability for the device manufacture process, a high oxidative and photostability and a long lifetime in electronic devices. In addition, they show advantageous properties as discussed above and below.

Preferably in the compounds of formula I the two groups ARR'R" have the same meaning.

A in formula I is preferably Si.

In a preferred embodiment of the present invention, in the compounds of formula I in at least one group ARR'R", preferably in both groups ARR'R", all substituents R, R' and R" are identical.

In another preferred embodiment of the present invention, in the compounds of formula I in at least one group ARR'R", preferably in both groups ARR'R", at least two of the substituents R, R' and R" are not identical. This means that in at least one group ARR'R", preferably in both groups ARR'R", at least one substituent R, R' and R" has a meaning that is different from the meanings of the other substituents R, R' and R".

In another preferred embodiment of the present invention, in the compounds of formula I each of R, R' and R" has a meaning that is different from the other of R' and R". Further preferred are compounds of formula I wherein two of R, R' and R" have the same meaning and one of R, R' and R" has a meaning which is different from the other two of R, R' and R".

Further preferred are compounds of formula I, wherein one or more of R, R' and R" denote or contain an alkenyl group or an aryl or heteroaryl group.

Very preferably R, R' and R" in the compounds of formula I are each independently selected from the group consisting of optionally substituted and straight-chain, branched or cyclic alkyl or alkoxy having 1 to 10 C atoms, which is for example methyl, ethyl, n-propyl, isopropyl, cyclopropyl, 2,3-dimethylcyclopropyl, 2,2,3,3-tetramethylcyclopropyl, cyclobutyl, cyclopentyl, methoxy or ethoxy, optionally substituted and straight-chain, branched or cyclic alkenyl, alkynyl or alkylcarbonyl having 2 to 12 C atoms, which is for example allyl, isopropenyl, 2-but-1-enyl, cis-2-but-2-enyl, 3-but-1-enyl, propynyl or acetyl, optionally substituted aryl, heteroaryl, arylalkyl or heteroarylalkyl, aryloxy or heteroaryloxy having 5 to 10 ring atoms, which is for example phenyl, p-tolyl, benzyl, 2-furanyl, 2-thienyl, 2-selenophenyl, N-methylpyrrol-2-yl or phenoxy.

The feature that the compound of formula I does not contain a ring atom that is common to more than two rings, means that, for example if the pair $R^1$ and $R^2$ or the pair $R^3$ and $R^4$ is cross-bridged with each other, then the pair $R^2$ and $R^3$ is not cross-bridged with each other, and if the pair $R^5$ and $R^6$ or the pair $R^7$ and $R^3$ is cross-bridged with each other, then the pair $R^6$ and $R^7$ is not cross-bridged with each other.

In the compounds of formula I, one or more, preferably one or two, of the pairs $R^1$ and $R^2$, $R^2$ and $R^3$, $R^3$ and $R^4$, $R^5$ and $R^6$, $R^6$ and $R^7$, $R^7$ and $R^8$ is cross-bridged with each other to form a $C_4$-$C_{40}$ saturated or unsaturated ring which is optionally intervened by one or more heteroatoms or groups selected from -O-, -S-, -Se-, -Ge-, -$SiR^0R^{00}$- and -$N(R^x)$-, and which is optionally substituted.

Very preferably at least the pair $R^7$ and $R^8$ is cross-bridged with each other to form a $C_4$-$C_{40}$ saturated or unsaturated ring which is optionally intervened by one or more heteroatoms or groups selected from -O-, -S-, -Se-, -Ge-, -$SiR^0R^{00}$- and -$N(R^x)$-, and which is optionally substituted.

Further preferably not more than one of the two pairs $R^1$ and $R^2$, $R^3$ and $R^4$, and not more than one of the two pairs $R^5$ and $R^6$, $R^7$ and $R^8$, is cross-bridged with each other to form a ring.

Preferably the said $C_4$-$C_{40}$ saturated or unsaturated ring formed by the cross-bridged pair $R^1$ and $R^2$, $R^2$ and $R^3$, $R^3$ and $R^4$, $R^5$ and $R^6$, $R^6$ and $R^7$, $R^7$ and $R^8$ is selected from the group consisting of aromatic and heteroaromatic groups with 5 to 25 ring atoms, which are mono- or polycyclic, i.e. which may also contain two or more individual rings that are connected to each other via single bonds, or contain two or more fused rings, and wherein each ring is unsubstituted or substituted with one or more groups L as defined above.

Very preferably the said $C_4$-$C_{40}$ saturated or unsaturated ring formed by the cross-bridged pair $R^1$ and $R^2$, $R^2$ and $R^3$, $R^3$ and $R^4$, $R^5$ and $R^6$, $R^6$ and $R^7$, $R^7$ and $R^8$ is selected from the group consisting of benzene, furan, thiophene, selenophene, pyrrole, pyridine, pyrimidine, thiazole, thiadiazole, oxazole, oxadiazole, selenazole, and bi-, tri- or tetracyclic aryl or heteroaryl groups containing one or more of the aforementioned rings and optionally one or more benzene rings, wherein the individual rings are connected by single bonds or fused with each other, and wherein all the aforementioned groups are unsubstituted or substituted with one or more groups L as defined above.

Furthermore very preferably the said $C_4$-$C_{40}$ saturated or unsaturated ring formed by the cross-bridged pair $R^1$ and $R^2$, $R^2$ and $R^3$, $R^3$ and $R^4$, $R^5$ and $R^6$, $R^6$ and $R^7$, $R^7$ and $R^8$ is selected from the group consisting of thieno-[3,2-b]thiophene, dithieno[3,2-*b*:2',3'-*d*]thiophene, selenopheno[3,2-b]-selenophene, selenopheno[2,3-b]selenophene, selenopheno[3,2-b]thiophene, selenopheno[2,3-b]thiophene, benzo[1,2-b:4,5-b']dithiophene, 2,2-dithiophene, 2,2-diselenophene, dithieno[3,2-*b*:2',3'-*d*]silole, 4*H*-cyclopenta[2,1-*b*:3,4-*b*']dithiophene, benzo[b]thiophene, benzo[b]selenophene, benzooxazole, benzothiazole, benzoselenazole, wherein all the aforementioned groups are unsubstituted or substituted with one or more groups L as defined above.

Most preferably one or more, in particular one or two, of the pairs $R^1$ and $R^2$, $R^2$ and $R^3$, $R^3$ and $R^4$, $R^5$ and

$R^6$, $R^6$ and $R^7$, $R^7$ and $R^8$ is cross-bridged with each other to form a ring selected from the group consisting of benzene, thiophene and pyridine, which are unsubstituted or substituted with one or more groups L as defined above.

In another preferred embodiment of the present invention, in the compounds of formula I the groups $R^1$, $R^2$, $R^3$, $R^4$, $R^5$, $R^6$, $R^7$ and $R^8$, which are not cross-bridged with each other to form a ring, are selected from the group consisting of H, F, Cl, Br, I, -CN, and straight chain, branched or cyclic alkyl, alkoxy, thioalkyl, alkenyl, alkynyl, alkylcarbonyl, alkoxycarbonyl, alkylcarbonyloxy, alkylcarbonylamido, alkylamidocarbonyl or alkoxycarbonyloxy with 1 to 20, preferably 1 to 12 C atoms which is unsubstituted or substituted with one or more F or Cl atoms or OH groups or perfluorinated.

Preferably at least two of $R^1$, $R^4$, $R^5$ and $R^8$ denote H. Very preferably at least one of $R^1$ and $R^5$ denotes H and at least one of $R^4$ and $R^8$ denotes H.

Furthermore preferably in the compounds of formula I the groups $R^1$, $R^2$, $R^3$, $R^4$, $R^5$, $R^6$, $R^7$ and $R^8$, which are not cross-bridged with each other to form a ring, are selected from the group consisting of aromatic and heteroaromatic groups with 5 to 25 ring atoms, which are mono- or polycyclic, i.e. which may also contain two or more individual rings that are connected to each other via single bonds, or contain two or more fused rings, and wherein each ring is unsubstituted or substituted with one or more groups L as defined above.

Very preferably these aforementioned aromatic and heteroaromatic groups are selected from the group consisting of phenyl, furan, thiophene, selenophene, N-pyrrole, pyridine, pyrimidine, thiazole, thiadiazole, oxazole, oxadiazole, selenazole, and bi-, tri- or tetracyclic aryl or heteroaryl groups containing one or more of the aforementioned rings and optionally one or more benzene rings, wherein the individual rings are connected by single bonds or fused with each other, and wherein all the aforementioned groups are unsubstituted or substituted with one or more groups L as defined above.

Very preferably these aforementioned bi-, tri- or tetracyclic aryl or heteroaryl groups are selected from the group consisting of thieno[3,2-b]thiophene, dithieno[3,2-*b*:2',3'-*d*]thiophene, selenopheno[3,2-b]-selenophene, selenopheno[2,3-b]selenophene, selenopheno[3,2-b]-thiophene, selenopheno[2,3-b]thiophene, benzo[1,2-b:4,5-b']dithiophene, 2,2-dithiophene, 2,2-diselenophene, dithieno[3,2-*b*:2',3'-*d*]silole, 4*H*-cyclopenta[2,1-*b*:3,4-*b*']dithiophene, benzo[b]thiophene, benzo[b]selenophene, benzooxazole, benzothiazole, benzoselenazole, wherein all the aforementioned groups are unsubstituted or substituted with one or more groups L as defined above.

Preferred compounds of formula I are selected from the following formulae I1 to I7:

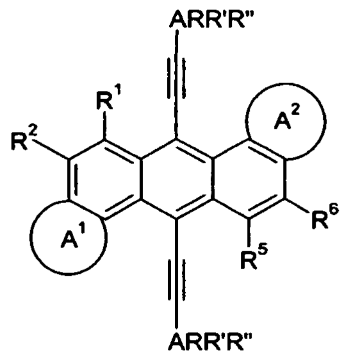

I1

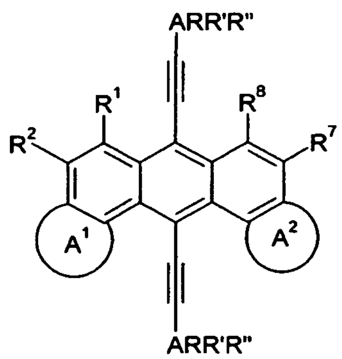

I2

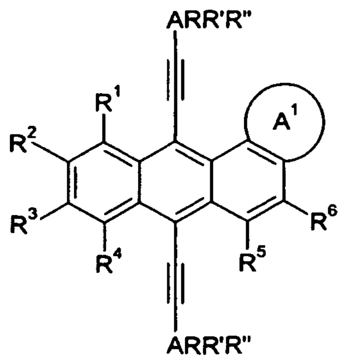

I3

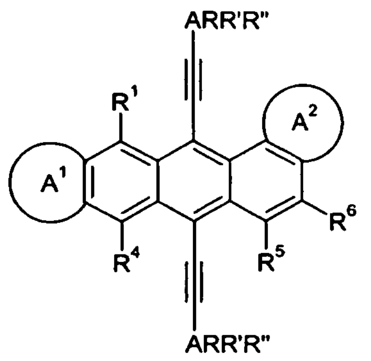

I4

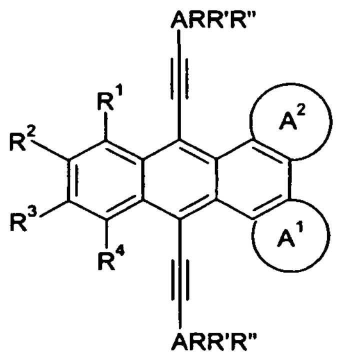

I5

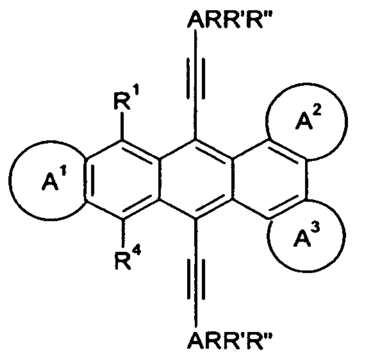

I6

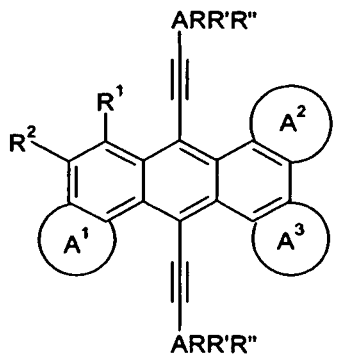

I7

wherein A, R, R' and R" are as defined in formula I, $R^{1-8}$ have one of the meanings of $R^{1-8}$ given in formula I, but are not cross-bridged to form a ring, and $A^1$, $A^2$ and $A^3$ together with the two explicitly shown carbon atoms denote independently of each other an aromatic or heteroaromatic group with 5 to 25 ring atoms, which is mono- or polycyclic, i.e. which may also contain two or more individual rings that are connected to each other via single bonds or contain two or more fused rings, and wherein each ring is unsubstituted or substituted with one or more groups L as defined above.

Very preferably $A^1$, $A^2$ and $A^3$ are selected from the group consisting of benzene, furan, thiophene, selenophene, pyrrole, pyridine, pyrimidine, thiazole, thiadiazole, oxazole, oxadiazole, selenazole, and bi-, tri- or tetracyclic aryl or heteroaryl groups containing one or more of the aforementioned rings and optionally one or more benzene rings, wherein the individual rings are connected by single bonds or fused with each other, and wherein all the aforementioned groups are unsubstituted or substituted with one or more groups L as defined above.

Further preferably $A^1$, $A^2$ and $A^3$ are selected from the group consisting of thieno[3,2-b]thiophene, dithieno[3,2-*b*:2',3'-*d*]thiophene, selenopheno[3,2-b]selenophene, selenopheno[2,3-b]selenophene, selenopheno[3,2-b]-thiophene, selenopheno[2,3-b]thiophene, benzo[1,2-b:4,5-b']dithiophene, 2,2-dithiophene, 2,2-diselenophene, dithieno[3,2-*b*:2',3'-*d*]silole, 4*H*-cyclopenta[2,1-*b*:3,4-*b*']dithiophene, benzo[b]thiophene, benzo[b]selenophene, benzooxazole, benzothiazole, benzoselenazole, wherein all the aforementioned groups are unsubstituted or substituted with one or more groups L as defined above.

Especially preferably $A^1$, $A^2$ and $A^3$ are selected from the group consisting on benzene, thiophene and pyridine, which are unsubstituted or substituted with one or more groups L as defined above.

Very preferred compounds of formula I are selected from the following formulae I1a - I4d:

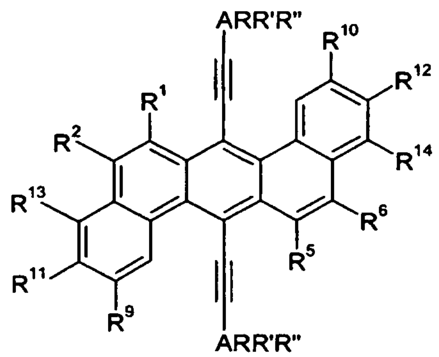

I1a

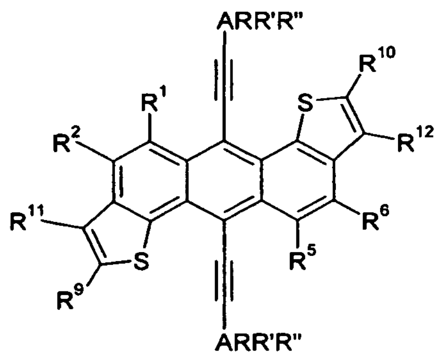

I1b

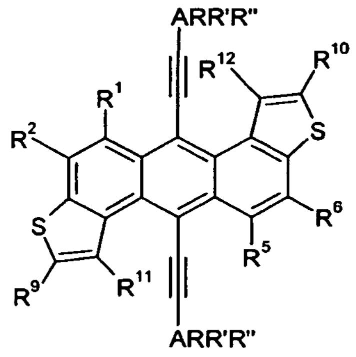

I1c

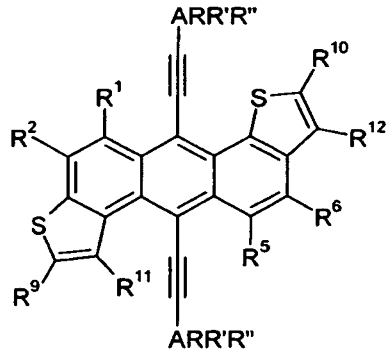

I1d

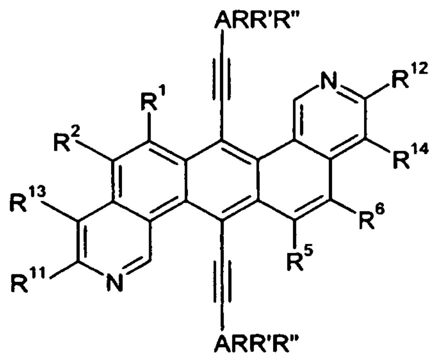

I1e

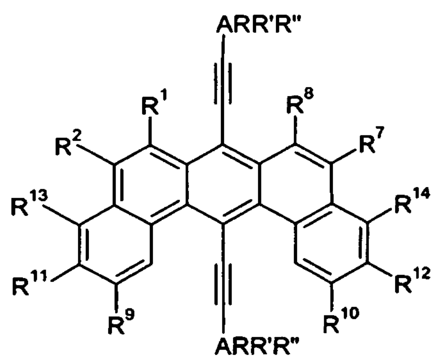

I2a

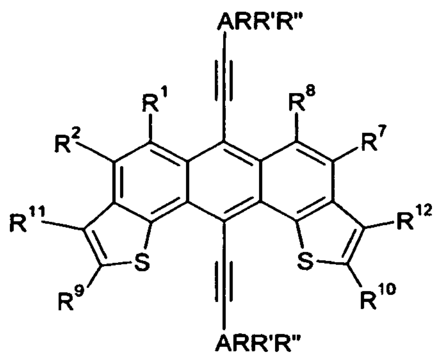

I2b

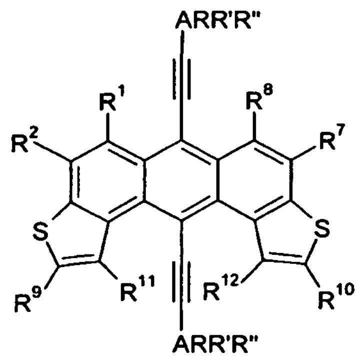

I2c

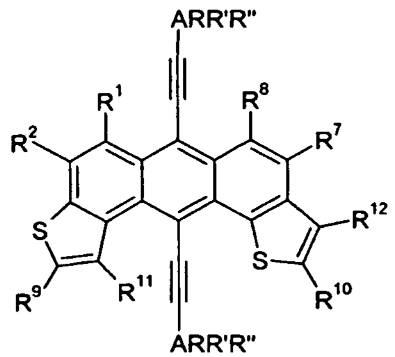

I2d

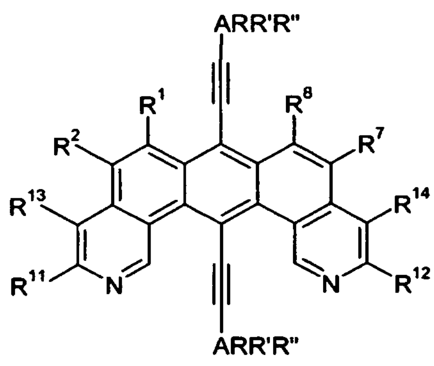

I2e

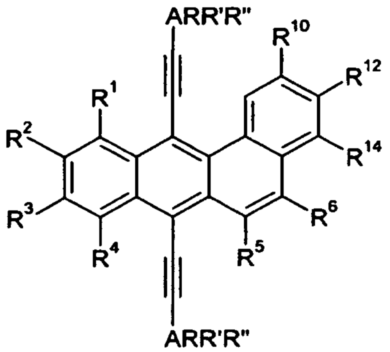

I3a

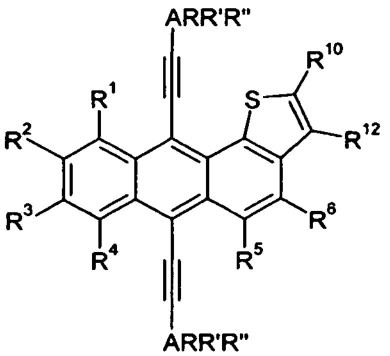

I3b

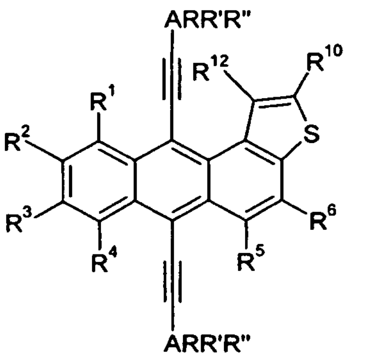

I3c

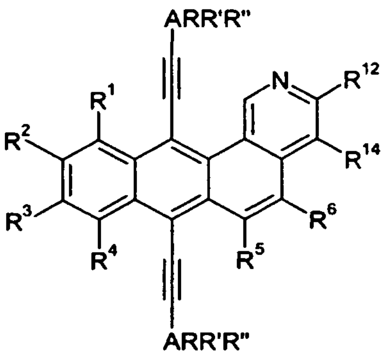

I3d

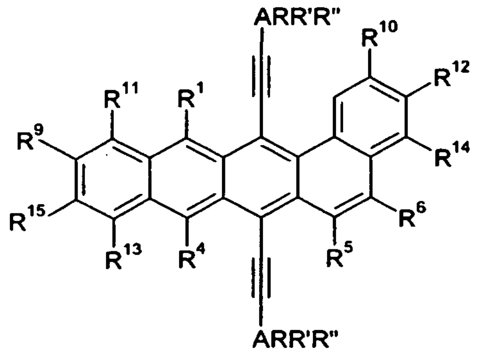

I4a

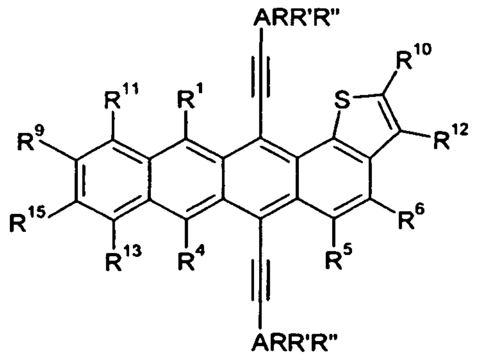

I4b

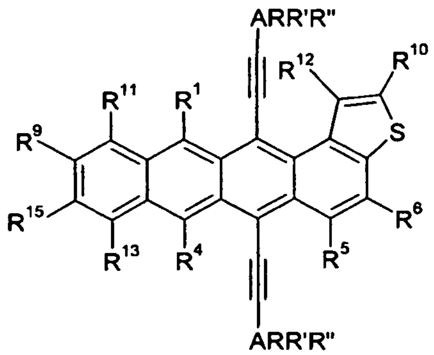

I4c

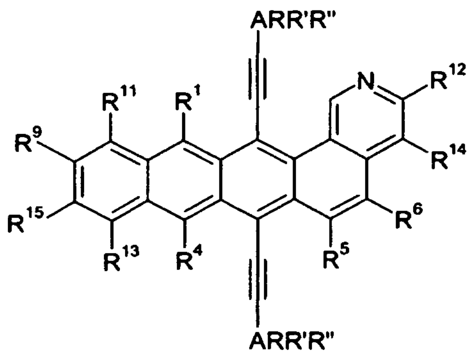

I4d

wherein A, R, R', R" and $R^{1-8}$ are as defined in formulae I1-I6 and $R^{9-15}$ have one of the meanings given for L above, and preferably $R^{11}$, $R^{12}$, $R^{13}$ and $R^{14}$ denote H.

Above and below, an alkyl group or an alkoxy group, i.e. alkyl where the terminal $CH_2$ group is replaced by -O-, can be straight-chain or branched. It is preferably straight-chain, has 2, 3, 4, 5, 6, 7 or 8 carbon atoms and accordingly is preferably ethyl, propyl, butyl, pentyl, hexyl, heptyl, octyl, ethoxy, propoxy, butoxy, pentoxy, hexoxy, heptoxy, or octoxy, furthermore methyl, nonyl, decyl, undecyl, dodecyl, tridecyl, tetradecyl, pentadecyl, methoxy, nonoxy, decoxy, undecoxy,

dodecoxy, tridecoxy or tetradecoxy, for example.

An alkenyl group, i.e. alkyl wherein one or more $CH_2$ groups are replaced by -CH=CH- can be straight-chain or branched. It is preferably straight-chain, has 2 to 10 C atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-, 2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-, 3-, 4-, 5-, 6-, 7-, 8- or dec-9-enyl.

Especially preferred alkenyl groups are $C_2$-$C_7$-1E-alkenyl, $C_4$-$C_7$-3E-alkenyl, $C_5$-$C_7$-4-alkenyl, $C_6$-$C_7$-5-alkenyl and $C_7$-6-alkenyl, in particular $C_2$-$C_7$-1E-alkenyl, $C_4$-$C_7$-3E-alkenyl and $C_5$-$C_7$-4-alkenyl. Examples for particularly preferred alkenyl groups are vinyl, 1 E-propenyl, 1 E-butenyl, 1 E-pentenyl, 1E-hexenyl, 1 E-heptenyl, 3-butenyl, 3E-pentenyl, 3E-hexenyl, 3E-heptenyl, 4-pentenyl, 4Z-hexenyl, 4E-hexenyl, 4Z-heptenyl, 5-hexenyl, 6-heptenyl and the like. Groups having up to 5 C atoms are generally preferred.

An oxaalkyl group, i.e. alkyl where a non-terminal $CH_2$ group is replaced by -O-, is preferably straight-chain 2-oxapropyl (= methoxymethyl), 2-oxabutyl (= ethoxymethyl) or 3-oxabutyl (= 2-methoxyethyl), 2-, 3-, or 4-oxapentyl, 2-, 3-, 4-, or 5-oxahexyl, 2-, 3-, 4-, 5-, or 6-oxaheptyl, 2-, 3-, 4-, 5-, 6- or 7-oxaoctyl, 2-, 3-, 4-, 5-, 6-, 7- or 8-oxanonyl or 2-, 3-, 4-, 5-, 6-,7-, 8- or 9-oxadecyl, for example.

In an alkyl group wherein one $CH_2$ group is replaced by -O- and another $CH_2$ group is replaced by -CO-, these radicals are preferably neighboured. Accordingly these radicals together form a carbonyloxy group -CO-O- or an oxycarbonyl group -O-CO-. Preferably this group is straight-chain and has 2 to 6 C atoms. It is accordingly preferably acetyloxy, propionyloxy, butyryloxy, pentanoyloxy, hexanoyloxy, acetyloxymethyl, propionyloxymethyl, butyryloxymethyl, pentanoyloxymethyl, 2-acetyloxyethyl, 2-propionyloxyethyl, 2-butyryloxyethyl, 3-acetyloxypropyl, 3-propionyloxypropyl, 4-acetyloxybutyl, methoxycarbonyl, ethoxycarbonyl, propoxycarbonyl, butoxycarbonyl, pentoxycarbonyl, methoxycarbonyl-methyl, ethoxycarbonylmethyl, propoxycarbonylmethyl, butoxycarbonyl-methyl, 2-(methoxycarbonyl)ethyl, 2-(ethoxycarbonyl)ethyl, 2-(propoxycarbonyl)-ethyl, 3-(methoxycarbonyl)propyl, 3-(ethoxycarbonyl)propyl, 4-(methoxycarbonyl)-butyl.

An alkyl group wherein two or more $CH_2$ groups are replaced by -O-and/or -COO- can be straight-chain or branched. It is preferably straight-chain and has 3 to 12 C atoms. Accordingly it is preferably bis-carboxy-methyl, 2,2-bis-carboxy-ethyl, 3,3-bis-carboxy-propyl, 4,4-bis-carboxy-butyl, 5,5-bis-carboxy-pentyl, 6,6-bis-carboxy-hexyl, 7,7-bis-carboxy-heptyl, 8,8-bis-carboxy-octyl, 9,9-bis-carboxy-nonyl, 10,10-bis-carboxy-decyl, bis-(methoxycarbonyl)-methyl, 2,2-bis-(methoxycarbonyl)-ethyl, 3,3-bis-(methoxycarbonyl)-propyl, 4,4-bis-(methoxycarbonyl)-butyl, 5,5-bis-(methoxycarbonyl)-pentyl, 6,6-bis-(methoxycarbonyl)-hexyl, 7,7-bis-(methoxycarbonyl)-heptyl, 8,8-bis-(methoxycarbonyl)-octyl, bis-(ethoxy-carbonyl)-methyl, 2,2-bis-(ethoxycarbonyl)-ethyl, 3,3-bis-(ethoxycarbonyl)-propyl, 4,4-bis-(ethoxycarbonyl)-butyl, 5,5-bis-(ethoxycarbonyl)-hexyl.

A thioalkyl group, i.e alkyl where one $CH_2$ group is replaced by -S-, is preferably straight-chain thiomethyl ($-SCH_3$), 1-thioethyl ($-SCH_2CH_3$), 1-thiopropyl (= $-SCH_2CH_2CH_3$), 1-thiobutyl, 1-thiopentyl, 1-thiohexyl, 1-thioheptyl, 1-thiooctyl, 1-thiononyl, 1-thiodecyl, 1-thioundecyl or 1-thiododecyl.

$R^{1-15}$, R', R" and R'" can be an achiral or a chiral group. Particularly preferred chiral groups are 2-butyl (= 1-methylpropyl), 2-methylbutyl, 2-methylpentyl, 3-methylpentyl, 2-ethylhexyl, 2-propylpentyl, in particular 2-methylbutyl, 2-methylbutoxy, 2-methylpentoxy, 3-methylpentoxy, 2-ethyl-hexoxy, 1-methylhexoxy, 2-octyloxy, 2-oxa-3-methylbutyl, 3-oxa-4-methyl-pentyl, 4-methylhexyl, 2-hexyl, 2-octyl, 2-nonyl, 2-decyl, 2-dodecyl, 6-methoxyoctoxy, 6-methyloctoxy, 6-methyloctanoyloxy, 5-methylheptyl-oxycarbonyl, 2-methylbutyryloxy, 3-methylvaleroyloxy, 4-methylhexanoy-loxy, 2-chlorpropionyloxy, 2-chloro-3-methylbutyryloxy, 2-chloro-4-methyl-valeryloxy, 2-chloro-3-methylvaleryloxy, 2-methyl-3-oxapentyl, 2-methyl-3-oxahexyl, 1-methoxypropyl-2-oxy, 1-ethoxypropyl-2-oxy, 1-propoxypropyl-2-oxy, 1-butoxypropyl-2-oxy, 2-fluorooctyloxy, 2-fluorodecyloxy, 1,1,1-trifluoro-2-octyloxy, 1,1,1-trifluoro-2-octyl, 2-fluoromethyloctyloxy for example. Very preferred are 2-hexyl, 2-octyl, 2-octyloxy, 1,1,1-trifluoro-2-hexyl, 1,1,1-trifluoro-2-octyl and 1,1,1-trifluoro-2-octyloxy.

Preferred achiral branched groups are isopropyl, isobutyl (=methylpropyl), isopentyl (=3-methylbutyl), tertiary butyl, isopropoxy, 2-methylpropoxy and 3-methylbutoxy.

$-CY^0=CY^{00}-$ is preferably -CH=CH-, -CF=CF- or -CH=C(CN)-.

Halogen is F, Cl, Br or I, preferably F, Cl or Br.

L is preferably selected from P-Sp-, F, Cl, Br, I, -OH, -CN, $-NO_2$ , -NCO, -NCS, -OCN, -SCN, $-C(=O)NR^0R^{00}$, $-C(=O)X^0$, $-C(=O)R^0$, $-NR^0R^{00}$, C(=O)OH, straight chain, branched or cyclic alkyl, alkoxy, oxaalkyl or thioalkyl with 1 to 20, preferably 1 to 12 C atoms which is unsubstituted or substituted with one or more F or Cl atoms or OH groups or perfluorinated, and straight chain, branched or cyclic alkenyl, alkynyl, alkylcarbonyl, alkoxycarbonyl, alkylcarbonyloxy or alkoxycarbonyloxy with 2 to 20, preferably 2 to 12 C atoms which is unsubstituted or substituted with one or more F or Cl atoms or OH groups or perfluorinated.

The compounds of formula I may also be substituted with a polymerisable or reactive group, which is optionally protected during the process of forming the polymer. Particularly preferred compounds of this type are those of formula I that contain one or more substituents L which denote P-Sp, wherein P is a polymerisable or reactive group and Sp is

a spacer group or a single bond. These compounds are particularly useful as semiconductors or charge transport materials, as they can be crosslinked via the groups P, for example by polymerisation in situ, during or after processing the polymer into a thin film for a semiconductor component, to yield polymer films which are potentially cross-linked with high charge carrier mobility and high thermal, mechanical and chemical stability.

Preferably the polymerisable or reactive group P is selected from $CH_2=CW^1-COO-$, $CH_2=CW^1-CO-$,

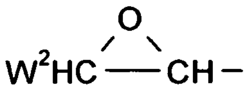

,

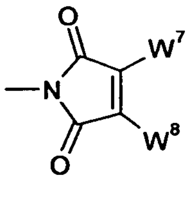

,

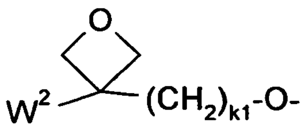

,

$CH_2=CW^2-(O)_{k1}-$, $CH_3-CH=CH-O-$, $(CH_2=CH)_2CH-OCO-$, $(CH_2=CH-CH_2)_2CH-OCO-$, $(CH_2=CH)_2CH-O-$, $(CH_2=CH-CH_2)_2N-$, $(CH_2=CH-CH_2)_2N-CO-$, $HO-CW^2W^3-$, $HS-CW^2W^3-$, $HW^2N-$, $HO-CW^2W^3-NH-$, $CH_2=CW^1-CO-NH-$, $CH_2=CH-(COO)_{k1}-Phe-(O)_{k2}-$, $CH_2=CH-(CO)_{k1}-Phe-(O)_{k2}-$, Phe-CH=CH-, HOOC-, OCN-, and $W^4W^5W^6Si-$, with $W^1$ being H, F, Cl, CN, $CF_3$, phenyl or alkyl with 1 to 5 C-atoms, in particular H, Cl or $CH_3$, $W^2$ and $W^3$ being independently of each other H or alkyl with 1 to 5 C-atoms, in particular H, methyl, ethyl or n-propyl, $W^4$, $W^5$ and $W^6$ being independently of each other Cl, oxaalkyl or oxacarbonylalkyl with 1 to 5 C-atoms, $W^7$ and $W^8$ being independently of each other H, Cl or alkyl with 1 to 5 C-atoms, Phe being 1,4-phenylene that is optionally substituted by one or more groups L as defined above, and $k_1$ and $k_2$ being independently of each other 0 or 1.

Alternatively P is a protected derivative of these groups which is nonreactive under the conditions described for the process according to the present invention. Suitable protective groups are known to the ordinary expert and described in the literature, for example in Green, "Protective Groups in Organic Synthesis", John Wiley and Sons, New York (1981), like for example acetals or ketals.

Especially preferred groups P are $CH_2=CH-COO-$, $CH_2=C(CH_3)-COO-$, $CH_2=CH-$, $CH_2=CH-O$ $(CH_2=CH)_2CH-OCO-$, $(CH_2=CH)_2CH-O-$,

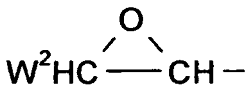

and

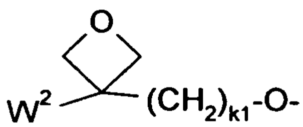

,

or protected derivatives thereof.

Polymerisation of group P can be carried out according to methods that are known to the ordinary expert and described in the literature, for example in D. J. Broer; G. Challa; G. N. Mol, Macromol. Chem, 1991, 192, 59.

The term "spacer group" is known in prior art and suitable spacer groups Sp are known to the ordinary expert (see e.g. Pure Appl. Chem. 73(5), 888 (2001). The spacer group Sp is preferably of formula Sp'-X', such that P-Sp- is P-Sp'-X'-, wherein

Sp' is alkylene with up to 30 C atoms which is unsubstituted or mono- or polysubstituted by F, Cl, Br, I or CN, it being also possible for one or more non-adjacent $CH_2$ groups to be replaced, in each case independently from one another, by -O-, -S-, -NH-, $-NR^0-$, $-SiR^0R^{00}-$, -CO-, -COO-, -OCO-, -OCO-O-, -S-CO-, -CO-S-, -CH=CH- or -C≡C- in such a manner that O and/or S atoms are not linked directly to one another,

X' is -O-, -S-, -CO-, -COO-, -OCO-, -O-COO-, $-CO-NR^0-$, $-NR^0-CO-$, $-NR^0-CO-NR^{00}-$, $-OCH_2-$, $-CH_2O-$ $-SCH_2-$, $-CH_2S-$, $-CF_2O-$, $-OCF_2-$, $-CF_2S-$, $-SCF_2-$, $-CF_2CH_2-$, $-CH_2CF_2-$, $-CF_2CF_2-$, -CH=N-, -N=CH-, -N=N-, $-CH=CR^0-$, $-CY^0=CY^{00}-$, -C≡C-, -CH=CH-COO-, -OCO-CH=CH- or a single bond,

$R^0$ and $R^{00}$ are independently of each other H or alkyl with 1 to 12 C-atoms, and

$Y^0$ and $Y^{00}$ are independently of each other H, F, Cl or CN.

X' is preferably -O-, -S-, $-OCH_2-$, $-CH_2O-$, $-SCH_2-$, $-CH_2S-$, $-CF_2O-$, $-OCF_2-$, $-CF_2S-$, $-SCF_2-$, $-CH_2CH_2-$, $-CF_2CH_2-$, $-CH_2CF_2-$, $-CF_2CF_2-$, -CH=N-, -N=CH-, -N=N-, $-CH=CR^0-$, $-CY^0=CY^{00}-$, -C≡C- or a single bond, in particular -O-, -S-, -C≡C-, $-CY^0=CY^{00}-$ or a single bond. In another preferred embodiment X' is a group that is able to form a conjugated system, such as -C=C- or $-CY^0=CY^{00}-$, or a single bond.

Typical groups Sp' are, for example, $-(CH_2)_p-$, $-(CH_2CH_2O)_q-CH_2CH_2-$, $-CH_2CH_2-S-CH_2CH_2-$ or $-CH_2CH_2-NH-CH_2CH_2-$ or $-(SiR^0R^{00}-O)_p-$, with p being an integer from 2 to 12, q being an integer from 1 to 3 and $R^0$ and $R^{00}$ having the meanings given above.

Preferred groups Sp' are ethylene, propylene, butylene, pentylene, hexylene, heptylene, octylene, nonylene, decylene, undecylene, dodecylene, octadecylene, ethyleneoxyethylene, methyleneoxybutylene, ethylene-thioethylene, ethylene-N-methyl-iminoethylene, 1-methylalkylene, ethenylene, propenylene and butenylene for example.

The compounds of formula I can be synthesized according to or in analogy to methods that are known to the skilled person and are described in the literature. Other methods of preparation can be taken from the examples. Especially preferred and suitable synthesis methods are further described below.

Suitable and preferred synthesis methods for the compounds of the present invention are exemplarily and schematically described in the reaction schemes below, wherein R is a substituted silyl or germyl or carbon group and $A^1$ and $A^2$ are optionally substituted aromatic or heterocyclic groups. Other derivatives with different substituents or rings can be synthesised in analogous manner.

Scheme 1

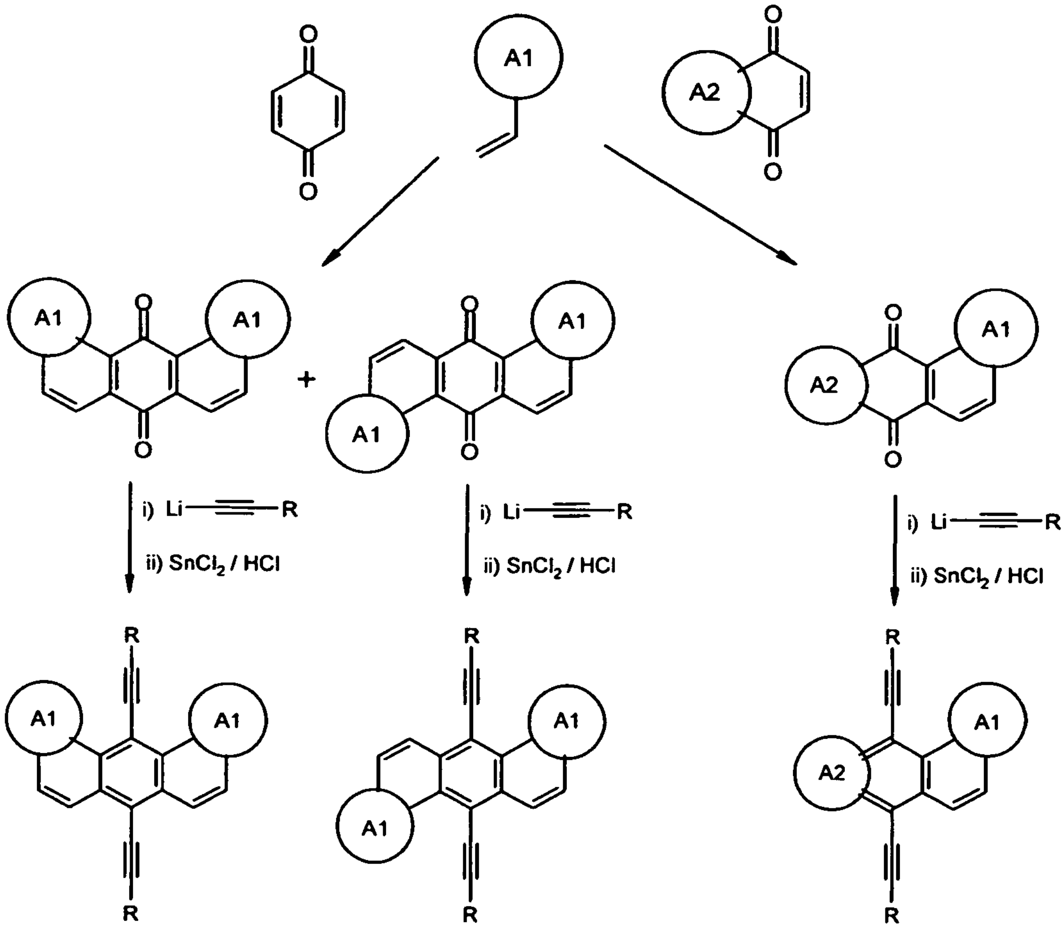

Scheme 2

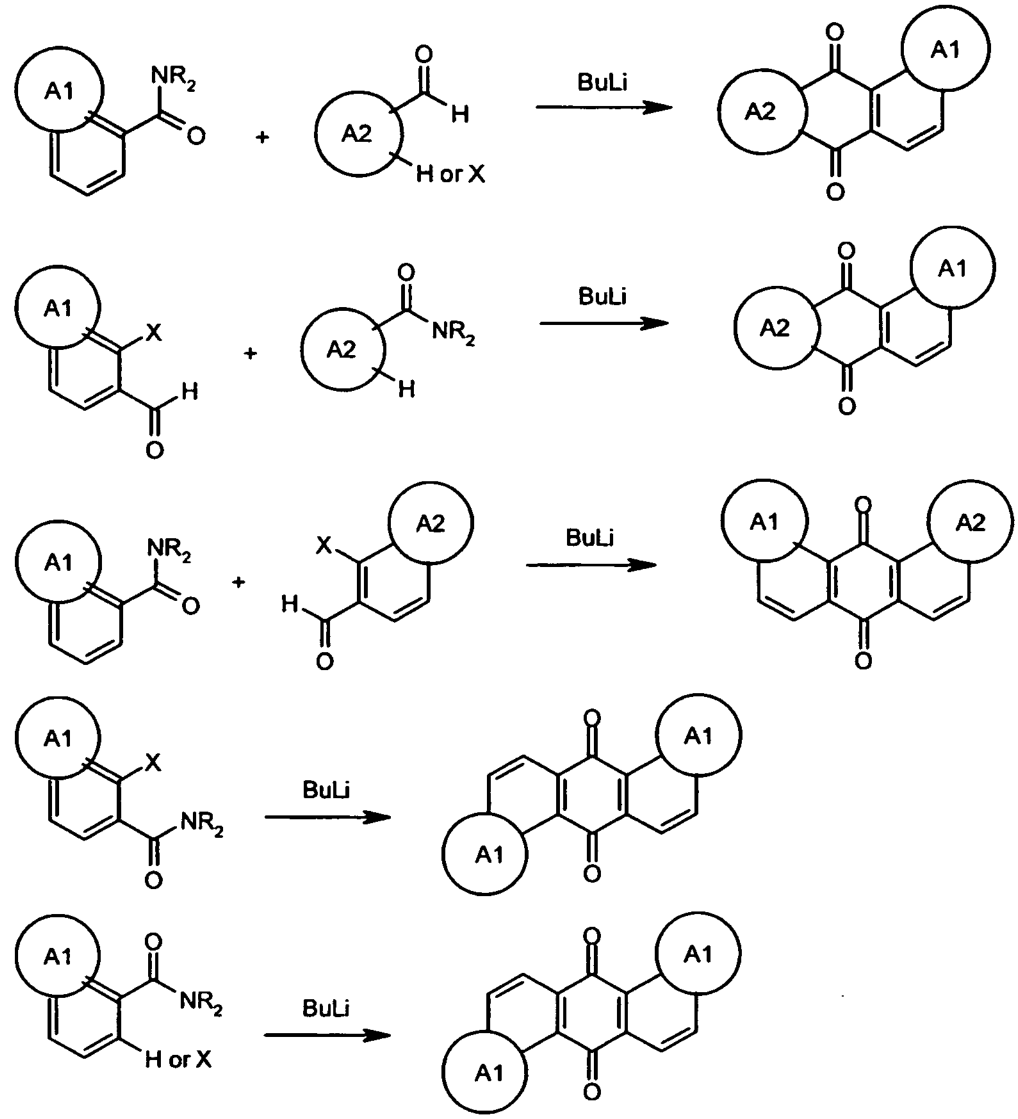


The above routes for preparation of the quinones is described in the literature, for example in M. Watanabe, V. Snieckus, J. Am. Chem. Soc., 1980, 102(4), 1457 and X. Wang, V. Snieckus, Synlett, 1990, 313.

The invention further relates to a formulation comprising one or more compounds of formula I and one or more solvents, preferably selected from organic solvents.

Preferred solvents are aliphatic hydrocarbons, chlorinated hydrocarbons, aromatic hydrocarbons, ketones, ethers and mixtures thereof. Additional solvents which can be used include 1,2,4-trimethylbenzene, 1,2,3,4-tetramethylbenzene, pentylbenzene, mesitylene, cumene, cymene, cyclohexylbenzene, diethylbenzene, tetralin, decalin, 2,6-lutidine, 2-fluoro-m-xylene, 3-fluoro-o-xylene, 2-chlorobenzotrifluoride, dimethylformamide, 2-chloro-6fluorotoluene, 2-fluoroanisole, anisole, 2,3-dimethylpyrazine, 4-fluoroanisole, 3-fluoroanisole, 3-trifluoro-methylanisole, 2-methylanisole, phenetol, 4-methylansiole, 3-methylanisole, 4-fluoro-3-methylanisole, 2-fluorobenzonitrile, 4-fluoroveratrol, 2,6-dimethylanisole, 3-fluorobenzonitrile, 2,5-dimethylanisole, 2,4-dimethylanisole, benzonitrile, 3,5-dimethylanisole, N,N-dimethylaniline, ethyl benzoate, 1-fluoro-3,5-dimethoxybenzene, 1-methylnaphthalene, N-methylpyrrolidinone, 3-fluorobenzotrifluoride, benzotrifluoride, benzotrifluoride, diosane, trifluoromethoxybenzene, 4-fluorobenzotrifluoride, 3-fluoropyridine, toluene, 2-fluorotoluene, 2-fluorobenzotrifluoride, 3-fluorotoluene, 4-isopropylbiphenyl, phenyl ether, pyridine, 4-fluorotoluene, 2,5-difluorotoluene, 1-chloro-2,4-difluorobenzene, 2-fluoropyridine, 3-chlorofluorobenzene, 3-chlorofluorobenzene, 1-chloro-2,5-difluorobenzene, 4-chlorofluorobenzene, chlorobenzene, o-dichlorobenzene, 2-chlorofluorobenzene, p-xylene, m-xylene, o-xylene or mixture of o-, m-, and p-isomers. Solvents with relatively low polarity are generally preferred. For inkjet printing solvents with high boiling temperatures and solvent mixtures are preferred. For spin coating alkylated benzenes like xylene and toluene are preferred.

The invention further relates to an organic semiconducting formulation comprising one or more compounds of

formula I, one or more organic binders or precursors thereof, preferably having a permittivity ε at 1,000 Hz of 3.3 or less, and optionally one or more solvents.

Combining specified soluble compounds of formula I, especially compounds of the preferred formulae as described above and below, with an organic binder resin (hereinafter also referred to as "the binder") results in little or no reduction in charge mobility of the compounds of formula I, even an increase in some instances. For instance, the compounds of formula I may be dissolved in a binder resin (for example poly(α-methylstyrene)) and deposited (for example by spin coating), to form an organic semiconducting layer yielding a high charge mobility. Moreover, a semiconducting layer formed thereby exhibits excellent film forming characteristics and is particularly stable.

If an organic semiconducting layer formulation of high mobility is obtained by combining a compound of formula I with a binder, the resulting formulation leads to several advantages. For example, since the compounds of formula I are soluble they may be deposited in a liquid form, for example from solution. With the additional use of the binder the formulation can be coated onto a large area in a highly uniform manner. Furthermore, when a binder is used in the formulation it is possible to control the properties of the formulation to adjust to printing processes, for example viscosity, solid content, surface tension. Whilst not wishing to be bound by any particular theory it is also anticipated that the use of a binder in the formulation fills in volume between crystalline grains otherwise being void, making the organic semiconducting layer less sensitive to air and moisture. For example, layers formed according to the process of the present invention show very good stability in OFET devices in air.

The invention also provides an organic semiconducting layer which comprises the organic semiconducting layer formulation.

The invention further provides a process for preparing an organic semiconducting layer, said process comprising the following steps:

(i) depositing on a substrate a liquid layer of a formulation comprising one or more compounds of formula I as described above and below, one or more organic binder resins or precursors thereof, and optionally one or more solvents,

(ii) forming from the liquid layer a solid layer which is the organic semiconducting layer,

(iii) optionally removing the layer from the substrate.

The process is described in more detail below.

The invention additionally provides an electronic device comprising the said organic semiconducting layer. The electronic device may include, without limitation, an organic field effect transistor (OFET), organic light emitting diode (OLED), photodetector, sensor, logic circuit, memory element, capacitor or photovoltaic (PV) cell. For example, the active semiconductor channel between the drain and source in an OFET may comprise the layer of the invention. As another example, a charge (hole or electron) injection or transport layer in an OLED device may comprise the layer of the invention. The formulations according to the present invention and layers formed therefrom have particular utility in OFETs especially in relation to the preferred embodiments described herein.

The semiconducting compound of formula I preferably has a charge carrier mobility, μ, of more than 0.001 $cm^2V^{-1}s^{-1}$, very preferably of more than 0.01 $cm^2V^{-1}s^{-1}$, especially preferably of more than 0.1 $cm^2V^{-1}s^{-1}$ and most preferably of more than 0.5 $cm^2V^{-1}s^{-1}$.

The binder, which is typically a polymer, may comprise either an insulating binder or a semiconducting binder, or mixtures thereof may be referred to herein as the organic binder, the polymeric binder or simply the binder.

Preferred binders according to the present invention are materials of low permittivity, that is, those having a permittivity ε at 1,000 Hz of 3.3 or less. The organic binder preferably has a permittivity ε at 1,000 Hz of 3.0 or less, more preferably 2.9 or less. Preferably the organic binder has a permittivity ε at 1,000 Hz of 1.7 or more. It is especially preferred that the permittivity of the binder is in the range from 2.0 to 2.9. Whilst not wishing to be bound by any particular theory it is believed that the use of binders with a permittivity ε of greater than 3.3 at 1,000 Hz, may lead to a reduction in the OSC layer mobility in an electronic device, for example an OFET. In addition, high permittivity binders could also result in increased current hysteresis of the device, which is undesirable.

An example of a suitable organic binder is polystyrene. Further examples of suitable binders are disclosed for example in US 2007/0102696 A1. Especially suitable and preferred binders are described in the following.

In one type of preferred embodiment, the organic binder is one in which at least 95%, more preferably at least 98% and especially all of the atoms consist of hydrogen, fluorine and carbon atoms.

It is preferred that the binder normally contains conjugated bonds, especially conjugated double bonds and/or aromatic rings.

The binder should preferably be capable of forming a film, more preferably a flexible film. Polymers of styrene and α-methylstyrene, for example copolymers including styrene, α-methylstyrene and butadiene may suitably be used.

Binders of low permittivity of use in the present invention have few permanent dipoles which could otherwise lead to random fluctuations in molecular site energies. The permittivity ε (dielectric constant) can be determined by the ASTM D150 test method.

It is also preferred that in the present invention binders are used which have solubility parameters with low polar and hydrogen bonding contributions as materials of this type have low permanent dipoles. A preferred range for the solubility parameters ('Hansen parameter') of a binder for use in accordance with the present invention is provided in Table 1 below.

Table 1

| | Hansen parameter | | |
|---|---|---|---|
| | $\delta_d$ MPa$^{1/2}$ | $\delta_p$ MPa$^{1/2}$ | $\delta_h$ MPa$^{1/2}$ |
| Preferred range | 14.5+ | 0-10 | 0-14 |
| More preferred range | 16+ | 0-9 | 0-12 |
| Most preferred range | 17+ | 0-8 | 0-10 |

The three dimensional solubility parameters listed above include: dispersive ($\delta_d$), polar ($\delta_p$) and hydrogen bonding ($\delta_h$) components (C.M. Hansen, Ind. Eng. and Chem., Prod. Res. and Devl., 9, No. 3, p. 282., 1970). These parameters may be determined empirically or calculated from known molar group contributions as described in Handbook of Solubility Parameters and Other Cohesion Parameters ed. A.F.M. Barton, CRC Press, 1991. The solubility parameters of many known polymers are also listed in this publication.

It is desirable that the permittivity of the binder has little dependence on frequency. This is typical of non-polar materials. Polymers and/or copolymers can be chosen as the binder by the permittivity of their substituent groups. A list of suitable and preferred low polarity binders is given (without limiting to these examples) in Table 2:

Table 2

| Binder | typical low frequency permittivity (ε) |
|---|---|
| polystyrene | 2.5 |
| poly(α-methylstyrene) | 2.6 |
| poly(α-vinylnaphtalene) | 2.6 |
| poly(vinyltoluene) | 2.6 |
| polyethylene | 2.2-2.3 |
| cis-polybutadiene | 2.0 |
| polypropylene | 2.2 |
| polyisoprene | 2.3 |
| poly(4-methyl-1-pentene) | 2.1 |
| poly (4-methylstyrene) | 2.7 |
| poly(chorotrifluoroethylene) | 2.3-2.8 |
| poly(2-methyl-1,3-butadiene) | 2.4 |
| poly(p-xylylene) | 2.6 |
| poly(α-α-α'-α' tetrafluoro-p-xylylene) | 2.4 |
| poly[1,1-(2-methyl propane)bis(4-phenyl)carbonate] | 2.3 |
| poly(cyclohexyl methacrylate) | 2.5 |
| poly(chlorostyrene) | 2.6 |
| poly(2,6-dimethyl-1,4-phenylene ether) | 2.6 |
| polyisobutylene | 2.2 |
| poly(vinyl cyclohexane) | 2.2 |

(continued)

| Binder | typical low frequency permittivity (ε) |
|---|---|
| poly(vinylcinnamate) | 2.9 |
| poly(4-vinylbiphenyl) | 2.7 |

Further preferred binders are poly(1,3-butadiene) and polyphenylene.

Especially preferred are formulations wherein the binder is selected from poly-α-methylstyrene, polystyrene and polytriarylamine or any copolymers of these, and the solvent is selected from xylene(s), toluene, tetralin and cyclohexanone.

Copolymers containing the repeat units of the above polymers are also suitable as binders. Copolymers offer the possibility of improving compatibility with the compounds of formula I, modifying the morphology and/or the glass transition temperature of the final layer composition. It will be appreciated that in the above table certain materials are insoluble in commonly used solvents for preparing the layer. In these cases analogues can be used as copolymers. Some examples of copolymers are given in Table 3 (without limiting to these examples). Both random or block copolymers can be used. It is also possible to add more polar monomer components as long as the overall composition remains low in polarity.

Table 3

| Binder | typical low frequency permittivity (ε) |
|---|---|
| poly(ethylene/tetrafluoroethylene) | 2.6 |
| poly(ethylene/chlorotrifluoroethylene) | 2.3 |
| fluorinated ethylene/propylene copolymer | 2-2.5 |
| polystyrene-co-α-methylstyrene | 2.5-2.6 |
| ethylene/ethyl acrylate copolymer | 2.8 |
| poly(styrene/10%butadiene) | 2.6 |
| poly(styrene/15%butadiene) | 2.6 |
| poly(styrene/2,4 dimethylstyrene) | 2.5 |
| Topas™ (all grades) | 2.2-2.3 |

Other copolymers may include: branched or non-branched polystyrene-block-polybutadiene, polystyrene-block(polyethylene-ran-butylene)-block-polystyrene, polystyrene-block-polybutadiene-block-polystyrene, polystyrene-(ethylene-propylene)-diblock-copolymers (e.g. KRATON®-G1701E, Shell), poly(propylene-co-ethylene) and poly(styrene-co-methylmethacrylate).

Preferred insulating binders for use in the organic semiconductor layer formulation according to the present invention are poly(α-methylstyrene), polyvinylcinnamate, poly(4-vinylbiphenyl), poly(4-methylstyrene), and Topas™ 8007 (linear olefin, cyclo- olefin(norbornene) copolymer available from Ticona, Germany). Most preferred insulating binders are poly(α-methylstyrene), polyvinylcinnamate and poly(4-vinylbiphenyl).

The binder can also be selected from crosslinkable binders, like e.g. acrylates, epoxides, vinylethers, thiolenes etc., preferably having a sufficiently low permittivity, very preferably of 3.3 or less. The binder can also be mesogenic or liquid crystalline.

As mentioned above the organic binder may itself be a semiconductor, in which case it will be referred to herein as a semiconducting binder. The semiconducting binder is still preferably a binder of low permittivity as herein defined. Semiconducting binders for use in the present invention preferably have a number average molecular weight ($M_n$) of at least 1500-2000, more preferably at least 3000, even more preferably at least 4000 and most preferably at least 5000. The semiconducting binder preferably has a charge carrier mobility, μ, of at least $10^{-5}cm^2V^{-1}s^{-1}$, more preferably at least $10^{-4}cm^2V^{-1}s^{-1}$.

A preferred class of semiconducting binder is a polymer as disclosed in US 6,630,566, preferably an oligomer or polymer having repeat units of formula 1:

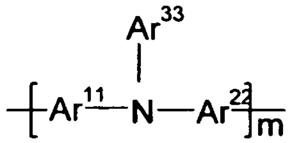

1

wherein

Ar$^{11}$, Ar$^{22}$ and Ar$^{33}$ which may be the same or different, denote, independently if in different repeat units, an optionally substituted aromatic group that is mononuclear or polynuclear, and

m is an integer ≥ 1, preferably ≥ 6, preferably ≥ 10, more preferably ≥ 15 and most preferably ≥ 20.

In the context of Ar$^{11}$, Ar$^{22}$ and Ar$^{33}$, a mononuclear aromatic group has only one aromatic ring, for example phenyl or phenylene. A polynuclear aromatic group has two or more aromatic rings which may be fused (for example naphthyl or naphthylene), individually covalently linked (for example biphenyl) and/or a combination of both fused and individually linked aromatic rings. Preferably each Ar$^{11}$, Ar$^{22}$ and Ar$^{33}$ is an aromatic group which is substantially conjugated over substantially the whole group.

Further preferred classes of semiconducting binders are those containing substantially conjugated repeat units. The semiconducting binder polymer may be a homopolymer or copolymer (including a block-copolymer) of the general formula 2:

$$A_{(c)}B_{(d)}...Z_{(z)} \qquad 2$$

wherein A, B,..., Z each independently represent a monomer unit and (c), (d),...(z) each represent the mole fraction of the respective monomer unit in the polymer, that is each (c), (d),...(z) is a value from 0 to 1 and the total of (c) + (d) +...+ (z) = 1.

Examples of suitable and preferred monomer units A, B,...Z include units of formula 1 above and of formulae 3 to 8 given below (wherein m is as defined in formula 1:

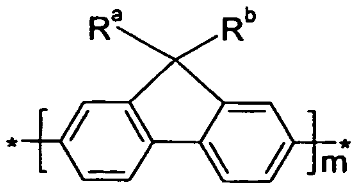

3

wherein

R$^a$ and R$^b$ are independently of each other selected from H, F, CN, $NO_2$, -N(R$^c$)(R$^d$) or optionally substituted alkyl, alkoxy, thioalkyl, acyl, aryl,

R$^c$ and R$^d$ are independently or each other selected from H, optionally substituted alkyl, aryl, alkoxy or polyalkoxy or other substituents,

and wherein the asterisk (*) is any terminal or end capping group including H, and the alkyl and aryl groups are optionally fluorinated;

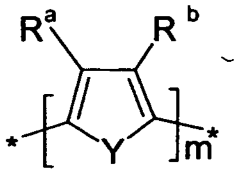

4

wherein

Y is Se, Te, O, S or -N($R^e$)-, preferably O, S or -N($R^e$)-,

$R^e$ is H, optionally substituted alkyl or aryl,

$R^a$ and $R^b$ are as defined in formula 3;

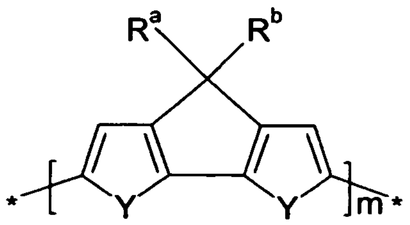

**5**

wherein $R^a$, $R^b$ and Y are as defined in formulae 3 and 4;

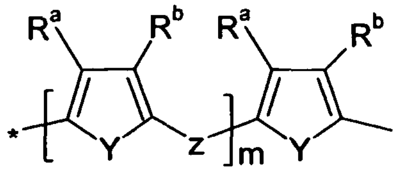

**6**

wherein $R^a$, $R^b$ and Y are as defined in formulae 3 and 4,

Z is -C($T^1$)=C($T^2$)-, -C=C-, -N($R^f$)-, -N=N-, ($R^f$)=N-, -N=C($R^f$)-,

$T^1$ and $T^2$ independently of each other denote H, Cl, F, -CN or alkyl with 1 to 8 C atoms,

$R^f$ is H or optionally substituted alkyl or aryl;

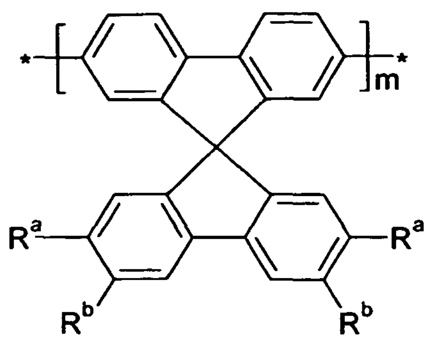

**7**

wherein $R^a$ and $R^b$ are as defined in formula 3;

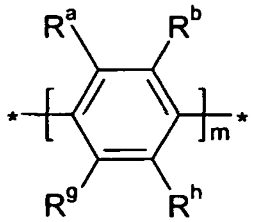

**8**

wherein $R^a$, $R^b$, $R^g$ and $R^h$ independently of each other have one of the meanings of $R^a$ and $R^b$ in formula 3.

In the case of the polymeric formulae described herein, such as formulae 1 to 8, the polymers may be terminated by any terminal group, that is any end-capping or leaving group, including H.

In the case of a block-copolymer, each monomer A, B,...Z may be a conjugated oligomer or polymer comprising a number, for example 2 to 50, of the units of formulae 3-8. The semiconducting binder preferably includes: arylamine, fluorene, thiophene, spirobifluorene and/or optionally substituted aryl (for example phenylene) groups, more preferably arylamine, most preferably triarylamine groups. The aforementioned groups may be linked by further conjugating groups, for example vinylene.

In addition, it is preferred that the semiconducting binder comprises a polymer (either a homopolymer or copolymer, including block-copolymer) containing one or more of the aforementioned arylamine, fluorene, thiophene and/or optionally substituted aryl groups. A preferred semiconducting binder comprises a homopolymer or copolymer (including block-copolymer) containing arylamine (preferably triarylamine) and/or fluorene units. Another preferred semiconducting binder comprises a homopolymer or copolymer (including block-copolymer) containing fluorene and/or thiophene units.

The semiconducting binder may also contain carbazole or stilbene repeat units. For example, polyvinylcarbazole, polystilbene or their copolymers may be used. The semiconducting binder may optionally contain DBBDT segments (for example repeat units as described for formula 1 above) to improve compatibility with the soluble compounds of formula.

Very preferred semiconducting binders for use in the organic semiconductor formulation according to the present invention are poly(9-vinylcarbazole) and PTAA1, a polytriarylamine of the following formula

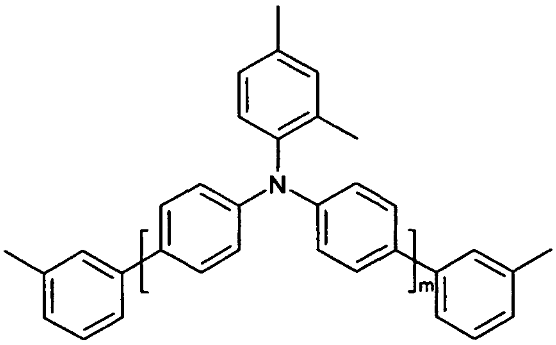

wherein m is as defined in formula 1.

For application of the semiconducting layer in p-channel FETs, it is desirable that the semiconducting binder should have a higher ionisation potential than the semiconducting compound of formula I, otherwise the binder may form hole traps. In n-channel materials the semiconducting binder should have lower electron affinity than the n-type semiconductor to avoid electron trapping.

The formulation according to the present invention may be prepared by a process which comprises:

(i) first mixing a compound of formula I and an organic binder or a precursor thereof. Preferably the mixing comprises mixing the two components together in a solvent or solvent mixture,

(ii) applying the solvent(s) containing the compound of formula I and the organic binder to a substrate; and optionally evaporating the solvent(s) to form a solid organic semiconducting layer according to the present invention,

(iii) and optionally removing the solid layer from the substrate or the substrate from the solid layer.

In step (i) the solvent may be a single solvent or the compound of formula I and the organic binder may each be dissolved in a separate solvent followed by mixing the two resultant solutions to mix the compounds.

The binder may be formed *in situ* by mixing or dissolving a compound of formula I in a precursor of a binder, for example a liquid monomer, oligomer or crosslinkable polymer, optionally in the presence of a solvent, and depositing the mixture or solution, for example by dipping, spraying, painting or printing it, on a substrate to form a liquid layer and then curing the liquid monomer, oligomer or crosslinkable polymer, for example by exposure to radiation, heat or electron beams, to produce a solid layer. If a preformed binder is used it may be dissolved together with the compound of formula I in a suitable solvent, and the solution deposited for example by dipping, spraying, painting or printing it on a substrate to form a liquid layer and then removing the solvent to leave a solid layer. It will be appreciated that solvents are chosen which are able to dissolve both the binder and the compound of formula I and which upon evaporation from the solution blend give a coherent defect-free layer.

Suitable solvents for the binder or the compound of formula I can be determined by preparing a contour diagram for the material as described in ASTM Method D 3132 at the concentration at which the mixture will be employed. The

material is added to a wide variety of solvents as described in the ASTM method.

It will also be appreciated that in accordance with the present invention the formulation may also comprise two or more compounds of formula I and/or two or more binders or binder precursors, and that the process for preparing the formulation may be applied to such formulations.

Examples of suitable and preferred organic solvents include, without limitation, dichloromethane, trichloromethane, monochlorobenzene, o-dichlorobenzene, tetrahydrofuran, anisole, morpholine, toluene, o-xylene, m-xylene, p-xylene, 1,4-dioxane, acetone, methylethylketone, 1,2-dichloroethane, 1,1,1-trichloroethane, 1,1,2,2-tetrachloroethane, ethyl acetate, n-butyl acetate, dimethylformamide, dimethylacetamide, dimethylsulfoxide, tetralin, decalin, indane and/or mixtures thereof.

After the appropriate mixing and ageing, solutions are evaluated as one of the following categories: complete solution, borderline solution or insoluble. The contour line is drawn to outline the solubility parameter-hydrogen bonding limits dividing solubility and insolubility. 'Complete' solvents falling within the solubility area can be chosen from literature values such as published in "Crowley, J.D., Teague, G.S. Jr. and Lowe, J.W. Jr., Journal of Paint Technology, 38, No. 496, 296 (1966)". Solvent blends may also be used and can be identified as described in "Solvents, W.H. Ellis, Federation of Societies for Coatings Technology, p. 9-10, 1986". Such a procedure may lead to a blend of 'non' solvents that will dissolve both the binder and the compound of formula I, although it is desirable to have at least one true solvent in a blend.

Especially preferred solvents for use in the formulation according to the present invention, with insulating or semiconducting binders and mixtures thereof, are xylene(s), toluene, tetralin and o-dichlorobenzene.

The proportions of binder to the compound of formula I in the formulation or layer according to the present invention are typically 20:1 to 1:20 by weight, preferably 10:1 to 1:10 more preferably 5:1 to 1:5, still more preferably 3:1 to 1:3 further preferably 2:1 to 1:2 and especially 1:1. Surprisingly and beneficially, dilution of the compound of formula I in the binder has been found to have little or no detrimental effect on the charge mobility, in contrast to what would have been expected from the prior art.

In accordance with the present invention it has further been found that the level of the solids content in the organic semiconducting layer formulation is also a factor in achieving improved mobility values for electronic devices such as OFETs. The solids content of the formulation is commonly expressed as follows:

$$\text{Solids content (\%)} = \frac{a+b}{a+b+c} \times 100$$

wherein a = mass of compound of formula I, b = mass of binder and c = mass of solvent.

The solids content of the formulation is preferably 0.1 to 10% by weight, more preferably 0.5 to 5% by weight.

Surprisingly and beneficially, dilution of the compound of formula I in the binder has been found to have little or no effect on the charge mobility, in contrast to what would have been expected from the prior art.

The compounds according to the present invention can also be used in mixtures or blends, for example together with other compounds having charge-transport, semiconducting, electrically conducting, photo-conducting and/or light emitting semiconducting properties. Thus, another aspect of the invention relates to a mixture or blend comprising one or more compounds of formula I and one or more further compounds having one or more of the above-mentioned properties. These mixtures can be prepared by conventional methods that are described in prior art and known to the skilled person. Typically the compounds are mixed with each other or dissolved in suitable solvents and the solutions combined.

The formulations according to the present invention can additionally comprise one or more further components like for example surface-active compounds, lubricating agents, wetting agents, dispersing agents, hydrophobing agents, adhesive agents, flow improvers, defoaming agents, deaerators, diluents which may be reactive or non-reactive, auxiliaries, colourants, dyes or pigments, sensitizers, stabilizers, nanoparticles or inhibitors.

It is desirable to generate small structures in modern microelectronics to reduce cost (more devices/unit area) and power consumption. Patterning of the layer of the invention may be carried out by photolithography or electron beam lithography.

Liquid coating of organic electronic devices such as field effect transistors is more desirable than vacuum deposition techniques. The formulations of the present invention enable the use of a number of liquid coating techniques. The organic semiconductor layer may be incorporated into the final device structure by, for example and without limitation, dip coating, spin coating, ink jet printing, letter-press printing, screen printing, doctor blade coating, roller printing, reverse-roller printing, offset lithography printing, flexographic printing, web printing, spray coating, brush coating, pad printing or nozzle printing. The present invention is particularly suitable for use in spin coating the organic semiconductor layer into the final device structure.

Selected formulations of the present invention may be applied to prefabricated device substrates by ink jet printing or microdispensing. Preferably industrial piezoelectric print heads such as but not limited to those supplied by

Aprion, Hitachi-Koki, InkJet Technology, On Target Technology, Picojet, Spectra, Trident, Xaar may be used to apply the organic semiconductor layer to a substrate. Additionally semi-industrial heads such as those manufactured by Brother, Epson, Konica, Seiko Instruments Toshiba TEC or single nozzle microdispensers such as those produced by Microdrop and Microfab may be used.

In order to be applied by ink jet printing or microdispensing, the mixture of the compound of formula I and the binder should be first dissolved in a suitable solvent. Solvents must fulfil the requirements stated above and must not have any detrimental effect on the chosen print head.

Additionally, solvents should have boiling points >100°C, preferably >140°C and more preferably >150°C in order to prevent operability problems caused by the solution drying out inside the print head. Suitable solvents include substituted and non-substituted xylene derivatives, di-$C_{1-2}$-alkyl formamide, substituted and non-substituted anisoles and other phenol-ether derivatives, substituted heterocycles such as substituted pyridines, pyrazines, pyrimidines, pyrrolidinones, substituted and non-substituted *N*,*N*-di-$C_{1-2}$-alkylanilines and other fluorinated or chlorinated aromatics.

A preferred solvent for depositing a formulation according to the present invention by ink jet printing comprises a benzene derivative which has a benzene ring substituted by one or more substituents wherein the total number of carbon atoms among the one or more substituents is at least three. For example, the benzene derivative may be substituted with a propyl group or three methyl groups, in either case there being at least three carbon atoms in total. Such a solvent enables an ink jet fluid to be formed comprising the solvent with the binder and the compound of formula I which reduces or prevents clogging of the jets and separation of the components during spraying. The solvent(s) may include those selected from the following list of examples: dodecylbenzene, 1-methyl-4-tert-butylbenzene, terpineol limonene, isodurene, terpinolene, cymene, diethylbenzene. The solvent may be a solvent mixture, that is a combination of two or more solvents, each solvent preferably having a boiling point >100°C, more preferably >140°C. Such solvent(s) also enhance film formation in the layer deposited and reduce defects in the layer.

The ink jet fluid (that is mixture of solvent, binder and semiconducting compound) preferably has a viscosity at 20°C of 1 to 100 mPa·s, more preferably 1 to 50 mPa·s and most preferably 1 to 30 mPa·s.

The use of the binder in the present invention allows tuning the viscosity of the coating solution, to meet the requirements of particular print heads.

The semiconducting layer of the present invention is typically at most 1 micron (=1μm) thick, although it may be thicker if required. The exact thickness of the layer will depend, for example, upon the requirements of the electronic device in which the layer is used. For use in an OFET or OLED, the layer thickness may typically be 500 nm or less.

In the semiconducting layer of the present invention there may be used two or more different compounds of formula I. Additionally or alternatively, in the semiconducting layer there may be used two or more organic binders of the present invention.

As mentioned above, the invention further provides a process for preparing the organic semiconducting layer which comprises (i) depositing on a substrate a liquid layer of a formulation which comprises one or more compounds of formula I, one or more organic binders or precursors thereof and optionally one or more solvents, and (ii) forming from the liquid layer a solid layer which is the organic semiconducting layer.

In the process, the solid layer may be formed by evaporation of the solvent and/or by reacting the binder resin precursor (if present) to form the binder resin in situ. The substrate may include any underlying device layer, electrode or separate substrate such as silicon wafer or polymer substrate for example.

In a particular embodiment of the present invention, the binder may be alignable, for example capable of forming a liquid crystalline phase. In that case the binder may assist alignment of the compound of formula I, for example such that their aromatic core is preferentially aligned along the direction of charge transport. Suitable processes for aligning the binder include those processes used to align polymeric organic semiconductors and are described in prior art, for example in US 2004/0248338 A1.

The formulation according to the present invention can additionally comprise one or more further components like for example surface-active compounds, lubricating agents, wetting agents, dispersing agents, hydrophobing agents, adhesive agents, flow improvers, defoaming agents, deaerators, diluents, reactive or non-reactive diluents, auxiliaries, colourants, dyes or pigments, furthermore, especially in case crosslinkable binders are used, catalysts, sensitizers, stabilizers, inhibitors, chain-transfer agents or co-reacting monomers.

The present invention also provides the use of the semiconducting compound, formulation or layer in an electronic device. The formulation may be used as a high mobility semiconducting material in various devices and apparatus. The formulation may be used, for example, in the form of a semiconducting layer or film. Accordingly, in another aspect, the present invention provides a semiconducting layer for use in an electronic device, the layer comprising the formulation according to the invention. The layer or film may be less than about 30 microns. For various electronic device applications, the thickness may be less than about 1 micron thick. The layer may be deposited, for example on a part of an electronic device, by any of the aforementioned solution coating or printing techniques.

The compounds and formulations according to the present invention are useful as charge transport, semiconducting, electrically conducting, photo-conducting or light mitting materials in optical, electrooptical, electronic, electroluminescent or photoluminescent components or devices. Especially preferred devices are OFETs, TFTs, ICs, logic circuits, capacitors, RFID tags, OLEDs, OLETs, OPEDs, OPVs, solar cells, laser diodes, photoconductors, photodetectors, electrophotographic devices, electrophotographic recording devices, organic memory devices, sensor devices, charge injection layers, Schottky diodes, planarising layers, antistatic films, conducting substrates and conducting patterns. In these devices, the compounds of the present invention are typically applied as thin layers or films. For example, the compound or formulation may be used as a layer or film, in a field effect transistor (FET) for example as the semiconducting channel, organic light emitting diode (OLED) for example as a hole or electron injection or transport layer or electroluminescent layer, photodetector, chemical detector, photovoltaic cell (PVs), capacitor sensor, logic circuit, display, memory device and the like. The compound or formulation may also be used in electrophotographic (EP) apparatus.

The compound or formulation is preferably solution coated to form a layer or film in the aforementioned devices or apparatus to provide advantages in cost and versatility of manufacture. The improved charge carrier mobility of the compound or formulation of the present invention enables such devices or apparatus to operate faster and/or more efficiently.

Especially preferred electronic devices are OFETs, OLEDs and OPV devices, in particular bulk heterojunction (BHJ) OPV devices. In an OFET, for example, the active semiconductor channel between the drain and source may comprise the layer of the invention. As another example, in an OLED device, the charge (hole or electron) injection or transport layer may comprise the layer of the invention.

For use in OPV devices the polymer according to the present invention is preferably used in a formulation that comprises or contains, more preferably consists essentially of, very preferably exclusively of, a p-type (electron donor) semiconductor and an n-type (electron acceptor) semiconductor. The p-type semiconductor is constituted by a compound according to the present invention. The n-type semiconductor can be an inorganic material such as zinc oxide or cadmium selenide, or an organic material such as a fullerene derivate, for example (6,6)-phenyl-butyric acid methyl ester derivatized methano $C_{60}$ fullerene, also known as "PCBM" or "$C_{60}$PCBM", as disclosed for example in G. Yu, J. Gao, J.C. Hummelen, F. Wudl, A.J. Heeger, Science 1995, Vol. 270, p. 1789 ff and having the structure shown below, or an structural analogous compound with e.g. a $C_{70}$ fullerene group ($C_{70}$PCBM), or a polymer (see for example Coakley, K. M. and McGehee, M. D. Chem. Mater. 2004, 16, 4533).

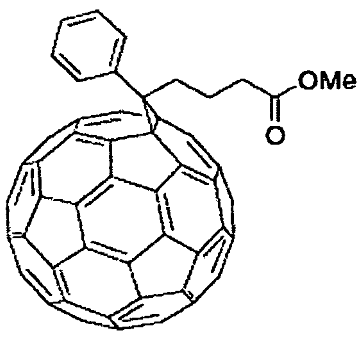

$C_{60}$PCBM

A preferred material of this type is a blend or mixture of an acene compound according to the present invention with a $C_{60}$ or $C_{70}$ fullerene or modified fullerene like PCBM. Preferably the ratio acene:fullerene is from 2:1 to 1:2 by weight, more preferably from 1.2:1 to 1:1.2 by weight, most preferably 1:1 by weight. For the blended mixture, an optional annealing step may be necessary to optimize blend morphology and consequently OPV device performance.

The OPV device can for example be of any type known from the literature [see e.g. Waldauf et al., Appl. Phys. Lett. 89, 233517 (2006)].

A first preferred OPV device according to the invention comprises:

- a low work function electrode (for example a metal, such as aluminum), and a high work function electrode (for example ITO), one of which is transparent,
- a layer (also referred to as "active layer") comprising a hole transporting material and an electron transporting material, preferably selected from OSC materials, situated between the electrodes; the active layer can exist for example as a bilayer or two distinct layers or blend or mixture of p-type and n-type semiconductor, forming a bulk heterjunction (BHJ) (see for example Coakley, K. M. and McGehee, M. D. Chem. Mater. 2004, 16, 4533),
- an optional conducting polymer layer, for example comprising a blend of PEDOT:PSS (poly(3,4-ethylenedioxythiophene): poly(styrene-sulfonate)), situated between the active layer and the high work function electrode, to modify the work function of the high work function electrode to provide an ohmic contact for holes,

- an optional coating (for example of LiF) on the side of the low workfunction electrode facing the active layer, to provide an ohmic contact for electrons.

A second preferred OPV device according to the invention is an inverted OPV device and comprises:

- a low work function electrode (for example a metal, such as gold), and a high work function electrode (for example ITO), one of which is transparent,
- a layer (also referred to as "active layer") comprising a hole transporting material and an electron transporting material, preferably selected from OSC materials, situated between the electrodes; the active layer can exist for example as a bilayer or two distinct layers or blend or mixture of p-type and n-type semiconductor, forming a BHJ,
- an optional conducting polymer layer, for example comprising a blend of PEDOT:PSS, situated between the active layer and the low work function electrode to provide an ohmic contact for electrons,
- an optional coating (for example of $TiO_x$) on the side of the high workfunction electrode facing the active layer, to provide an ohmic contact for holes.

In the OPV devices of the present invent invention the p-type and n-type semiconductor materials are preferably selected from the materials, like the p-type compound/fullerene systems, as described above. If the bilayer is a blend an optional annealing step may be necessary to optimize device performance.

The compound, formulation and layer of the present invention are also suitable for use in an OFET as the semiconducting channel. Accordingly, the invention also provides an OFET comprising a gate electrode, an insulating (or gate insulator) layer, a source electrode, a drain electrode and an organic semiconducting channel connecting the source and drain electrodes, wherein the organic semiconducting channel comprises a compound, formulation or organic semiconducting layer according to the present invention. Other features of the OFET are well known to those skilled in the art.

OFETs where an OSC material is arranged as a thin film between a gate dielectric and a drain and a source electrode, are generally known, and are described for example in US 5,892,244, US 5,998,804, US 6,723,394 and in the references cited in the background section. Due to the advantages, like low cost production using the solubility properties of the compounds according to the invention and thus the processibility of large surfaces, preferred applications of these FETs are such as integrated circuitry, TFT displays and security applications.

The gate, source and drain electrodes and the insulating and semiconducting layer in the OFET device may be arranged in any sequence, provided that the source and drain electrode are separated from the gate electrode by the insulating layer, the gate electrode and the semiconductor layer both contact the insulating layer, and the source electrode and the drain electrode both contact the semiconducting layer.

An OFET device according to the present invention preferably comprises:

- a source electrode,
- a drain electrode,
- a gate electrode,
- a semiconducting layer,
- one or more gate insulator layers,
- optionally a substrate.

wherein the semiconductor layer preferably comprises a compound or formulation as described above and below.

The OFET device can be a top gate device or a bottom gate device. Suitable structures and manufacturing methods of an OFET device are known to the skilled in the art and are described in the literature, for example in US 2007/0102696 A1.

The gate insulator layer preferably comprises a fluoropolymer, like e.g. the commercially available Cytop 809M® or Cytop 107M® (from Asahi Glass). Preferably the gate insulator layer is deposited, e.g. by spin-coating, doctor blading, wire bar coating, spray or dip coating or other known methods, from a formulation comprising an insulator material and one or more solvents with one or more fluoro atoms (fluorosolvents), preferably a perfluorosolvent. A suitable perfluorosolvent is e.g. FC75® (available from Acros, catalogue number 12380). Other suitable fluoropolymers and fluorosolvents are known in prior art, like for example the perfluoro-polymers Teflon AF® 1600 or 2400 (from DuPont) or Fluoropel® (from Cytonix) or the perfluorosolvent FC 43® (Acros, No. 12377). Especially preferred are organic dielectric materials having a low permittivity (or dielectric contant) from 1.0 to 5.0, very preferably from 1.8 to 4.0 ("low k materials"), as disclosed for example in US 2007/0102696 A1 or US 7,095,044.

In security applications, OFETs and other devices with semiconducting materials according to the present invention, like transistors or diodes, can be used for RFID tags or security markings to authenticate and prevent counterfeiting of documents of value like banknotes, credit cards or ID cards, national ID documents, licenses or any product

with monetry value, like stamps, tickets, shares, cheques etc..

Alternatively, the materials according to the invention can be used in OLEDs, e.g. as the active display material in a flat panel display applications, or as backlight of a flat panel display like e.g. a liquid crystal display. Common OLEDs are realized using multilayer structures. An emission layer is generally sandwiched between one or more electron-transport and/or hole-transport layers. By applying an electric voltage electrons and holes as charge carriers move towards the emission layer where their recombination leads to the excitation and hence luminescence of the lumophor units contained in the emission layer. The inventive compounds, materials and films may be employed in one or more of the charge transport layers and/or in the emission layer, corresponding to their electrical and/ or optical properties. Furthermore their use within the emission layer is especially advantageous, if the compounds, materials and films according to the invention show electroluminescent properties themselves or comprise electroluminescent groups or compounds. The selection, characterization as well as the processing of suitable monomeric, oligomeric and polymeric compounds or materials for the use in OLEDs is generally known by a person skilled in the art, see, e.g., Meerholz, Synthetic Materials, 111-112, 2000, 31-34, Alcala, J. Appl. Phys., 88, 2000, 7124-7128 and the literature cited therein.

According to another use, the materials according to this invention, especially those showing photoluminescent properties, may be employed as materials of light sources, e.g. in display devices, as described in EP 0 889 350 A1 or by C. Weder et al., Science, 279, 1998, 835-837.

A further aspect of the invention relates to both the oxidised and reduced form of the compounds according to this invention. Either loss or gain of electrons results in formation of a highly delocalised ionic form, which is of high conductivity. This can occur on exposure to common dopants. Suitable dopants and methods of doping are known to those skilled in the art, e.g. from EP 0 528 662, US 5,198,153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantantion of the dopant into the semiconductor material.

When electrons are used as carriers, suitable dopants are for example halogens (e.g., $I_2$, $Cl_2$, $Br_2$, ICl, $ICl_3$, IBr and IF), Lewis acids (e.g., $PF_5$, $AsF_5$, $SbF_5$, $BF_3$, $BCl_3$, $SbCl_5$, $BBr_3$ and $SO_3$), protonic acids, organic acids, or amino acids (e.g., HF, HCl, $HNO_3$, $H_2SO_4$, $HClO_4$, $FSO_3H$ and $ClSO_3H$), transition metal compounds (e.g., $FeCl_3$, FeOCl, $Fe(ClO_4)_3$, $Fe(4\text{-}CH_3C_6H_4SO_3)_3$, $TiCl_4$, $ZrCl_4$, $HfCl_4$, $NbF_5$, $NbCl_5$, $TaCl_5$, $MoF_5$, $MoCl_5$, $WF_5$, $WCl_6$, $UF_6$ and $LnCl_3$ (wherein Ln is a lanthanoid), anions (e.g., $Cl^-$, $Br^-$, $I^-$, $I_3^-$, $HSO_4^-$, $SO_4^{2-}$, $NO_3^-$, $ClO_4^-$, $BF_4^-$, $PF_6^-$, $AsF_6^-$, $SbF_6^-$, $FeCl_4^-$, $Fe(CN)_6^{3-}$, and anions of various sulfonic acids, such as aryl-$SO_3^-$). When holes are used as carriers, examples of dopants are cations (e.g., $H^+$, $Li^+$, $Na^+$, $K^+$, $Rb^+$ and $Cs^+$), alkali metals (e.g., Li, Na, K, Rb, and Cs), alkaline-earth metals (e.g., Ca, Sr, and Ba), $O_2$, $XeOF_4$, $(NO_2^+)$ $(SbF_6^-)$, $(NO_2^+)$ $(SbCl_6^-)$, $(NO_2^+)$ $(BF_4^-)$, $AgClO_4$, $H_2IrCl_6$, $La(NO_3)_3 \cdot 6H_2O$, $FSO_2OOSO_2F$, Eu, acetylcholine, $R_4N^+$, (R is an alkyl group), $R_4P^+$ (R is an alkyl group), $R_6As^+$ (R is an alkyl group), and $R_3S^+$ (R is an alkyl group).

The conducting form of the compounds of the present invention can be used as an organic "metal" in applications including, but not limited to, charge injection layers and ITO planarising layers in OLED applications, films for flat panel displays and touch screens, antistatic films, printed conductive substrates, patterns or tracts in electronic applications such as printed circuit boards and condensers.

The compounds and formulations according to the present invention may also be suitable for use in organic plasmon-emitting diodes (OPEDs), as described for example in Koller et al., Nature Photonics 2008 (published online September 28, 2008).

According to another use, the materials according to the present invention can be used alone or together with other materials in or as alignment layers in LCD or OLED devices, as described for example in US 2003/0021913. The use of charge transport compounds according to the present invention can increase the electrical conductivity of the alignment layer. When used in an LCD, this increased electrical conductivity can reduce adverse residual dc effects in the switchable LCD cell and suppress image sticking or, for example in ferroelectric LCDs, reduce the residual charge produced by the switching of the spontaneous polarisation charge of the ferroelectric LCs. When used in an OLED device comprising a light emitting material provided onto the alignment layer, this increased electrical conductivity can enhance the electroluminescence of the light emitting material. The compounds or materials according to the present invention having mesogenic or liquid crystalline properties can form oriented anisotropic films as described above, which are especially useful as alignment layers to induce or enhance alignment in a liquid crystal medium provided onto said anisotropic film. The materials according to the present invention may also be combined with photoisomerisable compounds and/or chromophores for use in or as photoalignment layers, as described in US 2003/0021913.

According to another use the materials according to the present invention, especially their water-soluble derivatives (for example with polar or ionic side groups) or ionically doped forms, can be employed as chemical sensors or materials for detecting and discriminating DNA sequences. Such uses are described for example in L. Chen, D. W.

McBranch, H. Wang, R. Helgeson, F. Wudl and D. G. Whitten, Proc. Natl. Acad. Sci. U.S.A. 1999, 96, 12287; D. Wang, X. Gong, P. S. Heeger, F. Rininsland, G. C. Bazan and A. J. Heeger, Proc. Natl. Acad. Sci. U.S.A. 2002, 99, 49; N. DiCesare, M. R. Pinot, K. S. Schanze and J. R. Lakowicz, Langmuir 2002, 18, 7785; D. T. McQuade, A. E. Pullen, T. M. Swager, Chem. Rev. 2000, 100, 2537.

Unless the context clearly indicates otherwise, as used herein plural forms of the terms herein are to be construed as including the singular form and vice versa.

Throughout the description and claims of this specification, the words "comprise" and "contain" and variations of the words, for example "comprising" and "comprises", mean "including but not limited to", and are not intended to (and do not) exclude other components.

It will be appreciated that variations to the foregoing embodiments of the invention can be made while still falling within the scope of the invention. Each feature disclosed in this specification, unless stated otherwise, may be replaced by alternative features serving the same, equivalent or similar purpose. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

The invention will now be described in more detail by reference to the following examples, which are illustrative only and do not limit the scope of the invention.

Examples

Example 1

1.1. Dibenzo[a,h]anthracene-7,14-dione:

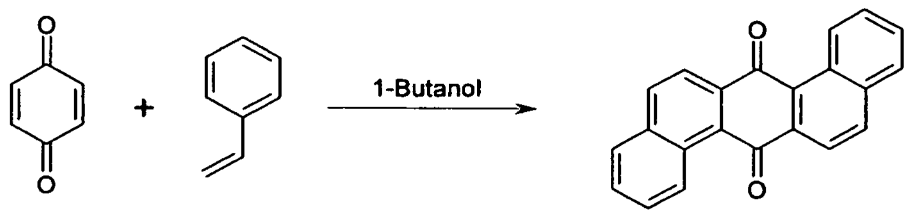


To 1,4-benzoquinone (110 g, 1020 mmol) and vinyl-benzene (233 $cm^3$, 2040 mmol) is added 1-butanol (300 $cm^3$) and the mixture heated at reflux for 17 hours. The mixture is allowed to cool and the solvent removed *in vacuo.* The residue is purified by silica plug (dichloromethane) and then recrystallised twice from acetonitrile to give dibenzo[a,h]anthracene-7,14-dione as an orange solid (5.0 g, 1.6%). $^1H$ NMR (300 MHz, $CDCl_3$) 7.61 - 7.70 (2H, m, ArH), 7.71 - 7.80 (2H, m, ArH), 7.91 (2H, d, ArH, J 8.1), 8.20 (2H, d, ArH, J 8.6), 8.37 (2H, d, ArH, J 8.6), 9.62 (2H, d, ArH, J 8.8); $^{13}C$ NMR (300 MHz, $CDCl_3$) 122.7, 127.9, 128.5, 128.6, 128.7, 130.0, 135.2, 135.6, 136.3, 186.9.

1.2. Dibenzo[a,h]anthracene-7,14-dione:

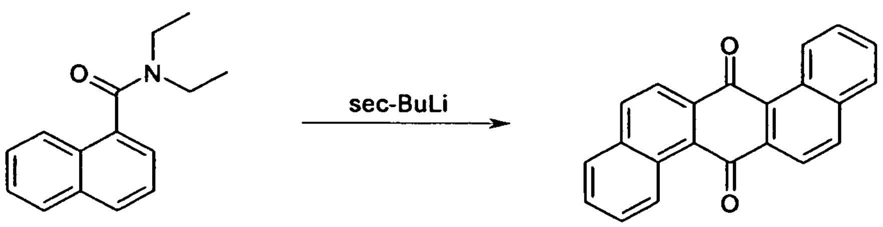

To a solution of naphthalene-1-carboxylic acid diethylamide (1.15 g, 5.0 mmol) in anhydrous tetrahydrofuran (20 $cm^3$) at -78 °C is added sec-butyllithium (11.5 $cm^3$, 15 mmol) dropwise over 30 minutes. The solution is then stirred at -78 °C for 30 minutes and then at 23 °C for 19 hours. The reaction mixture is poured into a vigorously stirred ice/water mix (100 $cm^3$) and triturated for 1 hour. The formed suspension is collected by filtration and washed with water. The solid is triturated in boiling methanol and filtered to give dibenzo[a,h]anthracene-7,14-dione as an orange solid (100 mg, 6.5%).

1.3. Dibenzo[a,j]anthracene-7,14-dione:

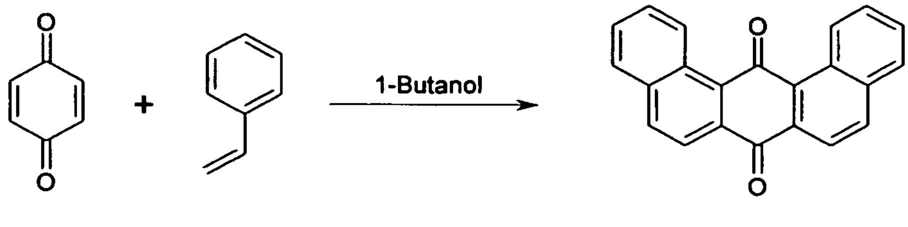


To 1,4-benzoquinone (100 g, 930 mmol) and vinyl-benzene (212 $cm^3$, 1850 mmol) is added 1-butanol (300 $cm^3$) and the mixture heated at reflux for 24 hours. The mixture is allowed to cool and the solvent removed *in vacuo.* The residue is purified by silica plug (dichloromethane) followed by column chromatography (40-60 petrol:dichloromethane; 1:1 to 0:1) and further column chromatography (toluene) to give dibenzo[a,j]anthracene-7,14-dione as an orange solid (0.50 g, 0.2%). $^1H$ NMR (300 MHz, $CDCl_3$) 7.58 - 7.65 (2H, m, ArH), 7.67 - 7.74 (2H, m, ArH), 7.85 - 7.90 (2H, m, ArH), 8.10 (2H, d, ArH, J 8.5), 8.25 (2H, d, ArH, J 8.5), 9.25 - 9.30 (2H, m, ArH); $^{13}C$ NMR (300 MHz, $CDCl_3$) 121.8, 128.4, 128.8, 129.4, 129.8, 132.0, 132.9, 134.3, 136.8, 184.6, 189.9.

1.4. 2.9-Difluoro-dibenzo[a,h]anthracene-7,14-dione:

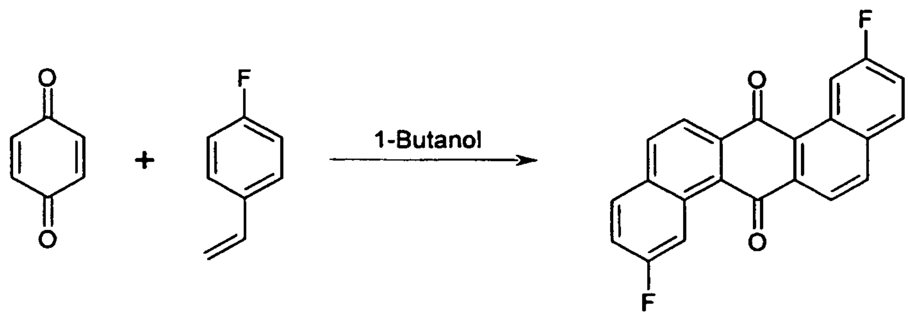


To 1,4-benzoquinone (88.5 g, 820 mmol) and 1-fluoro-4-vinyl-benzene (200 g, 1600 mmol) is added 1-butanol (300 $cm^3$) and the mixture heated at reflux for 24 hours. The mixture is allowed to cool and the solvent removed *in vacuo.* The residue is purified by silica plug (dichloromethane) followed by trituration with hot acetonitrile twice to give 2,9-difluoro-dibenzo[a,h]anthracene-7,14-dione as an orange solid (1.1 g, 0.4%).

1.5. 3,9-Dithia-dicyclopenta[a,h]anthracene-6,12-dione

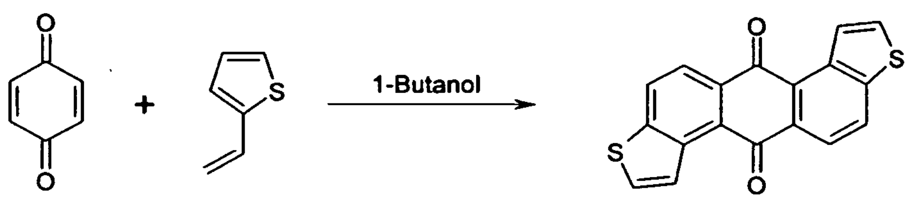

To 1,4-benzoquinone (81 g, 750 mmol) and 2-vinylthiophene (165 g, 1500 mmol) is added 1-butanol (250 $cm^3$) and the mixture heated at reflux for 65 hours. The mixture is allowed to cool and the solvent removed *in vacuo.* The residue is purified by silica plug (dichloromethane) followed by column chromatography (40-60 petrol:dichloromethane; 1:1 to 0:1). Further purification by trituration in hot acetonitrile and recrystallisation from dichloro-methane gives 3,9-dithia-dicyclopenta[a,h]anthracene-6,12-dione as a yellow solid (0.25 g, 0.1%). $^1H$ NMR (300 MHz, DMSO, 120 °C) 8.17 (2H, d, ArH, J 5.5), 8.23 (2H, d, ArH, J 8.4), 8.50 (2H, d, ArH, J 8.4), 8.76 (2H, d, ArH, J 5.5).

Example 2: 7,14-Bis-[(triisopropylsilanyl)-ethynyl]-dibenzo[a,h]anthracene

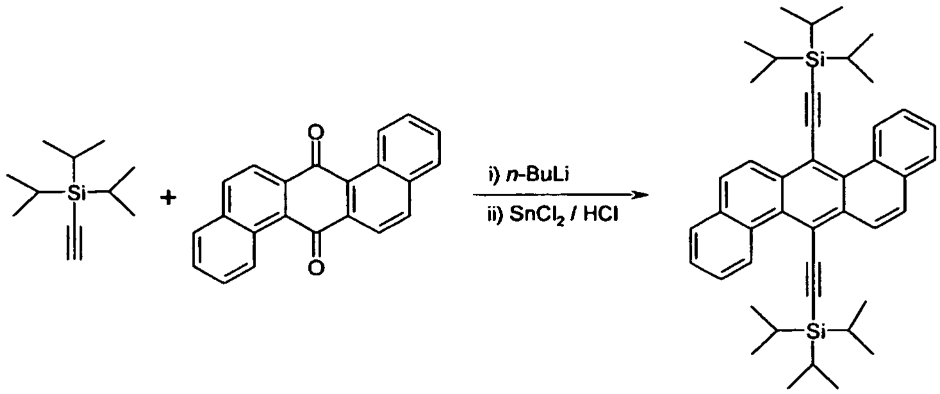


To a solution of (triisopropylsilyl)acetylene (2.7 $cm^3$, 12 mmol) in anhydrous tetrahydrofuran (50 $cm^3$) at 0 °C is added dropwise *n*-butyllithium (4.4 $cm^3$, 11 mmol, 2.5 M in hexanes). After addition, the mixture is stirred at 0 °C for 10 minutes and then at 23 °C for 1 hour. Dibenzo[a,h]-anthracene-7,14-dione (0.75 g, 2.4 mmol) is then added and the reaction mixture stirred at 23 °C for 17 hours. A saturated solution of tin(II)chloride in 10% aqueous hydrochloric acid (20 $cm^3$) is added and the reaction mixture stirred at 50 °C for 1 hour. The mixture allowed to cool and poured into water (300 $cm^3$) and the precipitate collected by filtration. The filtrate is extracted with dichloromethane (2 x 200 $cm^3$) and the combined organic extracts dried over anhydrous magnesium sulfate, filtered and the solvent removed *in vacuo.* The residue is stirred in methanol (100 $cm^3$) and the precipitate collected and combined with the previous precipitate. The crude is purified by column chromatography (40-60 petrol) and then recrystallised from tetrahydrofuran/methanol to give 7,14-bis-[(triisopropyl-silanyl)-ethynyl]-dibenzo[a,h]anthracene as yellow crystals (740 mg, 48%). $^1H$ NMR (300 MHz, $CDCl_3$) 1.21 - 1.41 (42H, m, $CH_3$ and CH), 7.57 - 7.70 (4H, m, ArH), 7.87 (2H, d, ArH, J 9.2), 7.89 - 7.94 (2H, m, ArH), 8.89 (2H, d, ArH, J 9.3), 10.49 - 10.54 (2H, m, ArH); $^{13}C$ NMR (300 MHz, $CDCl_3$) 11.6, 18.9, 106.5, 107.4, 117.5, 125.7, 125.8, 127.6, 127.9, 128.3, 129.0, 129.8, 130.3, 132.9, 134.0.

The DSC curve (1st cycle) measured at 10°C/min for 7,14-bis-[(triisopropyl-silanyl)-ethynyl]-dibenzo[a,h]anthracene, gave a melting point $T_m$ (onset) = 144 °C.

Example 3: 7,14-Bis-triethylsilanylethynyl-dibenzo[a,h]anthracene

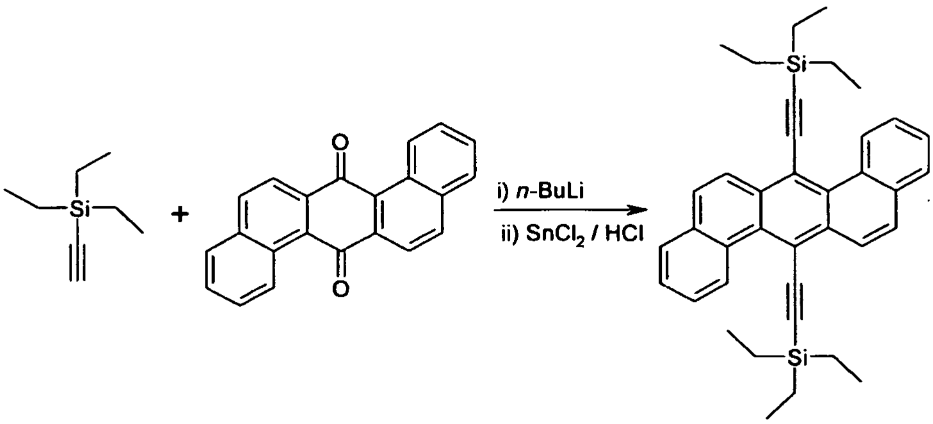


To a solution of (triethylsilyl)acetylene (1.7 g, 12 mmol) in anhydrous tetrahydrofuran (50 $cm^3$) at 0 °C is added dropwise *n*-butyllithium (4.4 $cm^3$, 11 mmol, 2.5 M in hexanes). After addition, the mixture is stirred at 0 °C for 10 minutes and then at 23 °C for 1 hour. Dibenzo[a,h]anthracene-7,14-dione (see Example 1) (0.75 g, 2.4 mmol) is then added and the reaction mixture stirred at 23 °C for 17 hours. A saturated solution of tin (II) chloride in 10% aqueous hydrochloric acid (20 $cm^3$) is added and the reaction mixture stirred at 40 °C for 30 minutes. Water (100 $cm^3$) is added and the product is extracted with dichloromethane (3 x 200 $cm^3$) and the combined organic extracts dried over anhydrous magnesium sulfate, filtered and the solvent removed *in vacuo.* The crude is purified by column chromatography (40-60 petrol with 10% dichloromethane) and then recrystallised from tetrahydrofuran/methanol to give 7,14-bis-triethylsilanylethynyl-dibenzo[a,h]anthracene as yellow crystals (660 mg, 49%). $^1H$ NMR (300 MHz, $CDCl_3$) 0.82 - 0.93 (12H, m, $CH_2$), 1.15 - 1.23 (18H, m, $CH_3$), 7.57 - 7.71 (4H, m, ArH), 7.86 (2H, d, ArH, J 9.1), 7.89 - 7.94 (2H, m, ArH), 8.82 (2H, d, ArH, J 9.3), 10.43 - 10.49 (2H, m, ArH); $^{13}C$ NMR (300 MHz, $CDCl_3$) 4.5, 7.8, 106.7, 107.4, 117.4, 125.5, 125.6, 127.6, 128.0, 128.2, 129.1, 129.8, 130.3, 132.9, 133.7.

The DSC curve (2$^{nd}$ cycle) measured at 10°C/min for 7,14-bis-triethyl-silanylethynyl-dibenzo[a,h]anthracene, gave a melting point $T_m$ (onset) = 90 °C.

Example 4: 7,14-Bis-trimethylsilanylethynyl-dibenzo[a,h]anthracene

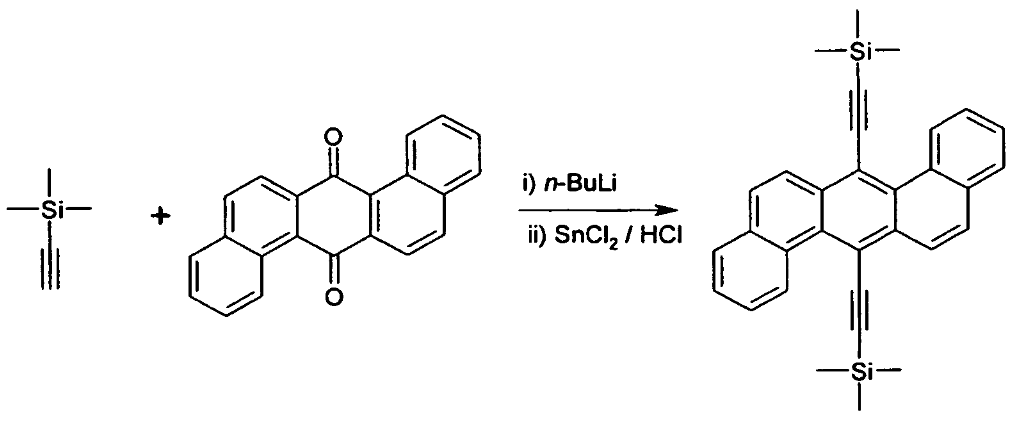


To a solution of (trimethylsilyl)acetylene (1.2 g, 12 mmol) in anhydrous tetrahydrofuran (50 $cm^3$) at 0 °C is added dropwise *n*-butyllithium (4.4 $cm^3$, 11 mmol, 2.5 M in hexanes). After addition, the mixture is stirred at 0 °C for 10 minutes and then at 23 °C for 1 hour. Dibenzo[a,h]anthracene-7,14-dione (see Example 1) (0.75 g, 2.4 mmol) is then added and the reaction mixture stirred at 23 °C for 17 hours. A saturated solution of tin (II) chloride in 10% aqueous hydrochloric acid (20 $cm^3$) is added and the reaction mixture stirred at 60 °C for 1 hour. Water (100 $cm^3$) is added and the product is extracted with dichloromethane (2 x 200 $cm^3$) and the combined organic extracts dried over anhydrous magnesium sulfate, filtered and the solvent removed *in vacuo.* The crude is purified by column chromatography (40-60 petrol with 10% dichloromethane) and then recrystallised from tetrahydrofuran/methanol to give 7,14-bis-trimethylsilanylethynyl-dibenzo[a,h]anthracene as yellow crystals (290 mg, 25%). $^1H$ NMR (300 MHz, $CDCl_3$) 0.44 (18H, s, $CH_3$),

7.60 - 7.71 (4H, m, ArH), 7.87 (2H, d, ArH, J 9.1), 7.90 - 7.95 (2H, m, ArH), 8.75 (2H, d, ArH, J 9.2), 10.32 - 10.38 (2H, m, ArH); $^{13}C$ NMR (300 MHz, $CDCl_3$) -0.2, 105.7, 109.0, 117.2, 125.4, 125.5, 127.7, 128.0, 128.1, 129.1, 129.9, 130.2, 133.0, 133.5.

The DSC curve (2$^{nd}$ cycle) measured at 10°C/min for 7,14-bis-trimethyl-silanylethynyl-dibenzo[a,h]anthracene, gave a melting point $T_m$ (onset) = 243 °C.

Example 5: 7,14-Bis-trimethylsilanylethynyl-dibenzo[a,j]nanthracene

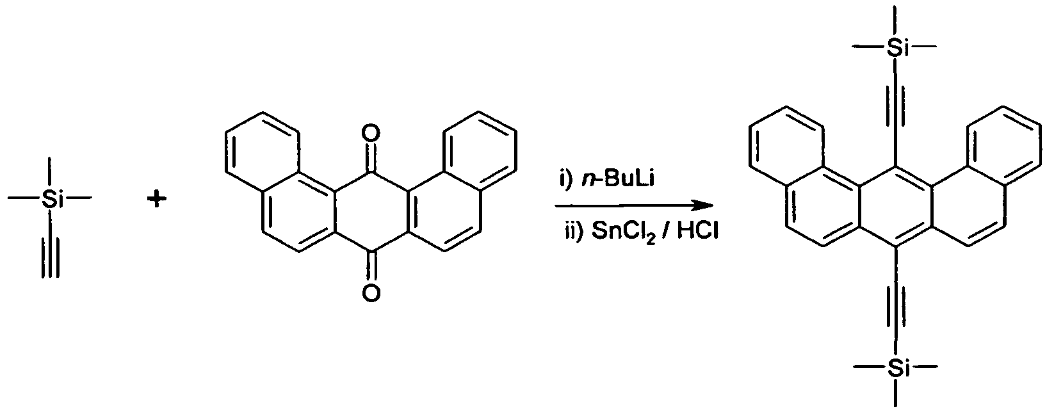


To a solution of (trimethylsilyl)acetylene (0.64 g, 6.5 mmol) in anhydrous tetrahydrofuran (25 $cm^3$) at 0 °C is added dropwise *n*-butyllithium (2.3 $cm^3$, 5.8 mmol, 2.5 M in hexanes). After addition, the mixture is stirred at 0 °C for 10 minutes and then at 23 °C for 1 hour. Dibenzo[a,j]anthracene-7,14-dione (0.40 g, 1.3 mmol) is then added and the reaction mixture stirred at 23 °C for 17 hours. A saturated solution of tin (II) chloride in 10% aqueous hydrochloric acid (10 $cm^3$) is added and the reaction mixture stirred at 50 °C for 1 hour. The mixture is allowed to cool and is poured into water (100 $cm^3$) and the precipitate collected by filtration. The solid is washed with methanol (50 $cm^3$). The crude is purified by column chromatography (40-60 petrol with 10% dichloromethane) and then recrystallised from tetrahydrofuran/methanol to give 7,14-bis-trimethylsilanylethynyl-dibenzo[a,j]-anthracene as yellow crystals (300 mg, 49%). $^1H$ NMR (300 MHz, $CDCl_3$) 0.20 (9H, s, $CH_3$), 0.32 (9H, s, $CH_3$), 7.47 - 7.58 (4H, m, ArH), 7.71 (2H, d, ArH, J 9.0), 7.76 - 7.81 (2H, m, ArH), 8.37 (2H, d, ArH, J 9.0), 10.19 - 10.25 (2H, m, ArH).

The DSC curve (2$^{nd}$ cycle) measured at 10°C/min for 7,14-bis-trimethyl-silanylethynyl-dibenzo[a,j]anthracene, gave a melting point $T_m$ (onset) = 244 °C.

Example 6: 2.9-Difluoro-7,14-bis-[(triisopropylsilanyl)-ethynyl]-dibenzo-[a,h]anthracene

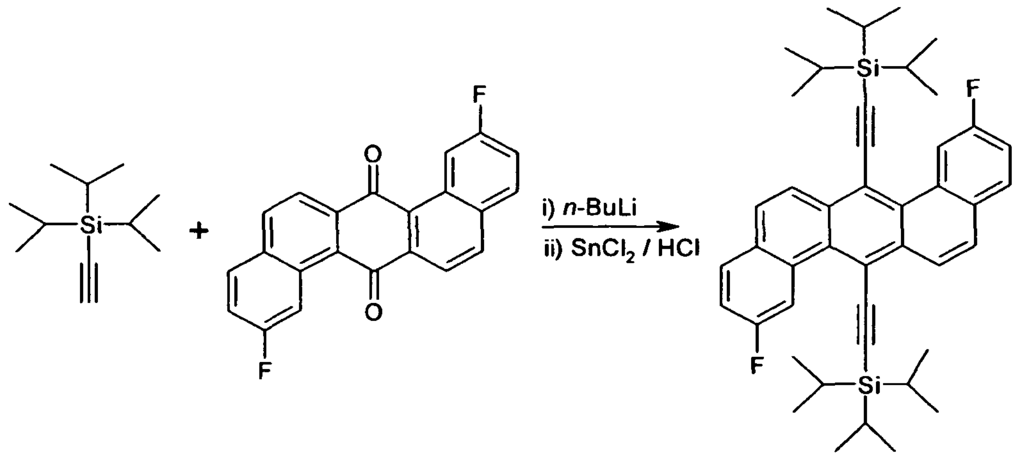

To a solution of (triisopropylsilyl)acetylene (1.6 $cm^3$, 7 mmol) in anhydrous tetrahydrofuran (50 $cm^3$) at 0 °C is added dropwise *n*-butyllithium (2.6 $cm^3$, 6.5 mmol, 2.5 M in hexanes). After addition, the mixture is stirred at 0 °C for 10 minutes and then at 23 °C for 1 hour. 2,9-Difluoro-dibenzo[a,h]-nthracene-7,14-dione (see Example 1) (0.50 g, 1.5 mmol) is then added and the reaction mixture stirred at 23 °C for 17 hours. A saturated solution of tin (II) chloride in 10% aqueous hydrochloric acid (20 $cm^3$) is added and the reaction mixture stirred at 50 °C for 1 hour. Water (100 $cm^3$) added and the product is extracted with dichloromethane (2 x 200 $cm^3$) and the combined organic extracts dried over anhydrous magnesium sulfate, filtered and the solvent removed *in vacuo.* The crude is purified by column chromatography (40-60 petrol with 10% dichloro-methane) and then recrystallised from tetrahydrofuran/methanol to give 2,9-difluoro-7,14-bis-[(triisopropylsilanyl)-ethynyl]-dibenzo[a,h] anthracene as yellow crystals (460 mg, 47%). $^1$H NMR (300 MHz, $CDCl_3$) 1.16 - 1.45 (42H, m, $CH_3$ and CH), 7.37 - 7.46 (2H, m, ArH), 7.80 - 7.93 (4H, m, ArH), 8.83 (2H, d, ArH, J 9.3), 10.23 - 10.31 (2H, m, ArH); $^{13}$C NMR (300 MHz, $CDCl_3$) 11.5, 18.9, 106.7, 108.1, 113.5, 113.8, 116.3, 116.6, 117.8, 125.0, 128.4, 129.2, 129.7, 129.8, 131.7, 131.8, 134.0, 159.0, 162.2.

The DSC curve (1$^{st}$ cycle) measured at 10°C/min for 2,9-difluoro-7,14-bis-[(triisopropylsilanyl)-ethynyl]-dibenzo[a,h] anthracene, gave a melting point $T_m$ (onset) = 115 °C.

Example 7: 2,9-Difluoro-7,14-bis-trimethylsilanylethynyl-dibenzo[a,h]-anthracene

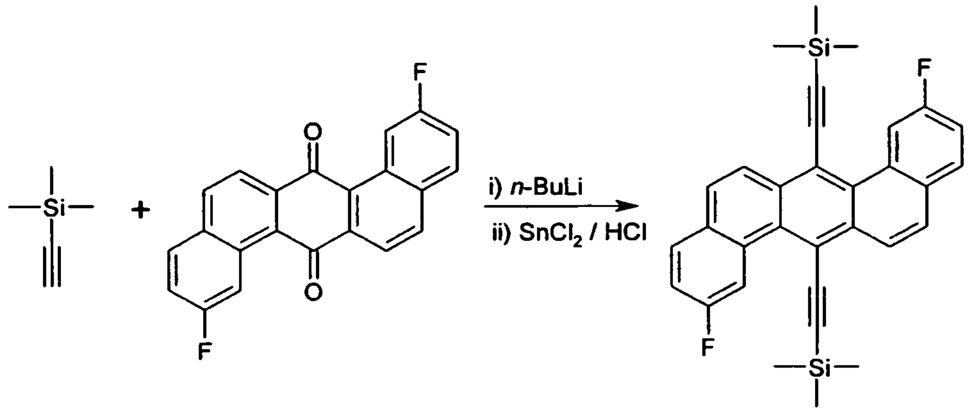


To a solution of (trimethylsilyl)acetylene (0.71 g, 7.3 mmol) in anhydrous tetrahydrofuran (50 $cm^3$) at 0 °C is added dropwise *n*-butyllithium (2.6 $cm^3$, 6.5 mmol, 2.5 M in hexanes). After addition, the mixture is stirred at 0 °C for 10 minutes and then at 23 °C for 1 hour. 2,9-Difluoro-dibenzo[a,h]-anthracene-7,14-dione (see Example 1) (0.50 g, 1.5 mmol) is then added and the reaction mixture stirred at 23 °C for 17 hours. A saturated solution of tin (II) chloride in 10% aqueous hydrochloric acid (20 $cm^3$) is added and the reaction mixture stirred at 50 °C for 1 hour. Water (100 $cm^3$) is added and the product is extracted with dichloromethane (2 x 200 $cm^3$) and the combined organic extracts dried over anhydrous magnesium sulfate, filtered and the solvent removed *in vacuo.* The crude is purified by precipitation from dichloromethane into methanol and then recrystallised from tetrahydrofuran/methanol to give 2,9-difluoro-7,14-bis-trimethylsilanyl-ethynyl-dibenzo[a,h]anthracene as orange crystals (280 mg, 38%). $^1$H NMR (300 MHz, $CDCl_3$) 0.46 (18H, s, $CH_3$), 7.39 - 7.47 (2H, m, ArH), 7.82 - 7.93 (4H, m, ArH), 8.70 (2H, d, ArH, J 9.3), 10.19 - 10.26 (2H, m, ArH).

The DSC curve (3$^{rd}$ cycle) measured at 10°C/min for 2,9-difluoro-7,14-bis-trimethylsilanylethynyl-dibenzo[a,h]anthracene, gave a melting point $T_m$ (onset) = 282 °C.

Example 8: 6,12-Bis-trimethylsilanylethynyl-3,9-dithia-dicyclopenta[a,h]-anthracene

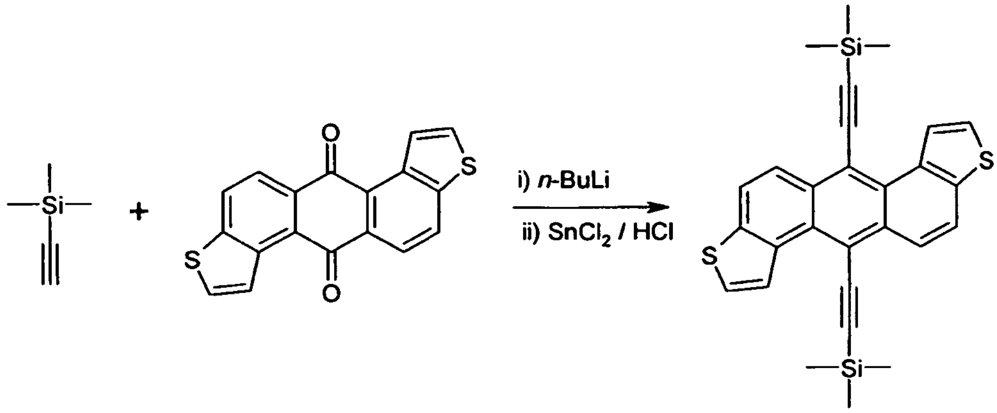


To a solution of (trimethylsilyl)acetylene (0.38 g, 3.9 mmol) in anhydrous tetrahydrofuran (20 $cm^3$) at 0 °C is added dropwise *n*-butyllithium (1.4 $cm^3$, 3.5 mmol, 2.5 M in hexanes). After addition, the mixture is stirred at 0 °C for 10 minutes and then at 23 °C for 1 hour. 3,9-Dithia-dicyclopenta[a,h]-anthracene-6,12-dione (0.25 g, 0.8 mmol) is then added and the reaction mixture stirred at 23 °C for 17 hours. A saturated solution of tin (II) chloride in 10% aqueous hydrochloric acid (10 $cm^3$) is added and the reaction mixture stirred at 50 °C for 1 hour. Water (100 $cm^3$) is added and the product is extracted with dichloromethane (2 x 100 $cm^3$) and the combined organic extracts dried over anhydrous magnesium sulfate, filtered and the solvent removed *in vacuo.* The crude is purified by column chromatography (40-60 petrol with 15% dichloromethane) and then recrystallised from tetrahydrofuran/methanol to give 6,12-bis-trimethylsilanylethynyl-3,9-dithia-dicyclopenta[a,h]anthracene as yellow crystals (80 mg, 21%). $^1$H NMR (300 MHz, $CDCl_3$) 0.45 (9H, s, $CH_3$), 0.47 (9H, s, $CH_3$), 7.60 (2H, d, ArH, J 5.6), 8.02 (2H, d, ArH, J 9.1), 8.60 (2H, d, ArH, J 9.1), 9.68 (2H, d, ArH, J 5.6).

The DSC curve (1$^{st}$ cycle) measured at 10°C/min for 6,12-bis-trimethyl-silanylethynyl-3,9-dithia-dicyclopenta[a,h]anthracene, gave a melting point $T_m$ (onset) = 227 °C.

Example 9: Transistor Fabrication and Measurement

Top-gate thin-film organic field-effect transistors (OFETs) were fabricated on glass substrates with photolithographically defined Au source-drain electrodes. A 2 wt. % solution of the organic semiconductor in mesitylene was spin-coated on top followed by a spin-coated fluoropolymer dielectric material (Lisicon® D139 from Merck, Germany). Finally a photolithographically defined Au gate electrode was deposited. The electrical characterization of the transistor devices was carried out in ambient air atmosphere using computer controlled Agilent 4155C Semiconductor Parameter Analyser. Charge carrier mobility in the saturation regime ($\mu_{sat}$) was calculated for the compound and the results are summarized in Table 4. Field-effect mobility was calculated in the saturation regime ($V_d > (V_g - V_o)$) using equation (1):

$$\left(\frac{dI_d^{sat}}{dV_g}\right)_{V_d} = \frac{WC_i}{L}\mu^{sat}(V_g - V_0) \qquad (1)$$

where W is the channel width, L the channel length, $C_i$ the capacitance of insulating layer, $V_g$ the gate voltage, $V_0$ the turn-on voltage, and $\mu_{sat}$ is the charge carrier mobility in the saturation regime. Turn-on voltage ($V_0$) was determined as the onset of source-drain current.

Table 4. Mobilties ($\mu_{sat}$) for compound examples in top-gate OFETs.

| Example | $\mu_{sat}$ ($cm^2/Vs$) |
|---|---|
| (4) | 1.7 |
| (5) | 0.25 |
| (7) | 0.20 |
| (8) | 0.04 |

**Figure 1** shows the transfer characteristics and the charge carrier mobility of a top-gate OFET prepared as described above, wherein 7,14-bis-tri-methylsilanylethynyl-dibenzo[a,h]anthracene (see Example 4) is used as organic semiconductor.

## Claims

1. Compound of formula I

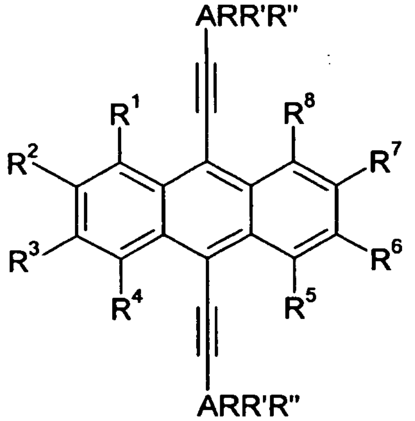

I

wherein the individual groups have the following meanings:

$R^{18}$ independently of each other denote H, F, Cl, Br, I, CN, straight chain, branched or cyclic alkyl, alkoxy, thioalkyl, alkenyl, alkynyl, alkylcarbonyl, alkoxycarbonyl, alkylcarbonyloxy, alkylcarbonylamido, alkylamidocarbonyl or alkoxycarbonyloxy with 1 to 20 C-atoms, which is unsubstituted or substituted by one or more groups L, and wherein one or more non-adjacent $CH_2$ groups are optionally replaced, in each case independently from one another, by -O-, -S-, -$NR^0$-, -$SiR^0R^{00}$-, -$CY^0$=$CY^{00}$- or -C≡C- in such a manner that O and/or S atoms are not linked directly to one another, or denote aryl or heteroaryl with 5 to 20 ring atoms which is unsubstituted or substituted by one or more groups L, or one or more of the pairs $R^1$ and $R^2$, $R^2$ and $R^3$, $R^3$ and $R^4$, $R^5$ and $R^6$, $R^6$ and $R^7$, $R^7$ and $R^8$ are cross-bridged with each other to form a $C_4$-$C_{40}$ saturated or unsaturated ring which is optionally intervened by one or more heteroatoms or groups selected from -O-, -S-, -Se-, -Ge-, -$SiR^0R^{00}$- and -N($R^x$)-, and which is optionally substituted,
A is Si, C or Ge,
R, R', R" are identical or different groups selected from the group consisting of H, straight-chain, branched or cyclic alkyl or alkoxy having 1 to 20 C atoms, straight-chain, branched or cyclic alkenyl having 2 to 20 C atoms, straight-chain, branched or cyclic alkynyl having 2 to 20 C atoms, straight-chain, branched or cyclic alkylcarbonyl having 2 to 20 C atoms, aryl or heteroaryl having 4 to 20 ring atoms, arylalkyl or heteroarylalkyl having 4 to 20 ring atoms, aryloxy or heteroaryloxy having 4 to 20 ring atoms, or aryl-alkyloxy or heteroarylalkyloxy having 4 to 20 ring atoms, wherein all the aforementioned groups are optionally substituted with one or more groups L,
L is selected from P-Sp-, F, Cl, Br, I, -OH, -CN, -$NO_2$, -NCO, -NCS, -OCN, -SCN, -C(=O)$NR^0R^{00}$, -C(=O)$X^0$, -C(=O)$R^0$, -$NR^0R^{00}$, C(=O)OH, optionally substituted aryl or heteroaryl having 4 to 20 ring atoms, or straight chain, branched or cyclic alkyl with 1 to 20, preferably 1 to 12 C atoms wherein one or more non-adjacent $CH_2$ groups are optionally replaced, in each case independently from one another, by -O-, -S-, -$NR^0$-, -$SiR^0R^{00}$-, -$CY^0$=$CY^{00}$- or -C≡C- in such a manner that O and/or S atoms are not linked directly to one another and which is unsubstituted or substituted with one or more F or Cl atoms or OH groups,
P is a polymerisable group,
Sp is a spacer group or a single bond,
$X^0$ is halogen,
$R^x$ has one of the meanings given for $R^1$,
$R^0$, $R^{00}$ independently of each other denote H or alkyl with 1 to 20 C-atoms,
$Y^0$, $Y^{00}$ independently of each other denote H, F, Cl or CN,

**characterized in that**
at least one of the pairs $R^1$ and $R^2$, $R^3$ and $R^4$, $R^5$ and $R^6$, $R^7$ and $R^8$ is cross-bridged with each other to form a

$C_4$-$C_{40}$ saturated or unsaturated ring which is optionally intervened by one or more heteroatoms or groups selected from -O-, -S-, -Se-, -Ge-, -$SiR^0R^{00}$- and -$N(R^x)$- and which is optionally substituted, and
at least one of the pairs $R^1$ and $R^2$, $R^3$ and $R^4$, $R^5$ and $R^6$, $R^7$ and $R^8$ is not cross-bridged with each other to form a ring, and
the compound does not contain a ring atom that is common to more than two rings.

**2.** Compound according to claim 1, wherein A is Si.

**3.** Compound according to claim 1 or 2, wherein R, R' and R" are each independently selected from the group consisting of optionally substituted and straight-chain, branched or cyclic alkyl or alkoxy having 1 to 10 C atoms, optionally substituted and straight-chain, branched or cyclic alkenyl, alkynyl or alkylcarbonyl having 2 to 12 C atoms, and optionally substituted aryl, heteroaryl, arylalkyl or heteroarylalkyl, aryloxy or heteroaryloxy having 5 to 10 ring atoms.

**4.** Compound according to one or more of claims 1 to 3, **characterized in that** one, two or three of the pairs $R^1$ and $R^2$, $R^2$ and $R^3$, $R^3$ and $R^4$, $R^5$ and $R^6$, $R^6$ and $R^7$, $R^7$ and $R^8$ is cross-bridged with each other to form a $C_4$-$C_{40}$ saturated or unsaturated ring which is optionally intervened by one or more heteroatoms or groups selected from -O-, -S-, -Se-, -Ge-, -$SiR^0R^{00}$- and -$N(R^x)$-, and which is optionally substituted.

**5.** Compound according to one or more of claims 1 to 4, **characterized in that** at least the pair $R^7$ and $R^8$ is cross-bridged with each other to form a $C_4$-$C_{40}$ saturated or unsaturated ring which is optionally intervened by one or more heteroatoms or groups selected from -O-, -S-, -Se-, -Ge-, -$SiR^0R^{00}$- and -$N(R^x)$- and which is optionally substituted.

**6.** Compound according to one or more of claims 1 to 5, **characterized in that** not more than one of the two pairs $R^1$ and $R^2$ and $R^3$ and $R^4$, and not more than one of the two pairs $R^5$ and $R^6$ and $R^7$ and $R^8$, is cross-bridged with each other to form a ring.

**7.** Compound according to one or more of claims 1 to 6, **characterized in that** said ring formed by the cross-bridged pair $R^1$ and $R^2$, $R^2$ and $R^3$, $R^3$ and $R^4$, $R^5$ and $R^6$, $R^6$ and $R^7$, $R^7$ and $R^8$ is selected from the group consisting of aromatic and heteroaromatic groups with 5 to 25 ring atoms, which are mono- or polycyclic and may also contain two or more individual rings that are connected to each other via single bonds, or contain two or more fused rings, and wherein each ring is unsubstituted or substituted with one or more groups L as defined in claim 1.

**8.** Compound according to one or more of claims 1 to 7, **characterized in that** said ring formed by the cross-bridged pair $R^1$ and $R^2$, $R^2$ and $R^3$, $R^3$ and $R^4$, $R^5$ and $R^6$, $R^6$ and $R^7$, $R^7$ and $R^8$ is selected from the group consisting of benzene, furan, thiophene, selenophene, pyrrole, pyridine, pyrimidine, thiazole, thiadiazole, oxazole, oxadiazole, selenazole, thieno[3,2-b]thiophene, dithieno[3,2-*b*:2',3'-*d*]thiophene, selenopheno[3,2-b]selenophene, selenopheno[2,3-b]selenophene, selenopheno[3,2-b]thiophene, selenopheno[2,3-b]thiophene, benzo[1,2-b:4,5-b']dithiophene, 2,2-dithiophene, 2,2-diselenophene, dithieno[3,2-*b*:2',3'-*d*]silole, 4*H*-cyclopenta[2,1-*b*:3,4-*b*']dithiophene, benzo[b]thiophene, benzo[b]selenophene, benzooxazole, benzo-thiazole, benzoselenazole, wherein all the aforementioned groups are unsubstituted or substituted with one or more groups L as defined in claim 1.

**9.** Compound according to one or more of claims 1 to 8, **characterized in that** said ring formed by the cross-bridged pair $R^1$ and $R^2$, $R^2$ and $R^3$, $R^3$ and $R^4$, $R^5$ and $R^6$, $R^6$ and $R^7$, $R^7$ and $R^8$ is selected from the group consisting of benzene, thiophene and pyridine, which are unsubstituted, or substituted with one or more groups L as defined in claim 1.

**10.** Compound according to one or more of claims 1 to 9, **characterized in that** the groups $R^1$, $R^2$, $R^3$, $R^4$, $R^5$, $R^6$, $R^7$ and $R^8$, which are not cross-bridged with each other to form a ring, are selected from the group consisting of H, F, Cl, Br, I, -CN, and straight chain, branched or cyclic alkyl, alkoxy, thioalkyl, alkenyl, alkynyl, alkylcarbonyl, alkoxycarbonyl, alkylcarbonyloxy, alkylcarbonylamido, alkylamidocarbonyl or alkoxycarbonyloxy with 1 to 20, preferably 1 to 12 C atoms which is unsubstituted or substituted with one or more F or Cl atoms or OH groups or perfluorinated, and aromatic and heteroaromatic groups with 4 to 25 ring atoms, which are mono- or polycyclic, i.e. which may also contain two or more individual rings that are connected to each other via single bonds, or contain two or more fused rings, and wherein each ring is unsubstituted or substituted with one or more groups L as defined in claim 1.

**11.** Compound according to one or more of claims 1 to 9, **characterized in that** the groups $R^1$, $R^2$, $R^3$, $R^4$, $R^5$, $R^6$, $R^7$ and $R^8$, which are not cross-bridged with each other to form a ring, are selected from the group consisting of phenylene, furan, thiophene, selenophene, N-pyrrole, pyridine, pyrimidine, thiazole, thiadiazole, oxazole, oxadiazole,

selenazole, and bi-, tri- or tetracyclic aryl or heteroaryl groups containing one or more of the aforementioned rings and optionally one or more benzene rings, wherein the individual rings are connected by single bonds or fused with each other, and wherein all the aforementioned groups are unsubstituted, or substituted with one or more groups L as defined above.

**12.** Compound according to one or more of claims 1 to 11, **characterized in that** the groups $R^1$, $R^2$, $R^3$, $R^4$, $R^5$, $R^6$, $R^7$ and $R^8$, which are not cross-bridged with each other to form a ring, are selected from the group consisting of thieno[3,2-b]thiophene, dithieno[3,2-*b*:2',3'-*d*]thiophene, selenopheno[3,2-b]selenophene, selenopheno[2,3-b]selenophene, selenopheno[3,2-b]thiophene, selenopheno[2,3-b]thiophene, benzo[1,2-b:4,5-b']dithiophene, 2,2-dithiophene, 2,2-diselenophene, dithieno[3,2-*b*:2',3'-*d*]silole, 4*H*-cyclopenta[2,1-*b*:3,4-*b*']dithiophene, benzo[b]thiophene, benzo[b]selenophene, benzooxazole, benzothiazole, benzoselenazole, wherein all the aforementioned groups are unsubstituted, or substituted with one or more groups L as defined above.

**13.** Compound according to one or more of claims 1 to 12, **characterized in that** at least two of $R^1$, $R^4$, $R^5$ and $R^8$ denote H.

**14.** Compound according to one or more of claims 1 to 13, **characterized in that** at least one of $R^1$ and $R^5$ denotes H and at least one of $R^4$ and $R^8$ denotes H.

**15.** Compounds according to one or more of claims 1 to 14, **characterized in that** they are selected from the following formulae I1 to I7:

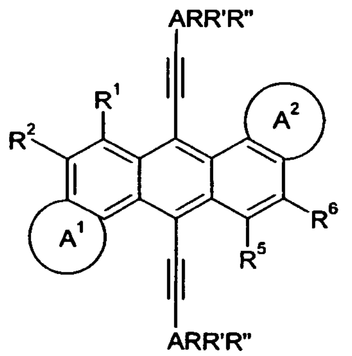

I1

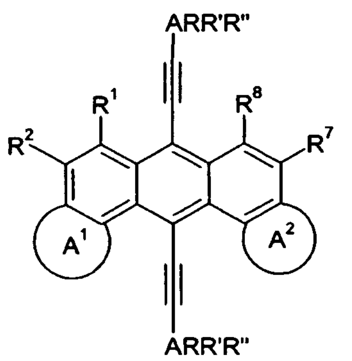

I2

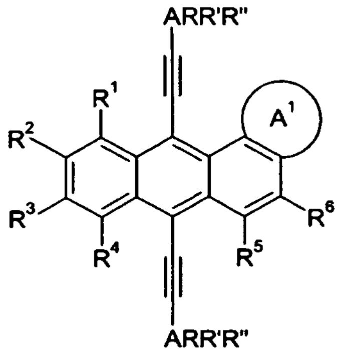

I3

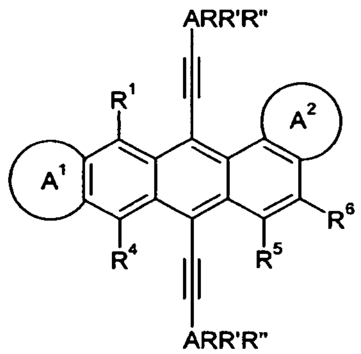

I4

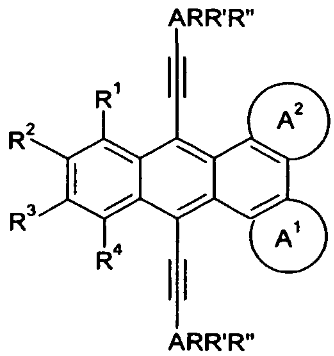

I5

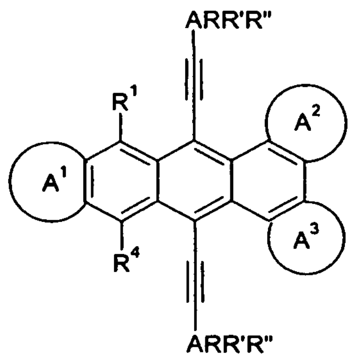

I6

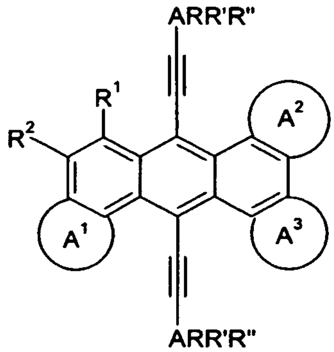

I7

wherein A, R, R' and R" are as defined in claim 1, $R^{1-8}$ have one of the meanings of $R^1$ given in claim 1 but are not cross-bridged to form a ring, and $A^1$, $A^2$ and $A^3$ denote independently of each other an aromatic or heteroaromatic group with 5 to 25 ring atoms, which is mono- or polycyclic, i.e. which may also contain two or more individual rings that are connected to each other via single bonds, or contain two or more fused rings, and wherein each ring is unsubstituted or substituted with one or more groups L as defined in claim 1.

**16.** Compound according to claim 15, **characterized in that** $A^1$, $A^2$ and $A^3$ are selected from the group consisting of benzene, furan, thiophene, selenophene, pyrrole, pyridine, pyrimidine, thiazole, thiadiazole, oxazole, oxadiazole, selenazole, thieno[3,2-b]thiophene, dithieno[3,2-*b*:2',3'-*d*]thiophene, selenopheno[3,2-b]selenophene, selenopheno-[2,3-b]selenophene, selenopheno[3,2-b]thiophene, selenopheno[2,3-b]thiophene, benzo[1,2-b:4,5-b']dithiophene, 2,2-dithiophene, 2,2-diselenophene, dithieno[3,2-*b*:2',3'-d]silole, 4*H*-cyclopenta[2,1-*b*:3,4-*b*']dithiophene, benzo[b]thiophene, benzo[b]selenophene, benzooxazole, benzothiazole, benzoselenazole, wherein all the aforementioned groups are unsubstituted or substituted with one or more groups L as defined in claim 1.

**17.** Compound according to claim 15 or 16, **characterized in that** $A^1$, $A^2$ and $A^3$ are selected from the group consisting on benzene, thiophene and pyridine, which are unsubstituted or substituted with one or more groups L as defined in claim 1.

**18.** Compound according to one or more of claims 1 to 17, **characterized in that** they are selected from the following formulae I1a to I4d:

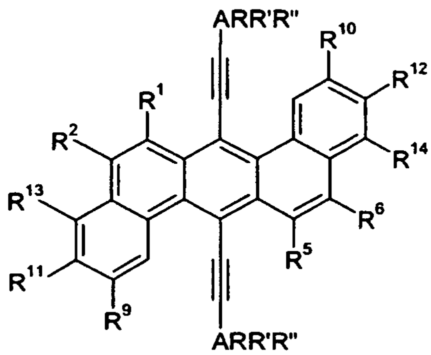

I1a

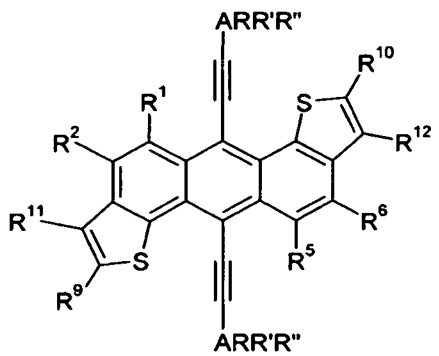

I1b

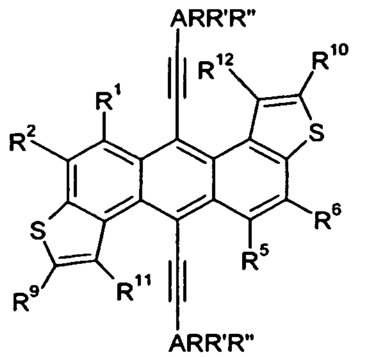

I1c

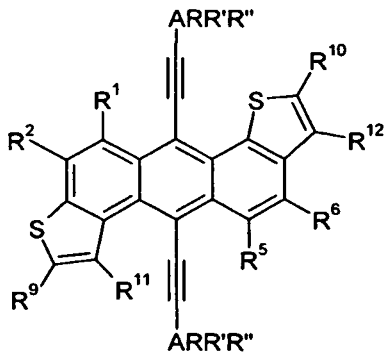

I1d

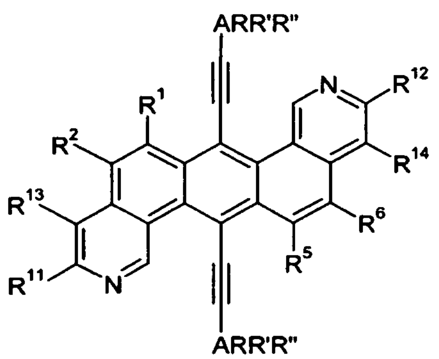

I1e

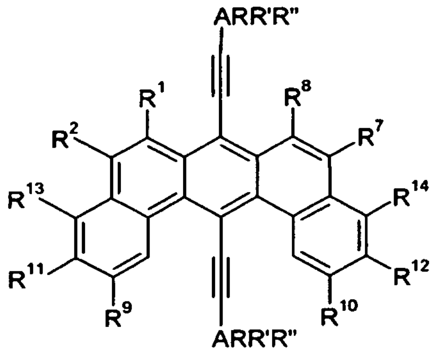

I2a

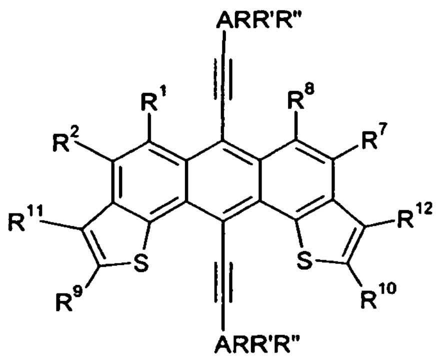

I2b

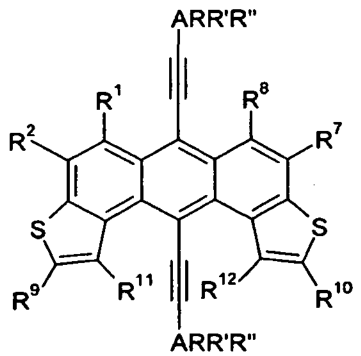

I2c

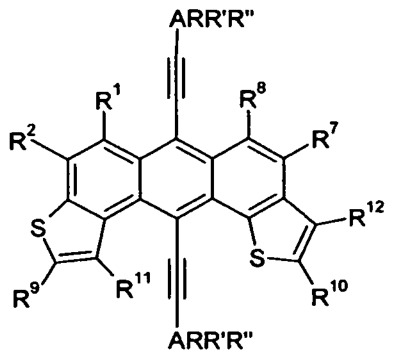

I2d

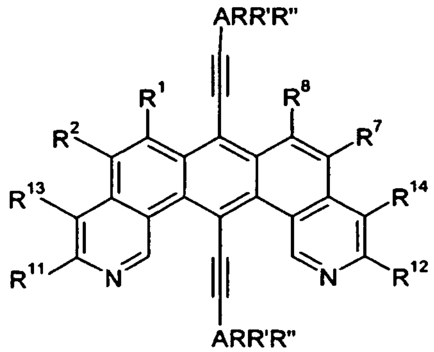

I2e

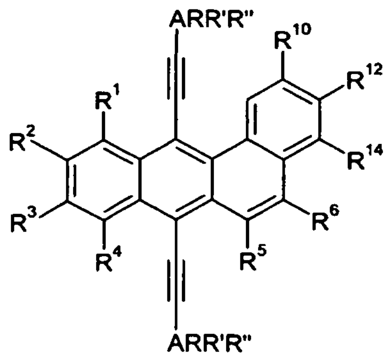

I3a

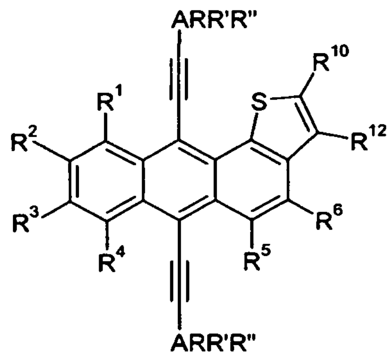

I3b

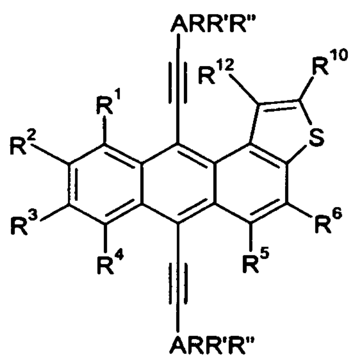

I3c

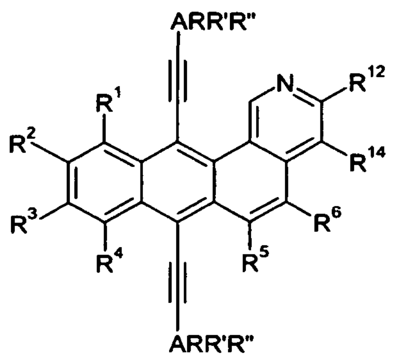

I3d

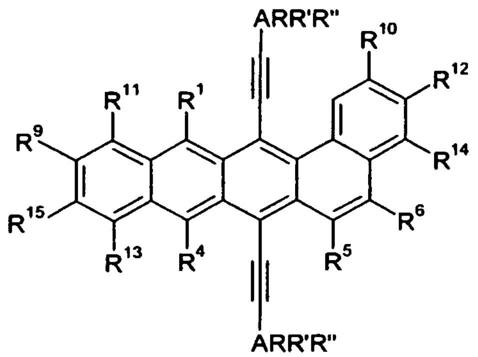

I4a

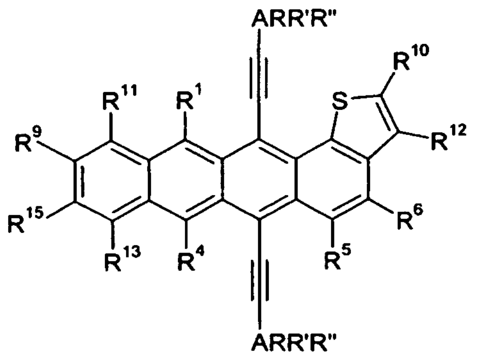

I4b

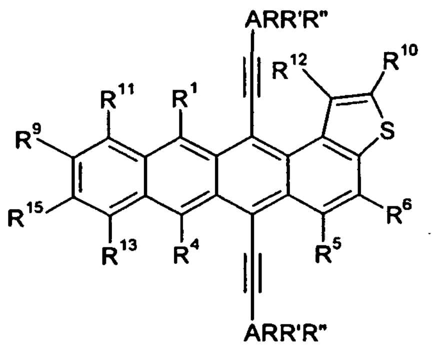

I4c

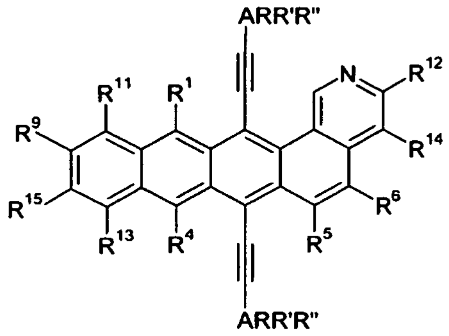

I4d

wherein A, R, R', R" and $R^{1-8}$ are as defined in claim 15, and $R^{9-15}$ have one of the meanings given for L in claim 1, and preferably $R^{11}$, $R^{12}$ , $R^{13}$ and $R^{14}$ denote H.

**19.** Formulation comprising one or more compounds according to one or more of claims 1 to 18 and one or more organic solvents.

**20.** Formulation comprising one or more compounds according to one or more of claims 1 to 18, one or more organic binders or precursors thereof, having a permittivity ε at 1,000 Hz of 3.3 or less, and optionally one or more solvents.

**21.** Use of compounds and formulations according according to one or more of claims 1 to 20 as charge transport, semiconducting, electrically conducting, photoconducting or light emitting material in an optical, electrooptical, electronic, electroluminescent or photoluminescent components or devices.

**22.** Charge transport, semiconducting, electrically conducting, photoconducting or light emitting material or component comprising one or more compounds or formulations according to one or more of claims 1 to 20.

**23.** Optical, electrooptical, electronic, electroluminescent or photoluminescent component or device comprising one or more compounds, formulations, materials or components according to one or more of claims 1 to 20 or 22.

**24.** Component or device according to claim 23, **characterized in that** it is selected from the group consisting of organic field effect transistors (OFET), thin film transistors (TFT), integrated circuits (IC), logic circuits, capacitors, radio frequency identification (RFID) tags, devices or components, organic light emitting diodes (OLED), organic light emitting transistors (OLET), flat panel displays, backlights of displays, organic photovoltaic devices (OPV), solar cells, laser diodes, photoconductors, photodetectors, electrophotographic devices, electrophotographic recording devices, organic memory devices, sensor devices, charge injection layers, charge transport layers or interlayers in polymer light emitting diodes (PLEDs), organic plasmon-emitting diodes (OPEDs), Schottky diodes, planarising layers, antistatic films, polymer electrolyte membranes (PEM), conducting substrates, conducting patterns, electrode materials in batteries, alignment layers, biosensors, biochips, security markings, security devices, and components or devices for detecting and discriminating DNA sequences.

## Patentansprüche

**1.** Verbindung der Formel I

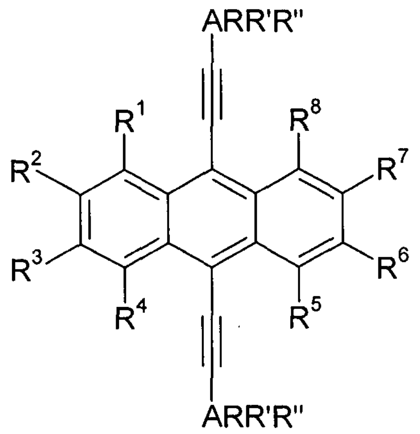

I

in der die einzelnen Gruppen die folgenden Bedeutungen besitzen:

$R^{1-8}$ bedeuten unabhängig voneinander H, F, Cl, Br, I, CN, geradkettiges, verzweigtes oder cyclisches Alkyl, Alkoxy, Thioalkyl, Alkenyl, Alkinyl, Alkylcarbonyl, Alkoxycarbonyl, Alkylcarbonyloxy, Alkylcarbonylamido, Alkylamidocarbonyl oder Alkoxycarbonyloxy mit 1 bis 20 C-Atomen, das unsubstituiert oder durch eine oder mehrere Gruppen L substituiert ist und in dem gegebenenfalls eine oder mehrere nicht benachbarte $CH_2$-Gruppen jeweils unabhängig voneinander so durch -O-, -S-, $-NR^0-$, $-SiR^0R^{00}-$, $-CY^0=CY^{00}$-oder -C=C- ersetzt sind, dass O- und/oder S-Atome nicht direkt miteinander verknüpft sind, oder bedeuten Aryl oder Heteroaryl mit 5 bis 20 Ringatomen, das unsubstituiert oder durch eine oder mehrere Gruppen L substituiert ist, oder ein oder mehrere der Paare $R^1$ und $R^2$, $R^2$ und $R^3$, $R^3$ und $R^4$, $R^5$ und $R^6$, $R^6$ und $R^7$, $R^7$ und $R^8$ sind miteinander zu einem gesättigten oder ungesättigten $C_4$-$C_{40}$-Ring verbrückt, der gegebenenfalls durch ein oder mehrere Heteroatome oder aus -O-, -S-, -Se-, -Ge-, $-SiR^0R^{00}-$ und $-N(R^x)-$ ausgewählte Gruppen unterbrochen ist und der gegebenenfalls substituiert ist,

A bedeutet Si, C oder Ge,

R, R', R" sind gleiche oder verschiedene Gruppen, die aus der Gruppe bestehend aus H, geradkettigem, verzweigtem oder cyclischem Alkyl oder Alkoxy mit 1 bis 20 C-Atomen, geradkettigem, verzweigtem oder cyclischem Alkenyl mit 2 bis 20 C-Atomen, geradkettigem, verzweigtem oder cyclischem Alkinyl mit 2 bis 20 C-Atomen, geradkettigem, verzweigtem oder cyclischem Alkylcarbonyl mit 2 bis 20 C-Atomen, Aryl oder Heteroaryl mit 4 bis 20 Ringatomen, Arylalkyl oder Heteroarylalkyl mit 4 bis 20 Ringatomen, Aryloxy oder Heteroaryloxy mit 4 bis 20 Ringatomen oder Arylalkyloxy oder Heteroarylalkyloxy mit 4 bis 20 Ringatomen ausgewählt sind, bei denen alle vorgenannten Gruppen gegebenenfalls mit einer oder mehreren Gruppen L substituiert sind,

L ist aus P-Sp-, F, Cl, Br, I, -OH, -CN, $-NO_2$ , -NCO, -NCS, -OCN, -SCN, $-C(=O)NR^0R^{00}$, $-C(=O)X^0$, $-C(=O)R^0$, $-NR^0R^{00}$, C(=O)OH, gegebenenfalls substituierten Aryl oder Heteroaryl mit 4 bis 20 Ringatomen oder geradkettigem, verzweigtem oder cyclischem Alkyl mit 1 bis 20, vorzugsweise 1 bis 12 C-Atomen ausgewählt, in dem gegebenenfalls eine oder mehrere nicht benachbarte $CH_2$-Gruppen jeweils unabhängig voneinander so durch -O-, -S-, $-NR^0-$, $-SiR^0R^{00}-$, $-CY^0=CY^{00}-$ oder -C≡C- ersetzt sind, dass O- und/oder S-Atome nicht direkt miteinander verknüpft sind und das unsubstituiert oder mit einem oder mehreren F- oder Cl-Atomen oder OH-Gruppen substituiert ist,

P bedeutet eine polymerisierbare Gruppe,

Sp bedeutet eine Spacergruppe oder eine Einfachbindung,

$X^0$ bedeutet Halogen,

$R^x$ besitzt eine der für $R^1$ angegebenen Bedeutungen,

$R^0$, $R^{00}$ bedeuten unabhängig voneinander H oder Alkyl mit 1 bis 20 C-Atomen,

$Y^0$, $Y^{00}$ bedeuten unabhängig voneinander H, F, Cl oder CN,

**dadurch gekennzeichnet, dass**

mindestens eines der Paare $R^1$ und $R^2$, $R^3$ und $R^4$, $R^5$ und $R^6$, $R^7$ und $R^8$ miteinander zu einem gesättigten oder ungesättigten $C_4$-$C_{40}$-Ring verbrückt ist, der gegebenenfalls durch ein oder mehrere Heteroatome oder aus -O-, -S-, -Se-, -Ge-, $-SiR^0R^{00}-$ und $-N(R^x)-$ ausgewählte Gruppen unterbrochen ist und der gegebenenfalls substituiert ist, und

mindestens eines der Paare $R^1$ und $R^2$, $R^3$ und $R^4$, $R^5$ und $R^6$, $R^7$ und $R^8$ nicht miteinander zu einem Ring verbrückt ist, und

die Verbindung kein Ringatom enthält, das mehr als zwei Ringen gemeinsam ist.

2. Verbindung nach Anspruch 1, bei der A Si bedeutet.

3. Verbindung nach Anspruch 1 oder 2, bei der R, R' und R" jeweils unabhängig aus der Gruppe bestehend aus gegebenenfalls substituiertem und geradkettigem, verzweigtem oder cyclischem Alkyl oder Alkoxy mit 1 bis 10 C-Atomen, gegebenenfalls substituiertem und geradkettigem, verzweigtem oder cyclischem Alkenyl, Alkinyl oder Alkylcarbonyl mit 2 bis 12 C-Atomen und gegebenenfalls substituiertem Aryl, Heteroaryl, Arylalkyl oder Heteroarylalkyl, Aryloxy oder Heteroaryloxy mit 5 bis 10 Ringatomen ausgewählt sind.

4. Verbindung nach einem oder mehreren der Ansprüche 1 bis 3, **dadurch gekennzeichnet, dass** ein, zwei oder drei der Paare $R^1$ und $R^2$, $R^2$ und $R^3$, $R^3$ und $R^4$, $R^5$ und $R^6$, $R^6$ und $R^7$, $R^7$ und $R^8$ miteinander zu einem gesättigten oder ungesättigten $C_4$-$C_{40}$-Ring verbrückt sind, der gegebenenfalls durch ein oder mehrere Heteroatome oder aus -O-, -S-, -Se-, -Ge-, $-SiR^0R^{00}$- und $-N(R^x)$- ausgewählte Gruppen unterbrochen ist und der gegebenenfalls substituiert ist.

5. Verbindung nach einem oder mehreren der Ansprüche 1 bis 4, **dadurch gekennzeichnet, dass** mindestens das Paar $R^7$ und $R^8$ miteinander zu einem gesättigten oder ungesättigten $C_4$-$C_{40}$-Ring verbrückt ist, der gegebenenfalls durch ein oder mehrere Heteroatome oder aus -O-, -S-, -Se-, -Ge-, $-SiR^0R^{00}$- und $-N(R^x)$- ausgewählte Gruppen unterbrochen ist und der gegebenenfalls substituiert ist.

6. Verbindung nach einem oder mehreren der Ansprüche 1 bis 5, **dadurch gekennzeichnet, dass** nicht mehr als eines der beiden Paare $R^1$ und $R^2$ und $R^3$ und $R^4$ und nicht mehr als eines der beiden Paare $R^5$ und $R^6$ und $R^7$ und $R^8$ miteinander zu einem Ring verbrückt ist.

7. Verbindung nach einem oder mehreren der Ansprüche 1 bis 6, **dadurch gekennzeichnet, dass** der durch das verbrückte Paar $R^1$ und $R^2$, $R^2$ und $R^3$, $R^3$ und $R^4$, $R^5$ und $R^6$, $R^6$ und $R^7$, $R^7$ und $R^8$ gebildete Ring aus der Gruppe bestehend aus aromatischen und heteroaromatischen Gruppen mit 5 bis 25 Ringatomen ausgewählt ist, die mono- oder polycyclisch sind und auch zwei oder mehr einzelne Ringe enthalten können, die über Einfachbindungen miteinander verbunden sind, oder zwei oder mehr anellierte Ringe enthalten und bei denen jeder Ring unsubstituiert oder mit einer oder mehreren Gruppen L wie in Anspruch 1 definiert substituiert ist.

8. Verbindung nach einem oder mehreren der Ansprüche 1 bis 7, **dadurch gekennzeichnet, dass** der durch das verbrückte Paar $R^1$ und $R^2$, $R^2$ und $R^3$, $R^3$ und $R^4$, $R^5$ und $R^6$, $R^6$ und $R^7$, $R^7$ und $R^8$ gebildete Ring aus der Gruppe bestehend aus Benzol, Furan, Thiophen, Selenophen, Pyrrol, Pyridin, Pyrimidin, Thiazol, Thiadiazol, Oxazol, Oxadiazol, Selenazol, Thieno[3,2-b]thiophen, Dithieno[3,2-*b*:2',3'-*d*]-thiophen, Selenopheno[3,2-b]selenophen, Selenopheno[2,3-b]-selenophen, Selenopheno[3,2-b]thiophen, Selenopheno[2,3-b]thiophen, Benzo[1,2-b:4,5-b']dithiophen, 2,2-Dithiophen, 2,2-Diselenophen, Dithieno[3,2-*b*:2',3'-*d*]silol, 4*H*-Cyclopenta[2,1-*b*:3,4-*b'*]dithiophen, Benzo[b]thiophen, Benzo[b]selenophen, Benzooxazol, Benzothiazol, Benzoselenazol ausgewählt ist, wobei die vorgenannten Gruppen jeweils unsubstituiert oder mit einer oder mehreren Gruppen L wie in Anspruch 1 definiert substituiert sind.

9. Verbindung nach einem oder mehreren der Ansprüche 1 bis 8, **dadurch gekennzeichnet, dass** der durch das verbrückte Paar $R^1$ und $R^2$, $R^2$ und $R^3$, $R^3$ und $R^4$, $R^5$ und $R^6$, $R^6$ und $R^7$, $R^7$ und $R^8$ gebildete Ring aus der Gruppe bestehend aus Benzol, Thiophen und Pyridin ausgewählt ist, die unsubstituiert oder mit einer oder mehreren Gruppen L wie in Anspruch 1 definiert substituiert sind.

10. Verbindung nach einem oder mehreren der Ansprüche 1 bis 9, **dadurch gekennzeichnet, dass** die Gruppen $R^1$, $R^2$, $R^3$, $R^4$, $R^5$, $R^6$, $R^7$ und $R^8$, die nicht miteinander zu einem Ring verbrückt sind, aus der Gruppe bestehend aus H, F, Cl, Br, I, -CN und geradkettigem, verzweigtem oder cyclischem Alkyl, Alkoxy, Thioalkyl, Alkenyl, Alkinyl, Alkylcarbonyl, Alkoxycarbonyl, Alkylcarbonyloxy, Alkylcarbonylamido, Alkylamidocarbonyl oder Alkoxycarbonyloxy mit 1 bis 20, vorzugsweise 1 bis 12 C-Atomen, das unsubstituiert oder mit einem oder mehreren F- oder Cl-Atomen oder OH-Gruppen substituiert oder perfluoriert ist, und aromatischen und heteroaromatischen Gruppen mit 4 bis 25 Ringatomen, die mono- oder polycyclisch sind, d.h. die auch zwei oder mehr einzelne Ringe enthalten können, die über Einfachbindungen miteinander verbunden sind, oder zwei oder mehr anellierte Ringe enthalten und bei denen jeder Ring unsubstituiert oder mit einer oder mehreren Gruppen L wie in Anspruch 1 definiert substituiert ist, ausgewählt sind.

11. Verbindung nach einem oder mehreren der Ansprüche 1 bis 9, **dadurch gekennzeichnet, dass** die Gruppen $R^1$, $R^2$, $R^3$, $R^4$, $R^5$, $R^6$, $R^7$ und $R^8$, die nicht miteinander zu einem Ring verbrückt sind, aus der Gruppe bestehend aus

Phenylen, Furan, Thiophen, Selenophen, N-Pyrrol, Pyridin, Pyrimidin, Thiazol, Thiadiazol, Oxazol, Oxadiazol, Selenazol und bi-, tri- oder tetracyclischen Aryl- oder Heteroarylgruppen enthaltend einen oder mehrere der vorgenannten Ringe und gegebenenfalls einen oder mehrere Benzolringe ausgewählt sind, wobei die einzelnen Ringe miteinander durch Einfachbindungen verbunden oder anelliert sind und wobei die vorgenannten Gruppen jeweils unsubstituiert oder mit einer oder mehreren Gruppen L wie vorstehend definiert substituiert sind.

12. Verbindung nach einem oder mehreren der Ansprüche 1 bis 11, **dadurch gekennzeichnet, dass** die Gruppen $R^1$, $R^2$, $R^3$, $R^4$, $R^5$, $R^6$, $R^7$ und $R^8$, die nicht miteinander zu einem Ring verbrückt sind, aus der Gruppe bestehend aus Thieno[3,2-b]thiophen, Dithieno[3,2-*b*:2',3'-*d*]-thiophen, Selenopheno[3,2-b]selenophen, Selenopheno[2,3-b]-selenophen, Selenopheno[3,2-b]thiophen, Selenopheno[2,3-b]thiophen, Benzo[1,2-b:4,5-b']dithiophen, 2,2-Dithiophen, 2,2-Diselenophen, Dithieno[3,2-*b*:2',3'-*d*]silol, 4*H*-Cyclopenta[2,1-*b*:3,4-*b'*]dithiophen, Benzo[b]thiophen, Benzo[b]selenophen, Benzooxazol, Benzothiazol, Benzoselenazol ausgewählt sind, wobei die vorgenannten Gruppen jeweils unsubstituiert oder mit einer oder mehreren Gruppen L wie vorstehend definiert substituiert sind.

13. Verbindung nach einem oder mehreren der Ansprüche 1 bis 12, **dadurch gekennzeichnet, dass** mindestens zwei von $R^1$, $R^4$, $R^5$ und $R^8$ H bedeuten.

14. Verbindung nach einem oder mehreren der Ansprüche 1 bis 13, **dadurch gekennzeichnet, dass** mindestens eines von $R^1$ und $R^5$ H bedeutet und mindestens eines von $R^4$ und $R^8$ H bedeutet.

15. Verbindungen nach einem oder mehreren der Ansprüche 1 bis 14, **dadurch gekennzeichnet, dass** sie aus den folgenden Formeln I1 bis 17 ausgewählt sind:

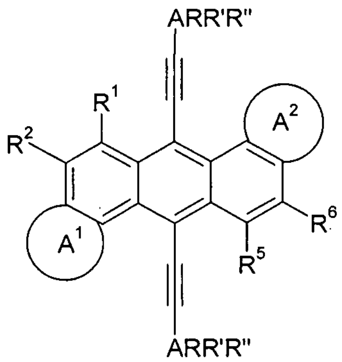

I1

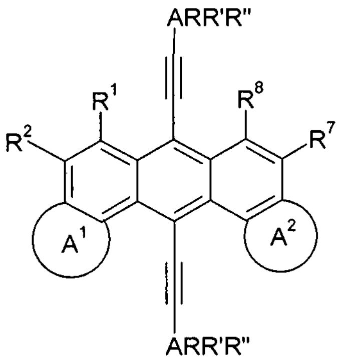

I2

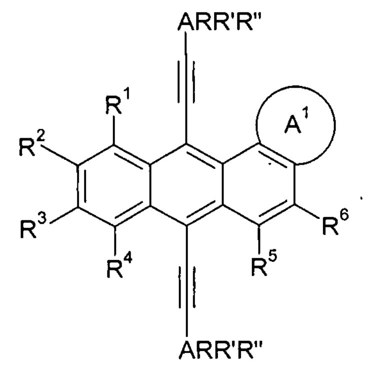

I3

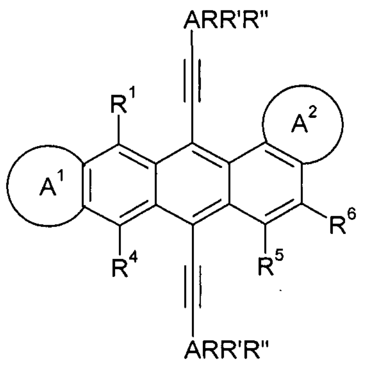

I4

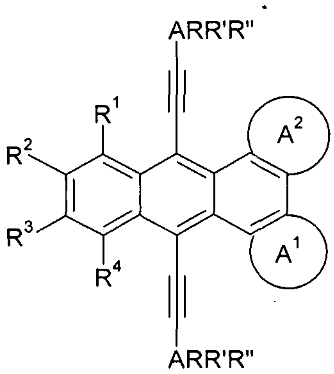

I5

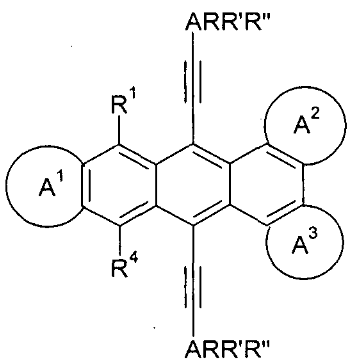

I6

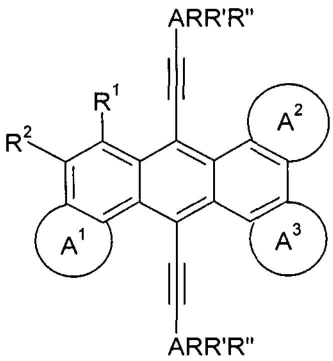

I7

in denen A, R, R' und R" wie in Anspruch 1 definiert sind, $R^{1-8}$ eine der in Anspruch 1 angegebenen Bedeutungen von $R^1$ besitzen, aber nicht zu einem Ring verbrückt sind, und $A^1$, $A^2$ und $A^3$ unabhängig voneinander eine aromatische oder heteroaromatische Gruppe mit 5 bis 25 Ringatomen bedeuten, die mono- oder polycyclisch ist, d.h. die auch zwei oder mehr einzelne Ringe enthalten kann, die über Einfachbindungen miteinander verbunden sind, oder zwei oder mehr anellierte Ringe enthalten und bei der jeder Ring unsubstituiert oder mit einer oder mehreren Gruppen L wie in Anspruch 1 definiert substituiert ist.

**16.** Verbindung nach Anspruch 15, **dadurch gekennzeichnet, dass** $A^1$, $A^2$ und $A^3$ aus der Gruppe bestehend aus Benzol, Furan, Thiophen, Selenophen, Pyrrol, Pyridin, Pyrimidin, Thiazol, Thiadiazol, Oxazol, Oxadiazol, Selenazol, Thieno[3,2-b]thiophen, Dithieno[3,2-*b*:2',3'-d]-thiophen, Selenopheno[3,2-b]selenophen, Selenopheno[2,3-b]-Selenophen, Selenopheno[3,2-b]thiophen, Selenopheno[2,3-b]thiophen, Benzo[1,2-b:4,5-b']dithiophen, 2,2-Dithiophen, 2,2-Diselenophen, Dithieno[3,2-*b*:2',3'-*d*]silol, 4*H*-Cyclopenta[2,1-b:3,4-*b*']dithiophen, Benzo[b]thiophen, Benzo[b]selenophen, Benzooxazol, Benzothiazol, Benzoselenazol ausgewählt sind, wobei die vorgenannten Gruppen jeweils unsubstituiert oder mit einer oder mehreren Gruppen L wie in Anspruch 1 definiert substituiert sind.

**17.** Verbindung nach Anspruch 15 oder 16, **dadurch gekennzeichnet, dass** $A^1$, $A^2$ und $A^3$ aus der Gruppe bestehend aus Benzol, Thiophen und Pyridin ausgewählt sind, die unsubstituiert oder mit einer oder mehreren Gruppen L wie in Anspruch 1 definiert substituiert sind.

**18.** Verbindung nach einem oder mehreren der Ansprüche 1 bis 17, **dadurch gekennzeichnet, dass** sie aus den folgenden Formeln I1a bis I4d ausgewählt ist:

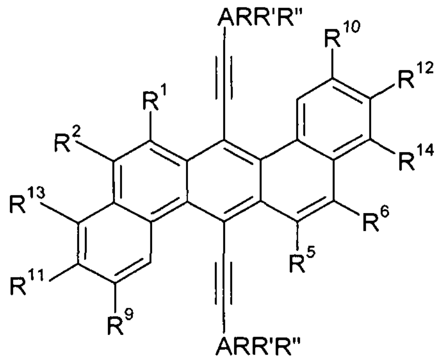

I1a

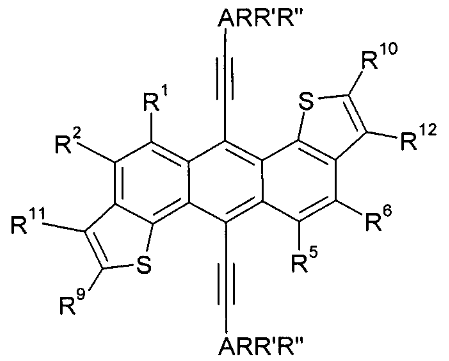

I1b

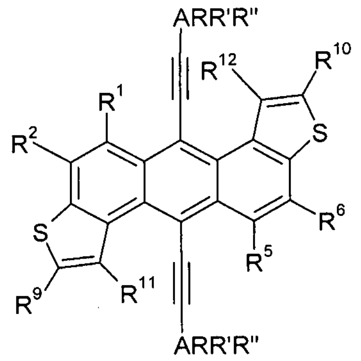

I1c

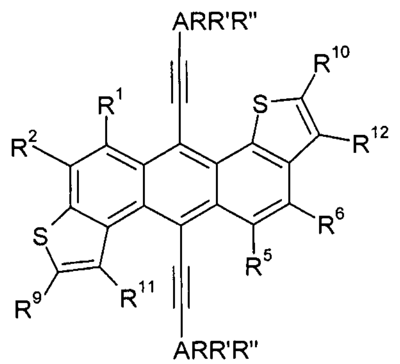

I1d

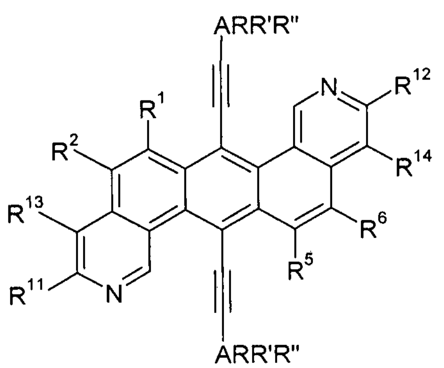

I1e

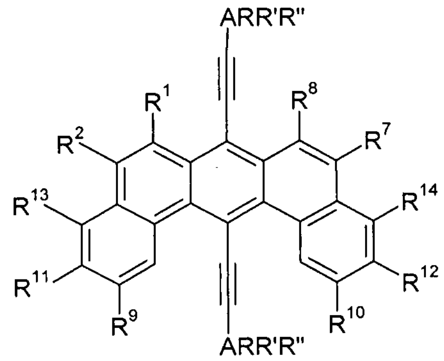

I2a

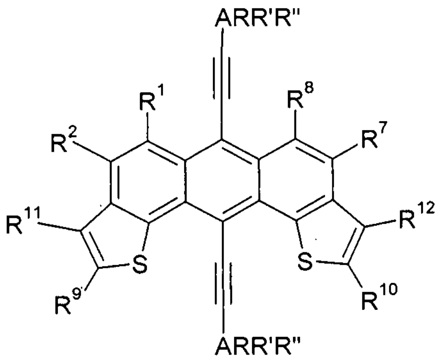

I2b

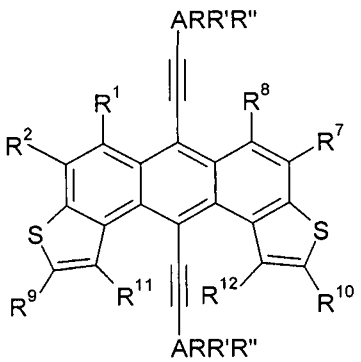

I2c

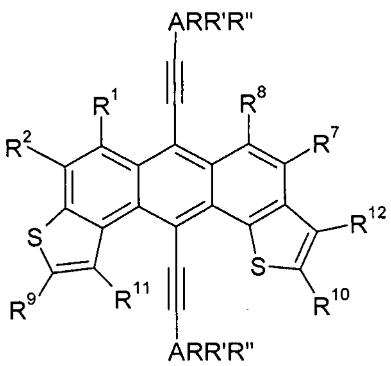

I2d

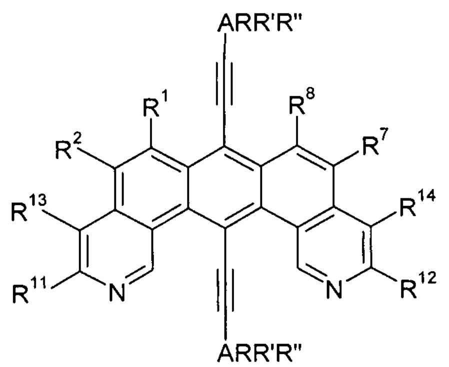

I2e

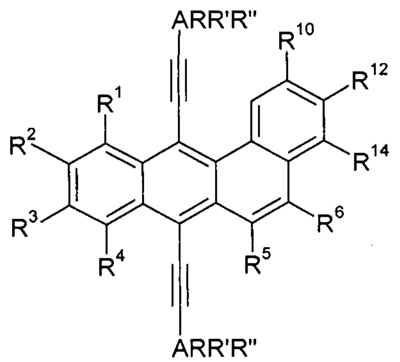

I3a

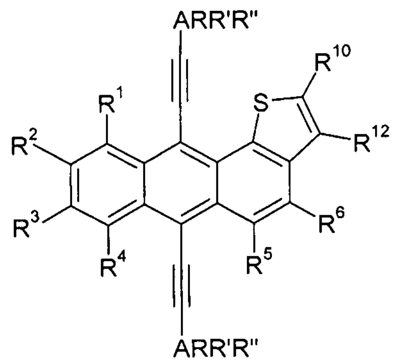

I3b

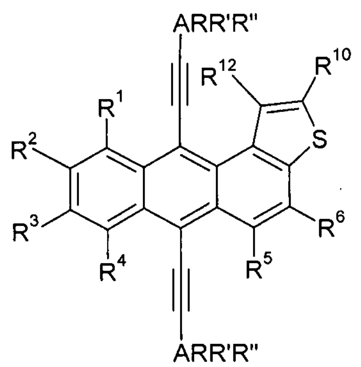

I3c

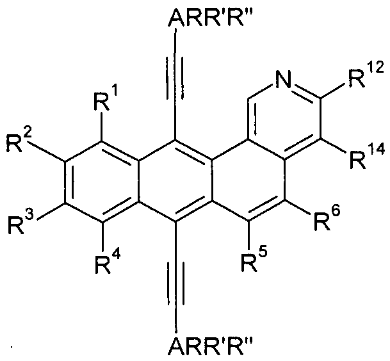

I3d

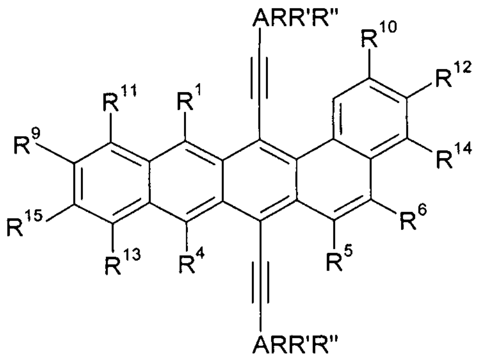

I4a

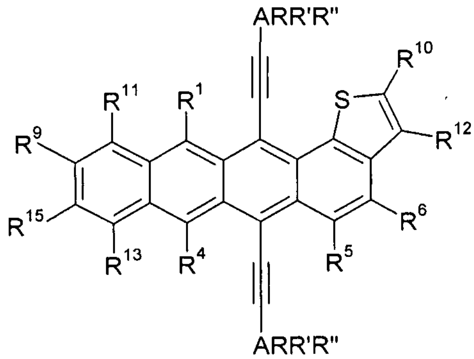

I4b

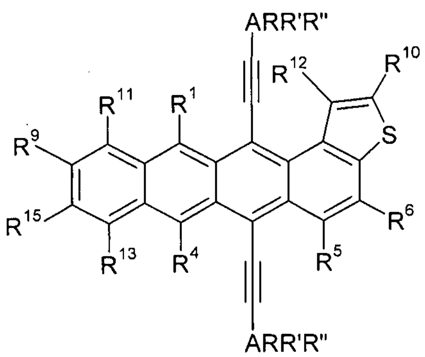

I4c

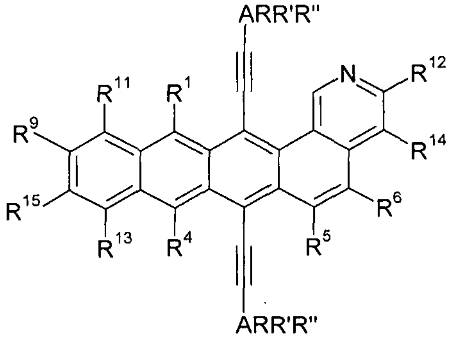

I4d

in denen A, R, R', R" und $R^{1-8}$ wie in Anspruch 15 definiert sind und $R^{9-15}$ eine der für L in Anspruch 1 angegebenen Bedeutungen besitzen und $R^{11}$, $R^{12}$, $R^{13}$ und $R^{14}$ vorzugsweise H bedeuten.

**19.** Formulierung enthaltend eine oder mehrere Verbindungen nach einem oder mehreren der Ansprüche 1 bis 18 und ein oder mehrere organische Lösungsmittel.

**20.** Formulierung enthaltend eine oder mehrere Verbindungen nach einem oder mehreren der Ansprüche 1 bis 18, ein oder mehrere organische Bindemittel oder Vorstufen davon, mit einer Dielektrizitätskonstante $\varepsilon$ von 3,3 oder weniger bei 1.000 Hz, und gegebenenfalls ein oder mehrere Lösungsmittel.

**21.** Verwendung von Verbindungen und Formulierungen nach einem oder mehreren der Ansprüche 1 bis 20 als Ladungstransport-, Halbleiter-, elektrisch leitendes, photoleitendes oder lichtemittierendes Material in optischen, elektrooptischen, elektronischen, Elektrolumineszenz- oder Photolumineszenzkomponenten oder -vorrichtungen.

**22.** Ladungstransport-, Halbleiter-, elektrisch leitende(s), photoleitende(s) oder lichtemittierende(s) Material oder Komponente, das/die eine oder mehrere Verbindungen oder Formulierungen nach einem oder mehreren der Ansprüche 1 bis 20 enthält.

**23.** Optische, elektrooptische, elektronische, Elektrolumineszenz- oder Photolumineszenzkomponente oder -vorrichtung, die ein(e) oder mehrere Verbindungen, Formulierungen, Materialien oder Komponenten nach einem oder mehreren der Ansprüche 1 bis 20 oder 22.

**24.** Komponente oder Vorrichtung nach Anspruch 23, **dadurch gekennzeichnet, dass** sie aus der Gruppe bestehend aus organischen Feldeffekttransistoren (OFETs), Dünnschichttransistoren (thin film transistors - TFTs), integrierten Schaltungen (integrated circuits - ICs), logischen Schaltungen, Kondensatoren, RFID-Tags, -Vorrichtungen oder -Komponenten (RFID - radio frequency identification), organischen Leuchtdioden (organic light emitting diodes - OLEDs), organischen lichtemittierenden Transistoren (organic light emitting transistors - OLETs), Flachbildschirmen, Hintergrundbeleuchtungen für Anzeigen, organischen Photovoltaikvorrichtungen (OPV), Solarzellen, Laserdioden, Photoleitern, Photodetektoren, elektrophotographischen Vorrichtungen, elektrophotographischen Aufzeichnungsvorrichtungen, organischen Speichervorrichtungen, Sensorvorrichtungen, Ladungsinjektionsschichten, Ladungstransportschichten oder Zwischenschichten in Polymer-Leuchtdioden (polymer light emitting diodes - PLEDs), organischen Plasmon-emittierenden Dioden (OPEDs), Schottky-Dioden, Planarisierungsschichten, Antistatikfolien, Polymerelektrolytmembranen (PEMs), leitenden Substraten, leitenden Mustern, Elektrodenmaterialien in Batterien, Orientierungsschichten, Biosensoren, Biochips, Sicherheitsmarkierungen, Sicherheitsvorrichtungen und Komponenten oder Vorrichtungen für den Nachweis und die Unterscheidung von DNA-Sequenzen ausgewählt ist.

## Revendications

**1.** Composé de la formule I

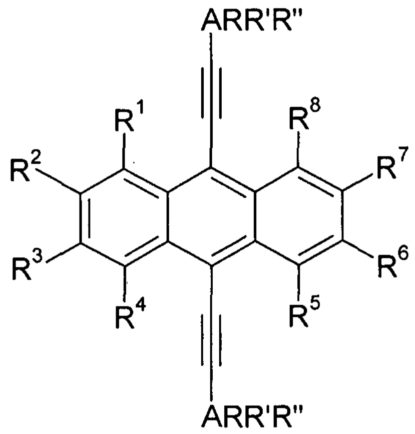

I

dans laquelle les groupes individuels ont les significations suivantes :

$R^{1-8}$ indépendamment les uns des autres représentent H, F, Cl, Br, I, CN, alkyle, alkoxy, thioalkyle, alkényle, alkynyle, alkylcarbonyle, alkoxycarbonyl, alkylcarbonyloxy, alkylcarbonylamido, alkylamidocarbonyle ou alkoxycarbonyloxy en chaine droite, ramifié ou cyclique aves 1 à 20 atomes de C, qui est non substitué ou substitué par un ou plusieurs groupes L, et dans lequel un ou plusieurs groupes $CH_2$ non adjacents sont en option remplacés, dans chaque cas indépendamment les uns des autres, par -O-, -S-, $-NR^0-$, $-SiR^0R^{00}-$, $-CY^0=CY^{00}-$ ou -C≡C- de telle sorte que des atomes de O et/ou de S ne soient pas liés directement les uns aux autres, ou représentent aryle ou hétéroaryle avec 5 à 20 atomes de cycle qui est non substitué ou substitué par un ou plusieurs groupes L, ou une ou plusieurs des paires $R^1$ et $R^2$, $R^2$ et $R^3$, $R^3$ et $R^4$, $R^5$ et $R^6$, $R^6$ et $R^7$, $R^7$ et $R^8$ sont inter-pontées avec chaque autre pour former un cycle $C_4$-$C_{40}$ saturé ou non saturé qui est en option combiné par un ou plusieurs hétéroatomes ou groupes choisis parmi -O-, -S-, -Se-,- Ge-, $-SiR^0R^{00}-$ et $-N(R^x)-$, et qui est en option substitué,

A est Si, C ou Ge,

R, R', R" sont des groupes identiques ou différents choisis parmi le groupe constitué de H, alkyle ou alcoxy en chaîne droite, ramifié ou cyclique ayant 1 à 20 atomes de C, alkényle en chaîne droite, ramifié ou cyclique ayant 2 à 20 atomes de C, alkynyle en chaîne droite, ramifié ou cyclique ayant 2 à 20 atomes de C, alkylcarbonyle en chaîne droite, ramifié ou cyclique ayant 2 à 20 atomes de C, aryle ou hétéroaryle ayant 4 à 20 atomes de cycle, arylalkyle ou hétéroarylalkyle ayant 4 à 20 atomes de cycle, aryloxy ou hétéroaryloxy ayant 4 à 20 atomes de cycle, ou arylalkyloxy ou hétéroarylalkyloxy ayant 4 à 20 atomes de cycle, dans lequel tous les groupes mentionnés précédemment sont en option substitués avec un ou plusieurs groupes L,

L est choisi parmi P-Sp-, F, Cl, Br, I, -OH, -CN, $-NO_2$ , -NCO, -NCS, -OCN, -SCN, $-C(=O)NR^0R^{00}$, $-C(=O)X^0$, $-C(=O)R^0$, $-NR^0R^{00}$, C(=O)OH, aryle ou hétéroaryle en option substitué, ayant 4 à 20 atomes de cycle, or alkyle en chaîne droite, ramifié ou cyclique ayant 1 à 20 atomes de C, de préférence 1 à 12 atomes de C dans lequel un ou plusieurs groupes $CH_2$ non adjacents sont en option remplacés, dans chaque cas indépendamment les uns des autres, par -O-, -S-, $-NR^0-$, $-SiR^0R^{00}-$, $-CY^0=CY^{00}-$ ou -C≡C- de telle sorte que des atomes de O et/ou de S ne soient pas liés directement l'un à l'autre et qui est non substitué ou substitué avec un ou plusieurs atomes de F ou C ou groupes OH,

P est un groupe polymérisable,

Sp est un groupe espaceur ou une liaison simple,

$X^0$ est halogène,

$R^x$ a les significations données pour $R^1$,

$R^0$, $R^{00}$ indépendamment l'un de l'autre représentent H ou alkyle avec 1 à 20 atomes de C,

$Y^0$, $Y^{00}$ indépendamment l'un de l'autre représentent H, F, Cl ou CN,

**caractérisé en ce que**

au moins l'une des paires $R^1$ et $R^2$, $R^3$ et $R^4$, $R^5$ et $R^6$, $R^7$ et $R^8$ est inter-pontée avec chaque autre pour former un cycle $C_4$-$C_{40}$ saturé ou non saturé qui est en option combiné avec un ou plusieurs hétéroatomes ou groupes choisis parmi -O-, -S-, -Se-, -Ge-, $-SiR^0R^{00}-$ et $-N(R^x)-$ et qui est en option substitué, et

au moins l'une des paires $R^1$ et $R^2$, $R^3$ et $R^4$, $R^5$ et $R^6$, $R^7$ et $R^8$ n'est pas inter-pontée avec chaque autre pour former un cycle, et

le composé ne contient pas un atome de cycle qui soit commun à plus de deux cycles.

**2.** Composé selon la revendication 1, dans lequel A est Si.

**3.** Composé selon la revendication 1 ou 2, dans lequel R, R' et R" sont chacun indépendamment choisis parmi le groupe constitué de alkyle ou alcoxy en chaîne droite, ramifié ou cyclique en option substitué, ayant 1 à 10 atomes de C, alkényle, alkynyle ou alkylcarbonyle en chaîne droite, ramifié ou cyclique en option substitué, ayant 2 à 12 atomes de C, et aryle, hétéroaryle, arylalkyle ou hétéroarylalkyle, aryloxy ou hétéroaryloxy en option substitué ayant 5 à 10 atomes de cycle.

**4.** Composé selon une ou plusieurs des revendications 1 à 3, **caractérisé en ce que** une, deux ou trois des paires $R^1$ et $R^2$, $R^2$ et $R^3$, $R^3$ et $R^4$, $R^5$ et $R^6$, $R^6$ et $R^7$, $R^7$ et $R^8$ est pontée avec chaque autre pour former un cycle $C_4$-$C_{40}$ saturé ou non saturé qui est impliqué par un ou plusieurs hétéroatomes ou groupes choisis parmi -O-, -S-, -Se-, -Ge-, -$SiR^0R^{00}$- et -$N(R^x)$-, et qui est en option substitué.

**5.** Composé selon une ou plusieurs des revendications 1 à 4, **caractérisé en ce que** au moins la paire $R^7$ et $R^8$ est inter-pontée avec chaque autre pour former un cycle $C_4$-$C_{40}$ saturé ou non saturé qui est en option combiné avec un ou plusieurs hétéroatomes ou groupes choisis parmi -O-, -S-, -Se-, -Ge-, -$SiR^0R^{00}$- et -$N(R^x)$- et qui est en option substitué.

**6.** Composé selon une ou plusieurs des revendications 1 à 5, **caractérisé en ce que** pas plus d'une des deux paires $R^1$ et $R^2$ et $R^3$ et $R^4$, et pas plus d'une des deux paires $R^5$ et $R^6$ et $R^7$ et $R^8$, est inter-pontée avec chaque autre pour former un cycle.

**7.** Composé selon une ou plusieurs des revendications 1 à 6, **caractérisé en ce que** ledit cycle formé par la paire inter-pontée $R^1$ et $R^2$, $R^2$ et $R^3$, $R^3$ et $R^4$, $R^5$ et $R^6$, $R^6$ et $R^7$, $R^7$ et $R^8$ est choisi parmi le groupe constitué des groupes aromatiques ou hétéroaromatiques avec 5 à 25 atomes de cycle, qui sont mono- ou polycycliques et qui peuvent également contenir deux cycles individuels ou plus qui sont connectés l'un à l'autre via des liaisons simples, ou contiennent deux cycles fusionnés ou plus, et dans lequel chaque cycle est non substitué ou substitué avec un ou plusieurs groupes L comme définis dans la revendication 1.

**8.** Composé selon une ou plusieurs des revendications 1 à 7, **caractérisé en ce que** ledit cycle formé par la paire inter-pontée $R^1$ et $R^2$, $R^2$ et $R^3$, $R^3$ et $R^4$, $R^5$ et $R^6$, $R^6$ et $R^7$, $R^7$ et $R^8$ est choisi parmi le groupe constitué de benzène, furane, thiophène, sélénophène, pyrrole, pyridine, pyrimidine, thiazole, thiadiazole, oxazole, oxadiazole, sélénazole, thiéno[3,2-b]thiophène, dithiéno[3,2-*b*:2',3'-dj]thiophène, sélénophéno[3,2-b]sélénophène, sélénophéno[2,3-b]sélénophène, sélénophéno[3,2-b]thiophène, sélénophéno[2,3-b]thiophène, benzo-[1,2-b:4,5-b']dithiophène, 2,2-dithiophène, 2,2-disélénophène, dithiéno[3,2-*b*:2',3'-*d*]silole, 4*H*-cyclopenta[2,1-*b*:3,4-*b'*]dithiophène, benzo[b]thiophène, benzo[b]sélénophène, benzooxazole, benzothiazole, benzosélénazole, dans lequel tous les groupes mentionnés avant sont non substitués ou substitués avec un ou plusieurs groupes L comme définis dans la revendication 1.

**9.** Composé selon une ou plusieurs des revendications 1 à 8, **caractérisé en ce que** ledit cycle formé par la paire inter-pontée $R^1$ et $R^2$, $R^2$ et $R^3$, $R^3$ et $R^4$, $R^5$ et $R^6$, $R^6$ et $R^7$, $R^7$ et $R^8$ est choisie parmi le groupe constitué de benzène, thiophène et pyridine, qui sont non substitués ou substitués avec un ou plusieurs groupes L comme définis dans la revendication 1.

**10.** Composé selon une ou plusieurs des revendications 1 à 9, **caractérisé en ce que** les groupes $R^1$, $R^2$, $R^3$, $R^4$, $R^5$, $R^6$, $R^7$ et $R^8$, qui ne sont pas inter-pontés avec chaque autre pour former un cycle, sont choisis parmi le groupe constitué de H, F, Cl, Br, I, -CN, et alkyl, alkoxy, thioalkyl, alkényle, alkynyle, alkylcarbonyle, alkoxycarbonyl, alkylcarbonyloxy, alkylcarbonylamido, alkylamidocarbonyl ou alkoxycarbonyloxy en chaîne droite, ramifié ou cyclique, avec 1 à 20, de préférence 1 à 12 atomes de C qui est non substitué ou substitué avec un ou plusieurs atomes de F ou Cl ou groupes OH ou groupes perfluorés, et aromatiques et hétéroaromatiques avec 4 à 25 atomes de cycle, qui sont mono- ou polycycliques, c'est-à-dire qui peuvent également contenir deux cycles individuels ou plus qui sont connectés l'un à l'autre via des liaisons simples, ou contiennent deux cycles fusionnés ou plus, et dans lequel chaque cycle est non substitué ou substitué avec un ou plusieurs groupes L comme définis dans la revendication 1.

**11.** Composé selon une ou plusieurs des revendications 1 à 9, **caractérisé en ce que** the groups $R^1$, $R^2$, $R^3$, $R^4$, $R^5$, $R^6$, $R^7$ et $R^8$, qui ne sont pas inter-pontés avec chaque autre pour former un cycle, sont choisis parmi le groupe constitué de phénylène, furane, thiophène, sélénophène, N-pyrrole, pyridine, pyrimidine, thiazole, thiadiazole, oxazole, oxadiazole, sélénazole, et les groupes aryle ou hétéroaryle bi-, tri- ou tétracycliques contenant un ou plusieurs des cycles mentionnés ci avant et en option un ou plusieurs cycles benzène, dans lequel les cycles individuels sont

connectés par des liaisons simples ou fusionnés l'un à l'autre, et dans lequel tous les groupes mentionnés ci avant sont non substitués ou substitués avec un ou plusieurs groupes L comme définis dans la revendication 1.

**12.** Composé selon une ou plusieurs des revendications 1 à 11, **caractérisé en ce que** the groups $R^1$, $R^2$, $R^3$, $R^4$, $R^5$, $R^6$, $R^7$ et $R^8$, qui ne sont pas inter-pontés avec chaque autre pour former un cycle, sont choisis parmi le groupe constitué de thiéno[3,2-b]thiophène, dithiéno[3,2-*b*:2',3'-*d*]thiophène, sélénophéno[3,2-b]sélénophène, sélénophéno[2,3-b]sélénophène, sélénophéno[3,2-b]thiophène, sélénophéno[2,3-b]thiophène, benzo[1,2-b:4,5-b']dithiophène, 2,2-dithiophène, 2,2-disélénophène, dithiéno[3,2-*b*:2',3'-d]silole, 4*H*-cyclopenta[2,1-*b*:3,4-b']dithiophène, benzo[b]thiophene, benzo[b]sélénophène, benzooxazole, benzothiazole, benzoselenazole, dans lequel tous les groupes mentionnés ci avant sont non substitués ou substitués avec un ou plusieurs groupes L comme définis ci avant.

**13.** Composé selon une ou plusieurs des revendications 1 à 12, **caractérisé en ce que** au moins deux de $R^1$, $R^4$, $R^5$ et $R^8$ représentent H.

**14.** Composé selon une ou plusieurs des revendications 1 à 13, **caractérisé en ce que** au moins l'un de $R^1$ et $R^5$ représente H et au moins l'un de $R^4$ et $R^8$ représente H.

**15.** Composés selon une ou plusieurs des revendications 1 à 14, **caractérisés en ce qu'**ils sont choisis parmi les formules qui suivent I1 à I7:

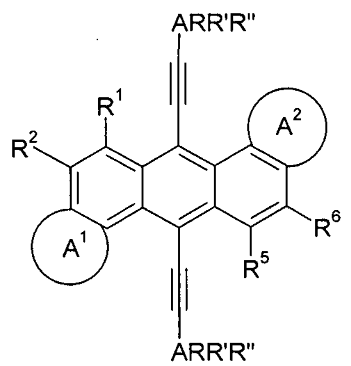

I1

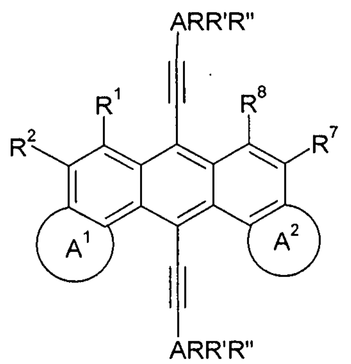

I2

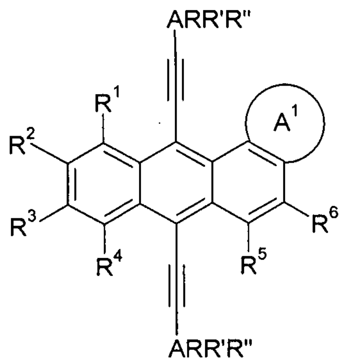

I3

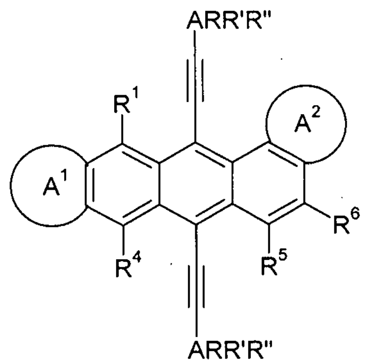

I4

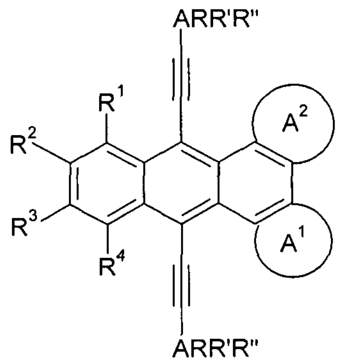

I5

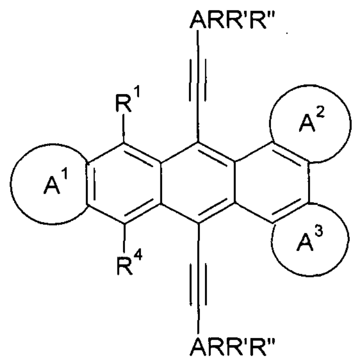

I6

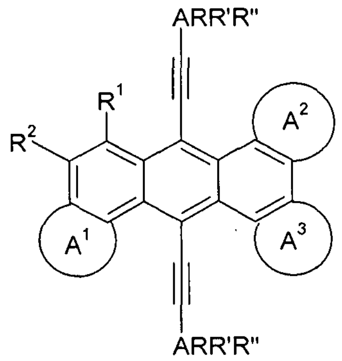

I7

dans lesquelles A, R, R' et R" sont comme défini dans la revendication 1, $R^{1-8}$ ont l'une des significations de $R^1$ donné dans la revendication 1 mais ne sont pas pontés pour former un cycle, et $A^1$, $A^2$ et $A^3$ représentent indépendamment l'un de l'autre un groupe aromatique ou hétéroaromatique avec 5 à 25 atomes de cycle, lequel est mono- ou polycyclique, c'est-à-dire qui peut également contenir deux cycles individuels ou plus qui sont connectés l'un à l'autre via des liaisons simples, ou contiennent deux cycles fusionnés ou plus, et dans lequel chaque cycle est non substitué ou substitué avec un ou plusieurs groupes L comme défini dans la revendication 1.

**16.** Composé selon la revendication 15, **caractérisé en ce que** $A^1$, $A^2$ et $A^3$ sont choisis par mi le groupe composé de benzène, furane, thiophène, sélénophène, pyrrole, pyridine, pyrimidine, thiazole, thiadiazole, oxazole, oxadiazole, sélénazole, thiéno[3,2-b]thiophène, dithiéno[3,2-*b*:2',3'-*d*]thiophène, sélénophéno[3,2-b]sélénophène, sélénophéno[2,3-b]sélénophène, sélénophéno[3,2-b]thiophène, sélénophéno[2,3-b]thiophène, benzo[1,2-b:4,5-b']dithiophène, 2,2-dithiophène, 2,2-disélénophène, dithiéno[3,2-*b*:2',3'-*d*]silole, 4*H*-cyclopenta[2,1-*b*:3,4-*b'*]dithiophène, benzo[b]thiophène, benzo[b]-sélénophène, benzooxazole, benzothiazole, benzosélénazole, dans lequel tous les groupes mentionnés avant sont non substitués ou substitués avec un ou plusieurs groupes L comme défini dans la revendication 1.

**17.** Composé selon la revendication 15 ou 16, **caractérisé en ce que** $A^1$, $A^2$ et $A^3$ sont choisis parmi les composés benzène, thiophène et pyridine, qui sont non substitués ou substitués avec un ou plusieurs groupes L comme défini dans la revendication 1.

**18.** Composé selon une ou plusieurs des revendications 1 à 17, **caractérisé en ce qu'**ils sont choisis parmi les formules qui suivent I1a à I4d:

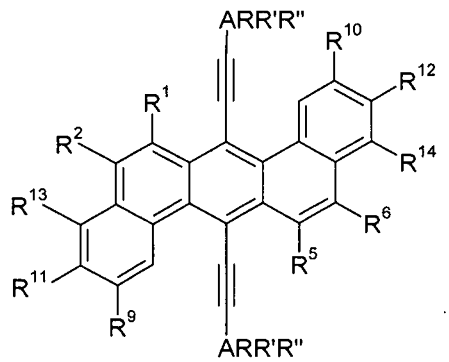

I1a

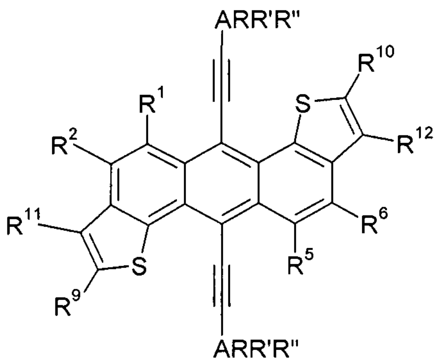

I1b

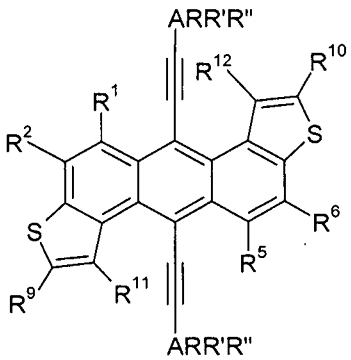

I1c

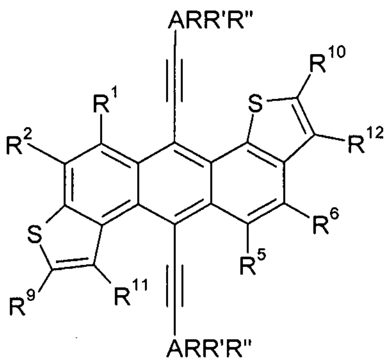

I1d

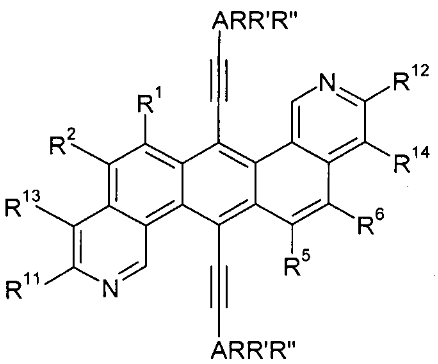

I1e

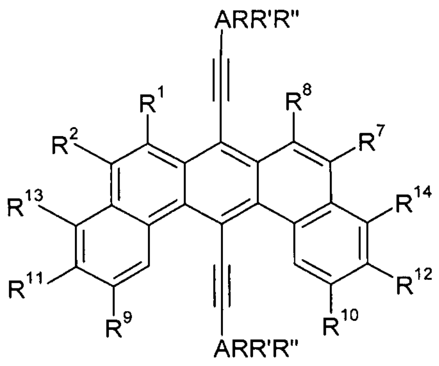

I2a

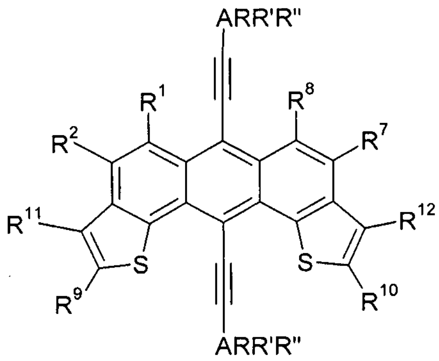

I2b

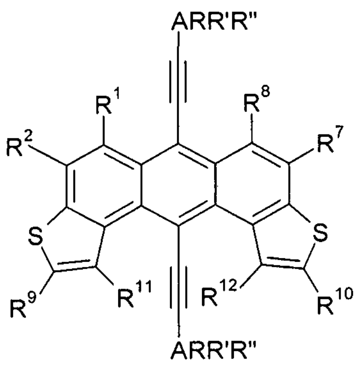

I2c

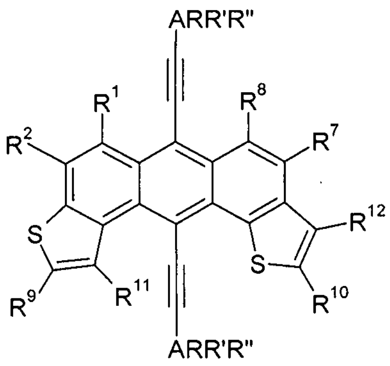

I2d

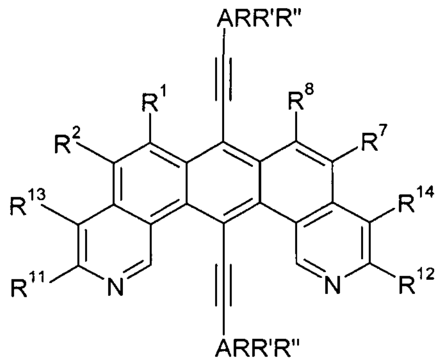

I2e

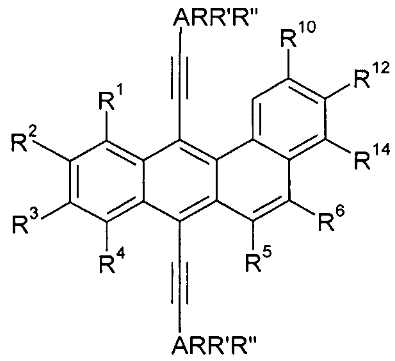

I3a

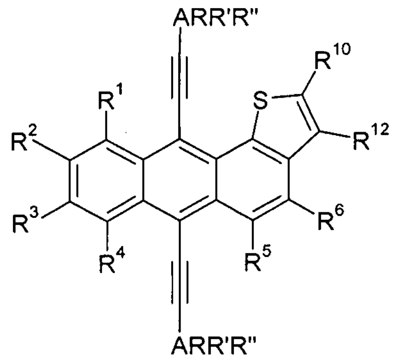

I3b

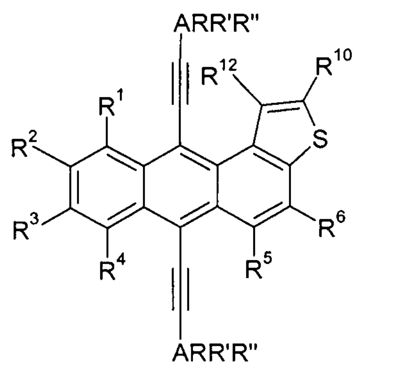

I3c

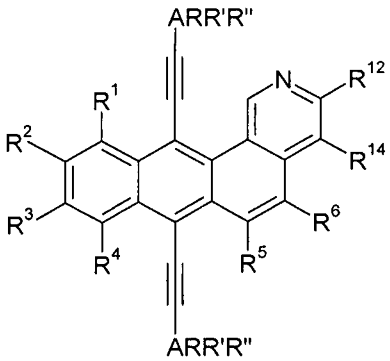

I3d

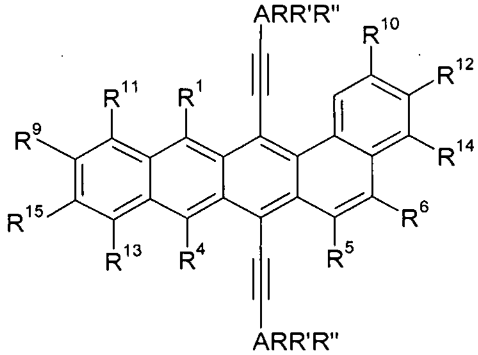

I4a

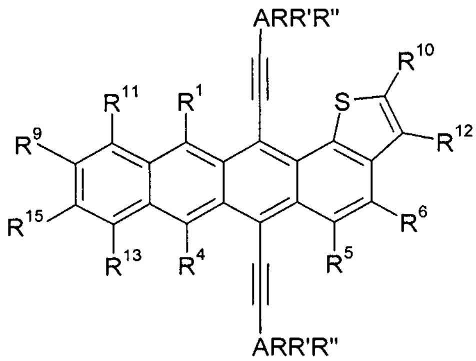

I4b

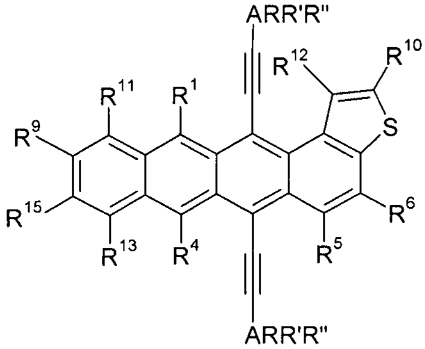

I4c

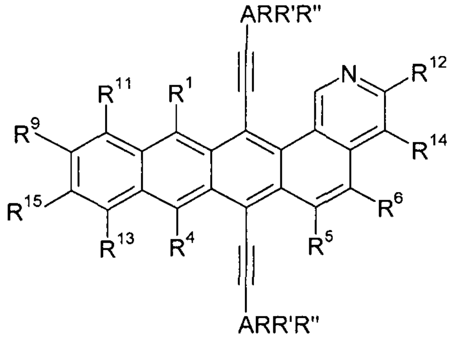

I4d

dans lesquelles A, R, R', R" et $R^{1-8}$ sont comme définis dans la revendication 15, et $R^{9-15}$ ont l'une des significations données pour L dans la revendication 1, et de préférence $R^{11}$, $R^{12}$, $R^{13}$ et $R^{14}$ représentent H.

**19.** Formulation comprenant un ou plusieurs composés selon une ou plusieurs des revendications 1 à 18 et un ou plusieurs solvants.

**20.** Formulation comprenant un ou plusieurs composés selon une ou plusieurs des revendications 1 à 18, un ou plusieurs liants organiques ou ses précurseurs, ayant une permittivité ε à 1000 Hz de 3,3 ou moins, et optionnellement un ou plusieurs solvants.

**21.** Utilisation de composés et formulations selon une ou plusieurs des revendications 1 à 20 en tant que matériau de transport de charges, de semiconduction, de conduction électrique, de photoconduction ou d'émission de lumière dans des composants ou dispositifs optiques, électro-optiques, électroniques, électroluminescents ou photoluminescents.

**22.** Matériau ou composant de transport de charges, de semiconduction, de conduction électrique, de photoconduction ou d'émission de lumière comprenant un ou plusieurs composés ou formulations selon une ou plusieurs des revendications 1 à 20.

**23.** Composant ou dispositif optique, électro-optique, électronique, électroluminescent ou photoluminescent comprenant un ou plusieurs composés selon une ou plusieurs des revendications 1 à 20 ou 22.

**24.** Composant ou dispositif selon la revendication 23, **caractérisé en ce qu'**il est choisi parmi le groupe constitué des transistors à effet de champ organiques (OFET), transistors à film mince (TFT), circuits intégrés (IC), circuits logiques, condensateurs, étiquettes, dispositifs ou composants d'identification radiofréquence (RFID), diodes émettrices de lumière organiques (OLED), transistors émetteurs de lumière organiques (OLET), affichages à écran plat, éclairages ou affichages arrière, dispositifs photovoltaïques organiques (OPV), cellules solaires, diodes laser, photoconducteurs, photodétecteurs, dispositifs électrophotographiques, dispositifs d'enregistrement électrophotographique, dispositifs de mémoire organique, dispositifs de capteur, couches d'injection de charges, couches ou intercouches de transport de charges dans des diodes émettrices de lumière en poymère, (PLED), diodes émettrices de plasmons organiques (OPED), diodes Schottky, couches de planarisation, films antistatiques, membranes d'électrolyte poymère (PEM), substrats conducteurs, motifs conducteurs, matériaux d'électrode dans des batteries, couches d'alignement, biocapteurs, biopuces, marquage de sécurité, dispositifs de sécurité, et des composants ou dispositifs pour la détection et la discrimination de séquences d'ADN.

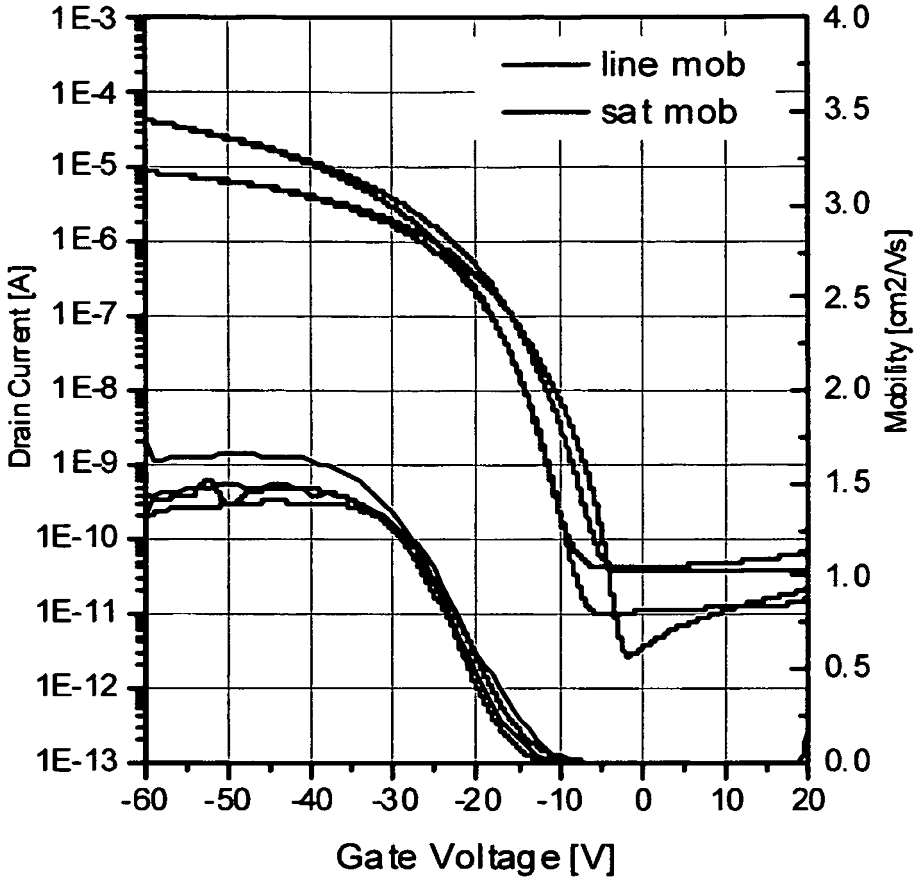
line mob
sat mob
1E-3
1E-4
1E-5
1E-6
1E-7
1E-8
1E-9
1E-10
1E-11
1E-12
1E-13
Drain Current [A]
4.0
3.5
3.0
2.5
2.0
1.5
1.0
0.5
0.0
Mobility [cm2/Vs]
-60
-50
-40
-30
-20
-10
0
10
20
Gate Voltage [V]

**Figure 1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010099583 A1
- US 20070102696 A1
- US 6630566 B
- US 20040248338 A1
- US 5892244 A
- US 5998804 A
- US 6723394 B
- US 7095044 B
- EP 0889350 A1
- EP 0528662 A
- US 5198153 A
- WO 9621659 A
- US 20030021913 A


### Non-patent literature cited in the description


- **J. E. ANTHONY.** *Angew. Chem. Int. Ed.,* 2008, vol. 47, 452
- **S. F. NELSON ; Y. Y. LIN ; D. J. GUNDLACH ; T. N. JACKSON.** *Appl. Phys. Lett.,* 1998, vol. 72, 1854
- **MALIAKAL, K. RAGHAVACHARI ; H. KATZ ; E. CHANDROSS ; T. SIEGRIST.** *Chem. Mater.,* 2004, vol. 16, 4980
- **J. E. ANTHONY.** *Angew. Chem. Int Ed.,* 2008, vol. 47, 452
- **WINZENBERG et al.** *Chem. Mater.,* 2009, vol. 21, 5701-5703
- **PAYNE et al.** *J. Am. Chem. Soc.,* 2005, vol. 127, 4986-4987
- **GREEN.** Protective Groups in Organic Synthesis. John Wiley and Sons, 1981
- **D. J. BROER ; G. CHALLA ; G. N. MOL.** *Macromol. Chem,* 1991, vol. 192, 59
- *Pure Appl. Chem.,* 2001, vol. 73 (5), 888
- **M. WATANABE ; V. SNIECKUS.** *J. Am. Chem. Soc.,* 1980, vol. 102 (4), 1457
- **X. WANG ; V. SNIECKUS.** *Synlett,* 1990, 313
- **C.M. HANSEN.** *Ind. Eng. and Chem., Prod. Res. and Devl.,* 1970, vol. 9 (3), 282
- Handbook of Solubility Parameters and Other Cohesion Parameters. CRC Press, 1991
- **CROWLEY, J.D. ; TEAGUE, G.S. JR. ; LOWE, J.W. JR.** *Journal of Paint Technology,* 1996, vol. 38 (496), 296
- **SOLVENTS, W.H. ELLIS.** *Federation of Societies for Coatings Technology,* 1986, 9-10
- **G. YU ; J. GAO ; J.C. HUMMELEN ; F. WUDL ; A.J. HEEGER.** *Science,* 1995, vol. 270, 1789 ff
- **COAKLEY, K. M. ; MCGEHEE, M. D.** *Chem. Mater.,* 2004, vol. 16, 4533
- **WALDAUF et al.** *Appl. Phys. Lett.,* 2006, vol. 89, 233517
- **MEERHOLZ.** *Synthetic Materials,* 2000, vol. 111-112, 31-34
- **ALCALA.** *J. Appl. Phys.,* 2000, vol. 88, 7124-7128
- **C. WEDER et al.** *Science,* 1998, vol. 279, 835-837
- **KOLLER et al.** *Nature Photonics,* 28 September 2008
- **L. CHEN ; D. W. MCBRANCH ; H. WANG ; R. HELGESON ; F. WUDL ; D. G. WHITTEN.** *Proc. Natl. Acad. Sci. U.S.A.,* 1999, vol. 96, 12287
- **D. WANG ; X. GONG ; P. S. HEEGER ; F. RININSLAND ; G. C. BAZAN ; A. J. HEEGER.** *Proc. Natl. Acad. Sci. U.S.A.,* 2002, vol. 99, 49
- **N. DICESARE ; M. R. PINOT ; K. S. SCHANZE ; J. R. LAKOWICZ.** *Langmuir,* 2002, vol. 18, 7785
- **D. T. MCQUADE ; A. E. PULLEN ; T. M. SWAGER.** *Chem. Rev.,* 2000, vol. 100, 2537